# EUROPÄISCHE PATENTSCHRIFT

(11) **EP 3 424 936 B1**
(45) Veröffentlichungstag und Bekanntmachung des Hinweises auf die Patenterteilung: **07.04.2021**
(21) Anmeldenummer: 18189133.4
(22) Anmeldetag: 02.07.2013
(51) Int. Cl.: C07F 15/00, C09K 11/00, H01L 51/00, H05B 33/10

(54) **METALLKOMPLEXE**
METAL COMPLEXES
COMPLEXE MÉTALLIQUE

(30) Priorität: 07.08.2012 EP 12005715
(43) Veröffentlichungstag der Anmeldung: 09.01.2019
(62) Teilanmeldung aus: 13734334.9
(73) Patentinhaber: Merck Patent GmbH, 64293 Darmstadt (DE)
(72) Erfinder: Stoessel, Philipp, 60389 Frankfurt am Main (DE); Joosten, Dominik, 64372 Ober-Ramstadt (DE); Breuning, Esther, 64372 Ober-Ramstadt (DE); Kaiser, Joachim, 64289 Darmstadt (DE)

(56) Entgegenhaltungen:
- EP-A1- 1 659 129
- WO-A1-2004/043974
- WO-A1-2005/113563

## Beschreibung

Die vorliegende Erfindung betrifft Metallkomplexe, welche sich für den Einsatz als Emitter in organischen Elektrolumineszenzvorrichtungen eignen.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Dabei werden als emittierende Materialien zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, immer noch Verbesserungsbedarf, insbesondere im Hinblick auf Effizienz, Betriebsspannung und Lebensdauer. Dies gilt insbesondere für OLEDs, welche im kürzerwelligen Bereich, also grün und insbesondere blau, emittieren.

Gemäß dem Stand der Technik werden in phosphoreszierenden OLEDs als Triplettemitter insbesondere Iridium- und Platinkomplexe eingesetzt. Eine Verbesserung dieser OLEDs konnte dadurch erzielt werden, dass Metallkomplexe mit polypodalem Liganden bzw. Kryptate eingesetzt wurden, wodurch die Komplexe eine höhere thermische Stabilität aufweisen, was zu einer höheren Lebensdauer der OLEDs führt (WO 2004/081017, WO 2005/113563, WO 2006/008069). Es sind jedoch weitere Verbesserungen, insbesonderen in Hinblick auf die Effizienz und die Lebensdauer der Komplexe, wünschenswert.

Als Iridiumkomplexe werden insbesondere bis- und tris-ortho-metallierte Komplexe mit aromatischen Liganden eingesetzt, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenylpyridyl)iridium(III) und Derivate davon (z. B. gemäß US 2002/0034656 oder WO 2010/027583). Aus der Literatur ist eine Vielzahl verwandter Liganden und Iridium- bzw. Platinkomplexe bekannt, wie beispielsweise Komplexe mit 1- oder 3-Phenylisochinolinliganden (z. B. gemäß EP 1348711 oder WO 2011/028473), mit 2-Phenylchinolinen (z. B. gemäß WO 2002/064700 oder WO 2006/095943), mit Phenyl-chinoxalinen (z. B. gemäß US 2005/0191527), mit Phenyl-imidazolen (z. B. gemäß JP 2003/109758), mit Phenyl-benzimidazolen (z. B. gemäß US 2005/0008895) oder mit Phenyl-carbenen (z. B. gemäß WO 2005/019373). Platinkomplexe sind beispielsweise aus der WO 2003/040257 bekannt. Auch wenn mit derartigen Metallkomplexen bereits gute Ergebnisse erzielt werden, sind hier noch weitere Verbesserungen wünschenswert.

Aus WO 2004/043974 ist ein Iridiumkomplex mit Phenylpyridinliganden bekannt, welcher mit einer ankondensierten Gruppe -O-CH₂-O- substituiert ist.

Aufgabe der vorliegenden Erfindung ist daher die Bereitstellung neuer Metallkomplexe, welche sich als Emitter für die Verwendung in OLEDs eignen. Insbesondere ist die Aufgabe, Emitter bereitzustellen, welche verbesserte Eigenschaften in Bezug auf Effizienz, Betriebsspannung, Lebensdauer, Farbkoordinaten und/oder Farbreinheit, d. h. Breite der Emissionsbande, zeigen.

Überraschend wurde gefunden, dass bestimmte, unten näher beschriebene Metallchelatkomplexe diese Aufgabe lösen und sich sehr gut für die Verwendung in einer organischen Elektrolumineszenzvorrichtung eignen. Diese Metallkomplexe und organische Elektrolumineszenzvorrichtungen, welche diese Komplexe enthalten, sind daher der Gegenstand der vorliegenden Erfindung.

Gegenstand der Erfindung ist somit eine Verbindung gemäß Formel (1),

M(L)ₙ(L')ₘ Formel (1)

welche eine Teilstruktur M(L)ₙ der Formel (2) enthält: 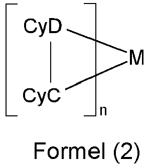 wobei für die verwendeten Symbole und Indizes gilt:
- M: ist Iridium oder Platin;
- CyC: ist eine Aryl- oder Heteroarylgruppe mit 5 bis 18 aromatischen Ringatomen oder eine Fluorengruppe, welche jeweils über ein Kohlenstoffatom an M koordiniert und welche jeweils mit einem oder mehreren Resten R substituiert sein kann und welche jeweils über eine kovalente Bindung mit CyD verbunden ist;
- CyD: ist eine Heteroarylgruppe mit 5 bis 18 aromatischen Ringatomen, welche über ein neutrales Stickstoffatom oder über ein Carben-Kohlenstoffatom an M koordiniert und welche mit einem oder mehreren Resten R substituiert sein kann und welche über eine kovalente Bindung mit CyC verbunden ist;
- R: ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann, oder eine Aralkyl- oder Heteroaralkylgruppe mit 5 bis 40 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei benachbarte Reste R auch miteinander ein mono- oder polycyclisches, aliphatisches, aromatisches oder heteroaromatisches Ringsystem bilden;
- R¹: ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere benachbarte Reste R¹ miteinander oder R¹ mit R ein mono- oder polycyclisches, aliphatisches, aromatisches oder heteroaromatisches Ringsystem bilden;
- R²: ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R² auch miteinander ein mono- oder polycyclisches, aliphatisches Ringsystem bilden;
- L': ist gleich oder verschieden bei jedem Auftreten ein bidentater Coligand;
- n: ist 1, 2 oder 3;
- m: ist 0, 1 oder 2;
dabei können CyC und CyD auch über eine Gruppe ausgewählt aus C(R¹)₂, C(R¹)₂-C(R¹)₂-, NR¹, O oder S miteinander verknüpft sein;
dabei können auch mehrere Liganden L miteinander oder L mit L' über eine Einfachbindung oder eine bivalente oder trivalente Brücke verknüpft sein und so ein tridentates, tetradentates, pentadentates oder hexadentates Ligandensystem aufspannen;
dabei kann auch ein Substituent R zusätzlich an das Metall koordinieren;
dadurch gekennzeichnet, dass CyD und/oder CyC zwei benachbarte Kohlenstoffatome aufweist, die jeweils mit Resten R substituiert sind, wobei die jeweiligen Reste R zusammen mit den C-Atomen einen Ring der folgenden Formel (4) aufspannen, 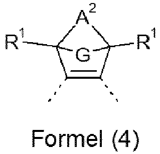 wobei R¹ und R² die oben genannten Bedeutungen aufweisen, die gestrichelten Bindungen die Verknüpfung der beiden Kohlenstoffatome im Liganden andeuten und weiterhin gilt:
- A²: ist C(R¹)₂ oder O;
- G: ist eine Alkylengruppe mit 1, 2 oder 3 C-Atomen, welche mit einem oder mehreren Resten R² substituiert sein kann, oder eine orthoverknüpfte Arylen- oder Heteroarylengruppe mit 5 bis 14 aromatischen Ringatomen, welche durch einen oder mehrere Reste R² substituiert sein kann.

Dabei ist die Anwesenheit einer Teilstruktur der Formel (4), also eines ankondensierten aliphatischen Fünfrings erfindungswesentlich. In der oben abgebildeten Struktur der Formel (4) sowie den weiteren als bevorzugt genannten Ausführungsformen dieser Struktur wird formal eine Doppelbindung zwischen den zwei Kohlenstoffatomen abgebildet. Dies stellt eine Vereinfachung der chemischen Struktur dar, da diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist dem Fachmann offensichtlich, dass hiermit eine aromatische Bindung gemeint ist.

Dabei bedeutet "benachbarte Kohlenstoffatome", dass die Kohlenstoffatome direkt aneinander gebunden sind. Weiterhin bedeutet "benachbarte Reste" in der Definition der Reste, dass diese Reste an dasselbe Kohlenstoffatom oder an benachbarte Kohlenstoffatome gebunden sind.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl oder Terphenyl, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 60 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt sind Verbindungen gemäß Formel (1), dadurch gekennzeichnet, dass diese nicht geladen, d. h. elektrisch neutral, sind. Dies wird auf einfache Weise dadurch erreicht, dass die Ladung der Liganden L und L' so gewählt werden, dass sie die Ladung des komplexierten Metallatoms M kompensieren.

Dabei werden in den Komplexen der Formel (1) die Indizes n und m so gewählt, dass die Koordinationszahl am Metall M insgesamt, je nach Metall, der für dieses Metall üblichen Koordinationszahl entspricht. Dies ist für Iridium(III) die Koordinationszahl 6 und für Platin(II) die Koordinationszahl 4.

In einer bevorzugten Ausführungsform der Erfindung ist M Iridium(III), und der Index n steht für 1, 2 oder 3, bevorzugt für 2 oder 3. Wenn der Index n = 1 ist, sind noch zwei bidentate Liganden L' an das Metall koordiniert. Wenn der Index n = 2 ist, sind noch ein bidentater Ligand L' an das Metall koordiniert. Wenn der Index n = 3 ist, ist der Index m = 0.

In einer weiteren bevorzugten Ausführungsform der Erfindung ist M Platin(II), und der Index n steht für 1 oder 2. Wenn der Index n = 1 ist, ist noch ein bidentater Ligand L' an das Metall M koordiniert. Wenn der Index n = 2 ist, ist der Index m = 0.

In einer bevorzugten Ausführungsform der vorliegenden Erfindung ist CyC eine Aryl- oder Heteroarylgruppe mit 6 bis 14 aromatischen Ringatomen, besonders bevorzugt mit 6 bis 10 aromatischen Ringatomen, ganz besonders bevorzugt mit 6 aromatischen Ringatomen, welche über ein Kohlenstoffatom an M koordiniert und welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-19), wobei die Gruppe CyC jeweils an der durch # gekennzeichneten Position an CyD bindet und an der durch * gekennzeichneten Position an das Metall koordiniert, 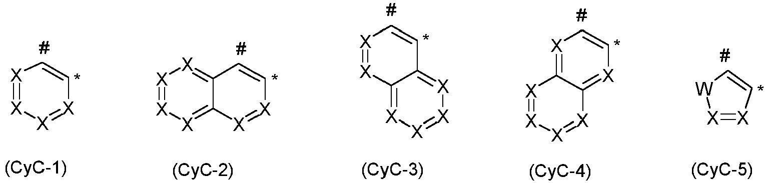 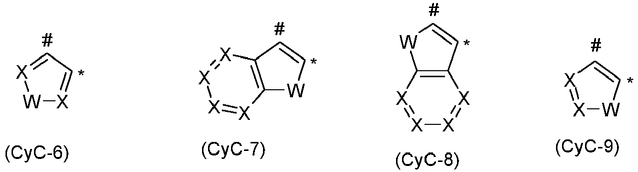 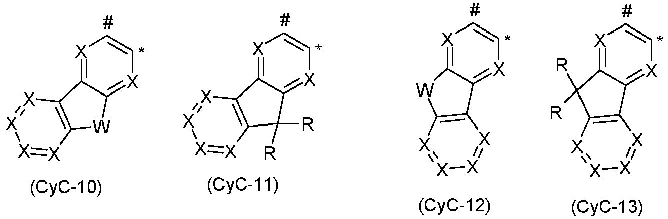 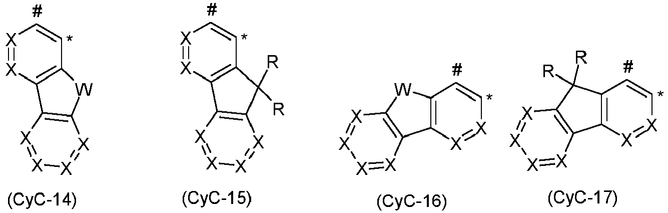 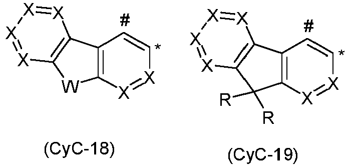 wobei R die oben genannten Bedeutungen aufweist und für die weiteren verwendeten Symbole gilt:
- X: ist bei jedem Auftreten gleich oder verschieden CR oder N;
- W: ist bei jedem Auftreten gleich oder verschieden NR, O, S oder CR₂.

Falls die Gruppe der Formel (4) an CyC gebunden ist, stehen zwei benachbarte Gruppen X in CyC für CR und bilden zusammen mit den Resten R, die an diese Kohlenstoffatome gebunden sind, eine Gruppe der oben genannten bzw. unten genauer ausgeführten Formel (4).

Bevorzugt stehen maximal drei Symbole X in CyC für N, besonders bevorzugt stehen maximal zwei Symbole X in CyC für N, ganz besonders bevorzugt steht maximal ein Symbol X in CyC für N. Insbesondere bevorzugt stehen alle Symbole X für CR.

Besonders bevorzugte Gruppen CyC sind die Gruppen der folgenden Formeln (CyC-1a) bis (CyC-19a), 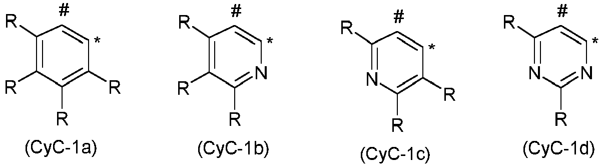 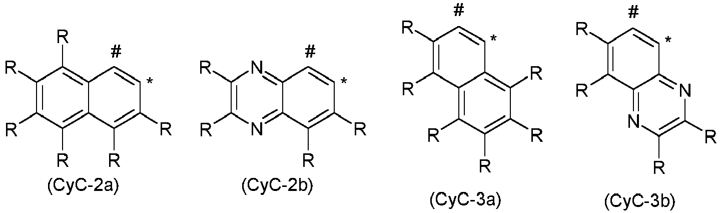 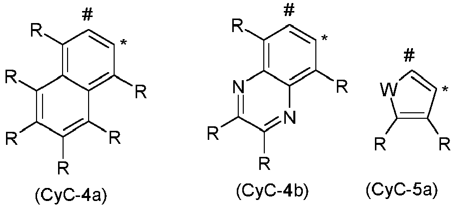 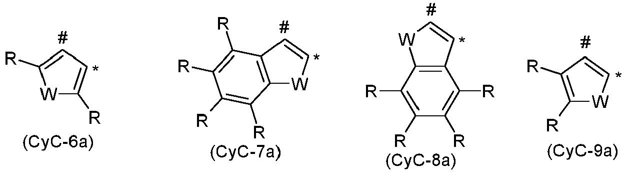 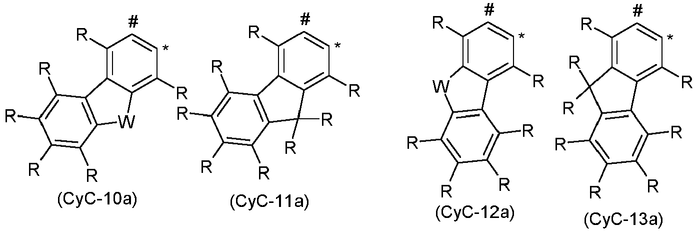 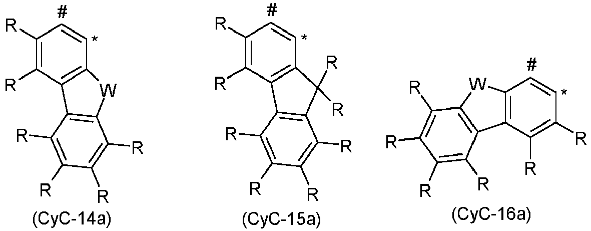 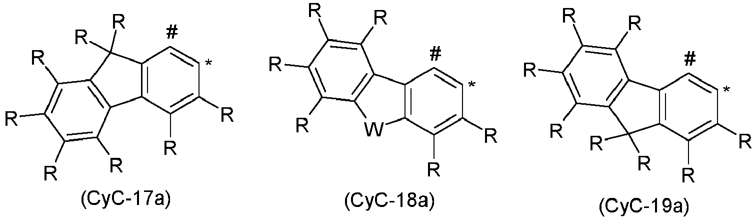 wobei die verwendeten Symbole die oben genannten Bedeutungen aufweisen.

Bevorzugte Gruppen unter den Gruppen (CyC-1) bis (CyC-19) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe mit 5 bis 13 aromatischen Ringatomen, besonders bevorzugt mit 5 bis 10 aromatischen Ringatomen, welche über ein neutrales Stickstoffatom oder über ein Carben-Kohlenstoffatom an M koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-10), wobei die Gruppe CyD jeweils an der durch # gekennzeichneten Position an CyC bindet und an der durch * gekennzeichneten Position an das Metall koordiniert, 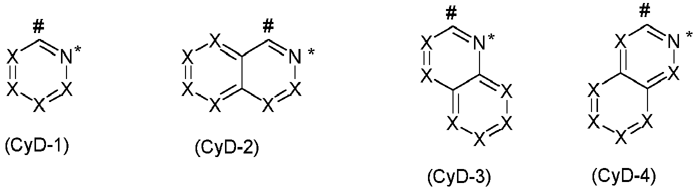 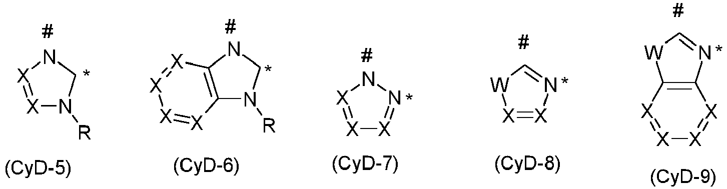 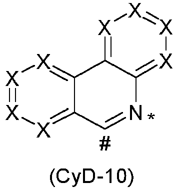 wobei X, W und R die oben genannten Bedeutungen aufweist.

Falls die Gruppe der Formel (4) an CyD gebunden ist, stehen zwei benachbarte Gruppen X in CyD für CR und bilden zusammen mit den Resten R, die an diese Kohlenstoffatome gebunden sind, eine Gruppe der oben genannten bzw. unten genauer ausgeführten Formel (4).

Bevorzugt stehen maximal drei Symbole X in CyD für N, besonders bevorzugt stehen maximal zwei Symbole X in CyD für N, ganz besonders bevorzugt steht maximal ein Symbol X in CyD für N. Insbesondere bevorzugt stehen alle Symbole X für CR.

Besonders bevorzugte Gruppen CyD sind die Gruppen der folgenden Formeln (CyD-1a) bis (CyD-10a), 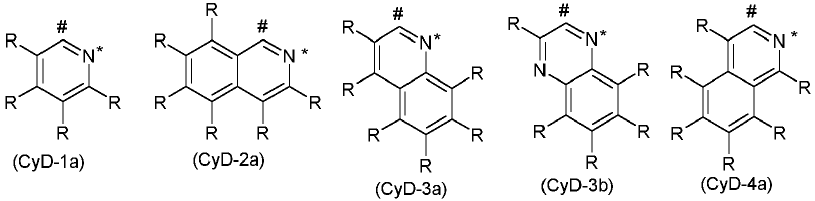 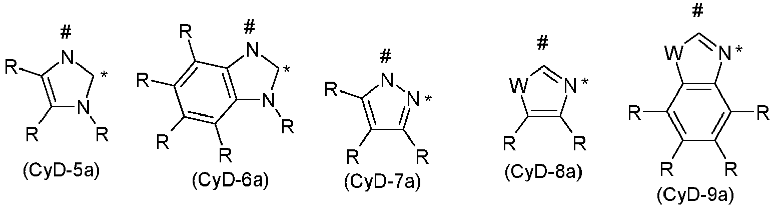 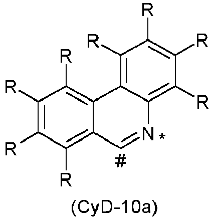 wobei die verwendeten Symbole die oben genannten Bedeutungen aufweisen.

Bevorzugte Gruppen unter den Gruppen (CyD-1) bis (CyD-10) sind die Gruppen (CyD-1), (CyD-3), (CyD-4), (CyD-5) und (CyD-6), und besonders bevorzugt sind die Gruppen (CyD-1a), (CyD-3a), (CyD-4a), (CyD-5a) und (CyD-6a).

Die oben genannten bevorzugten Gruppen CyC und CyD können beliebig miteinander kombiniert werden. Geeignet sind somit im Liganden L die folgenden Kombinationen aus CyC und CyD:

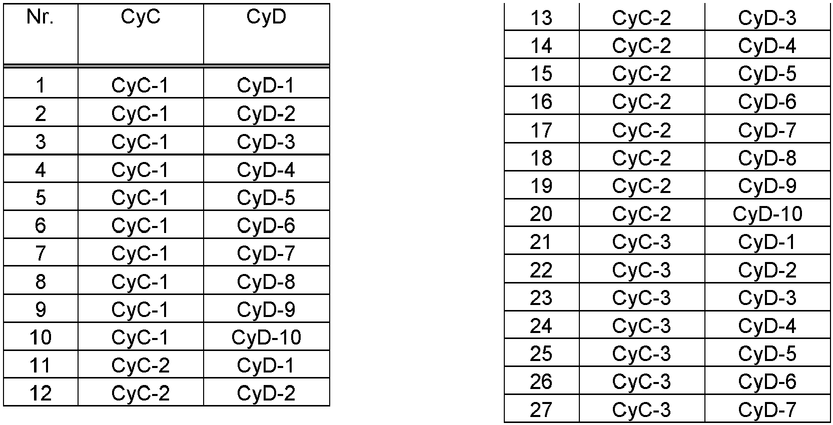

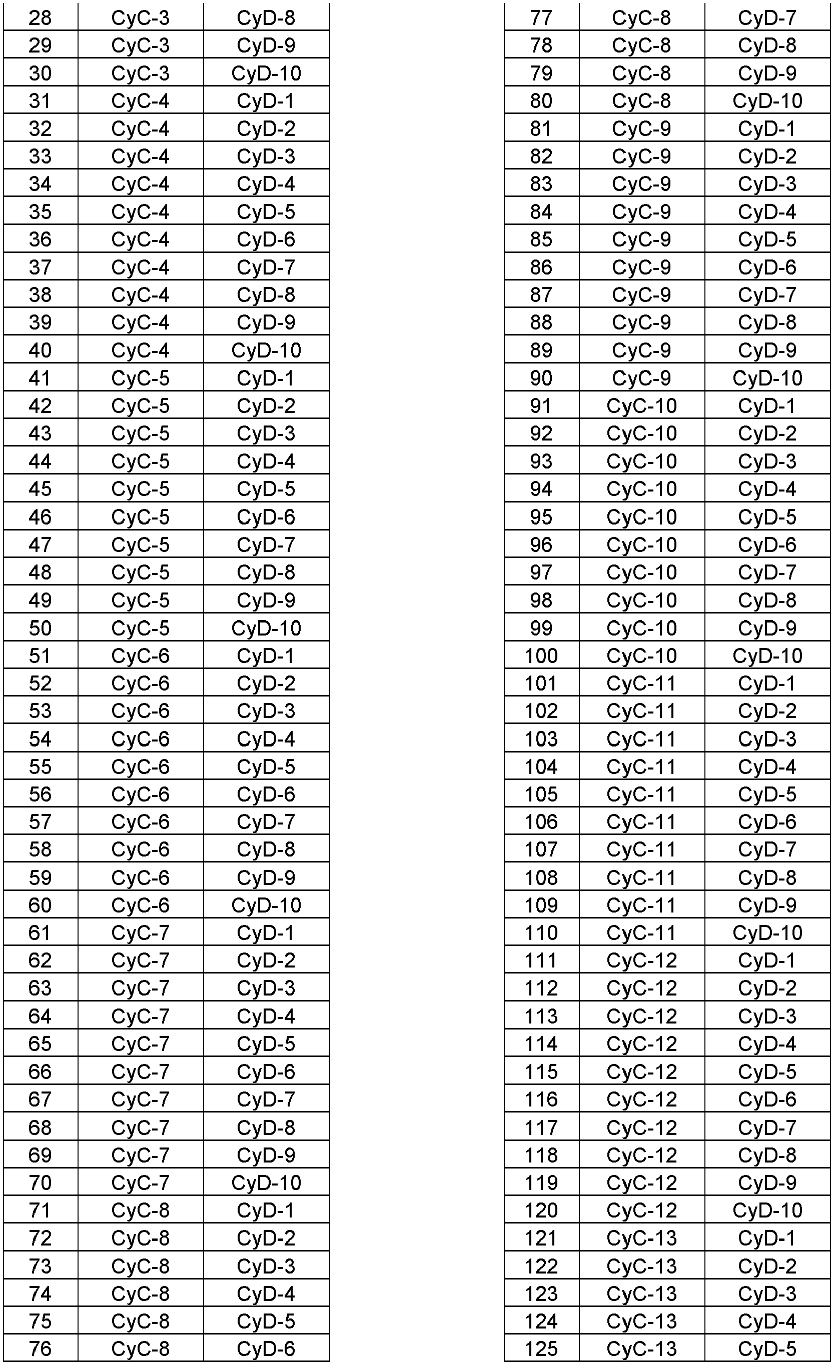

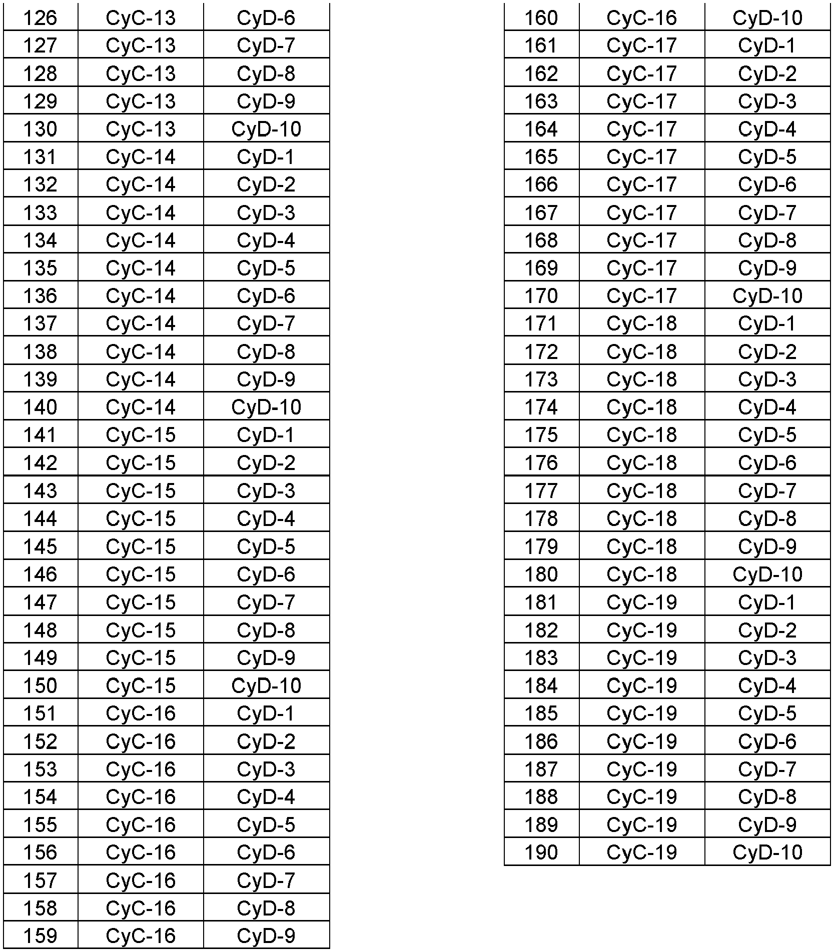

Insbesondere bevorzugt ist es, wenn die oben als besonders bevorzugt genannten Gruppen CyC und CyD miteinander kombiniert werden. Bevorzugt sind somit im Liganden L die folgenden Kombinationen aus CyC und CyD:

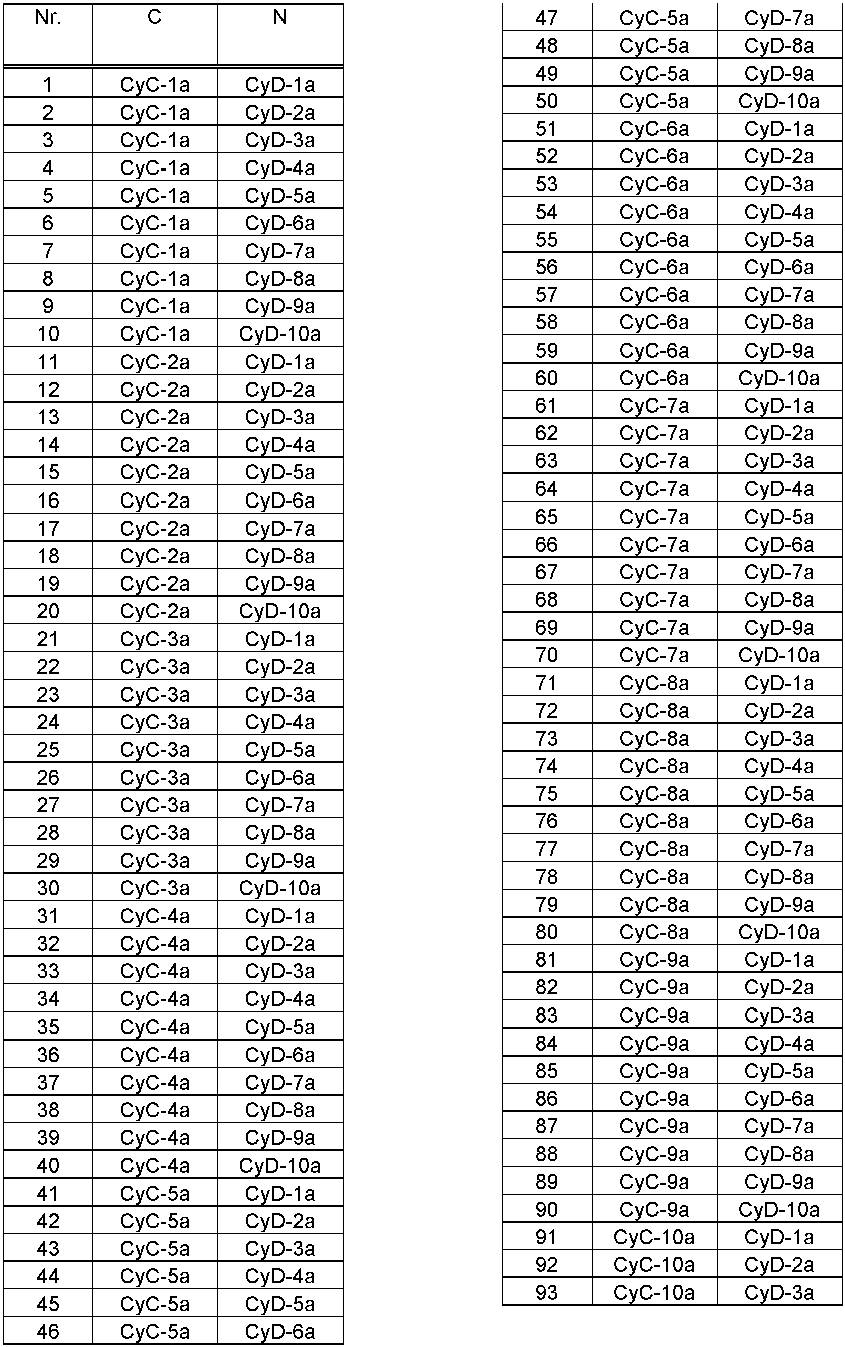

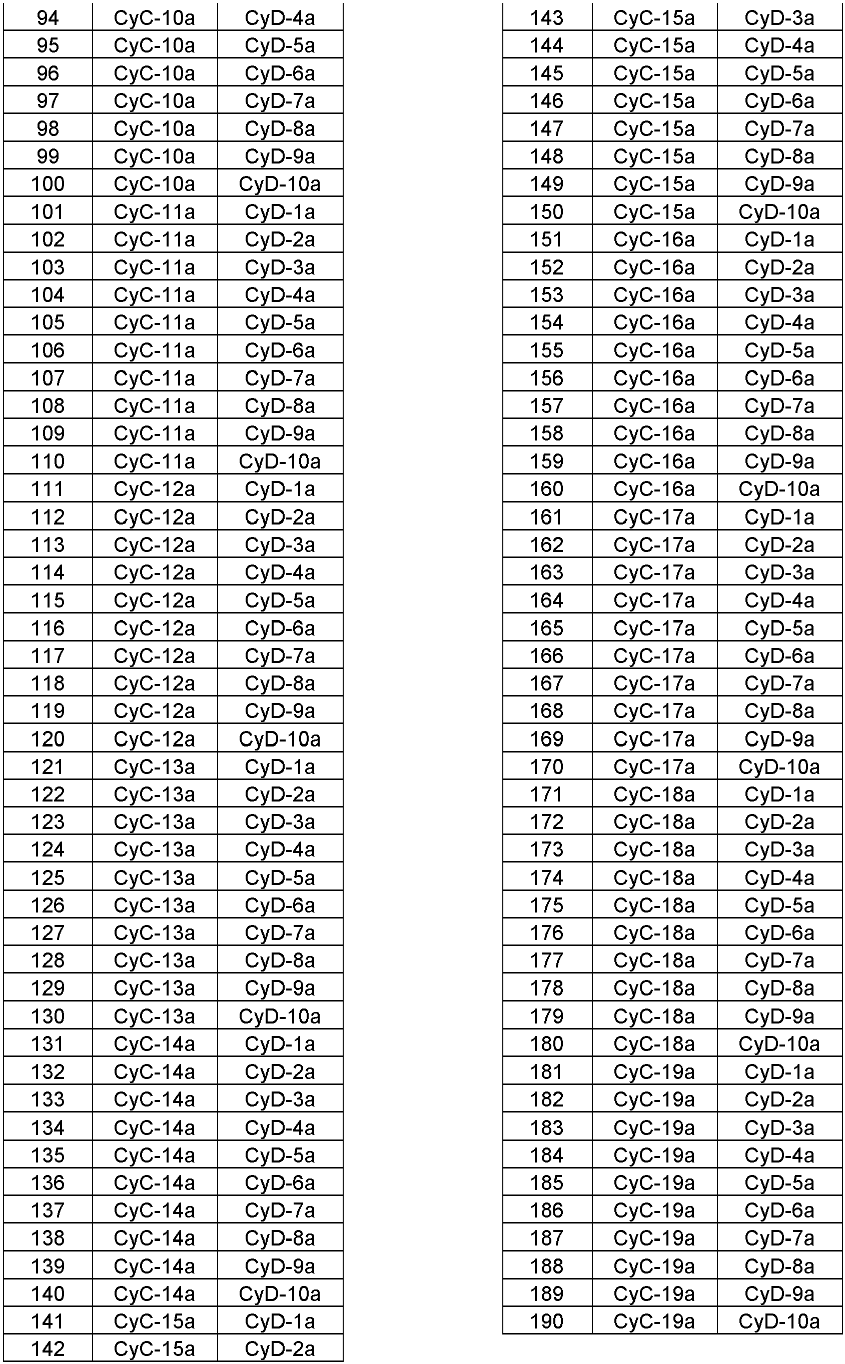

Wie oben beschrieben, ist es erfindungswesentlich, dass CyD und/oder CyC bzw. die oben aufgeführten bevorzugten Ausführungsformen zwei benachbarte Kohlenstoffatome aufweist, die jeweils mit Resten R substituiert sind, wobei die jeweiligen Reste R zusammen mit den C-Atomen einen Ring der oben genannten Formel (4) aufspannen.

In einer bevorzugten Ausführungsform der Erfindung enthält der Ligand L genau eine Gruppe der Formel (4). Besonders bevorzugt weist CyD zwei benachbarte Kohlenstoffatome auf, die jeweils mit Resten R substituiert sind, wobei die jeweiligen Reste R zusammen mit den C-Atomen einen Ring der oben genannten Formel (4) aufspannen. Generell kann die Gruppe der Formel (4) in jeder möglichen Position an CyC oder CyD gebunden sein.

In den folgenden Gruppen (CyC-1-1) bis (CyC-19-1) und (CyD-1-1) bis (CyD-10-1) sind jeweils die bevorzugten Positionen für benachbarte Gruppen X, welche für CR stehen, wobei die jeweiligen Reste R zusammen mit den C-Atomen, an die sie gebunden sind, einen Ring der oben genannten Formel (4) aufspannen, abgebildet, 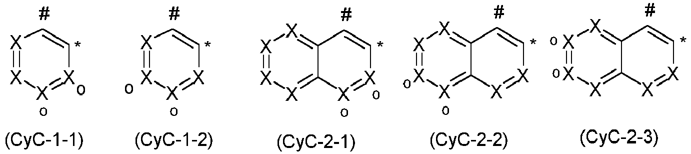 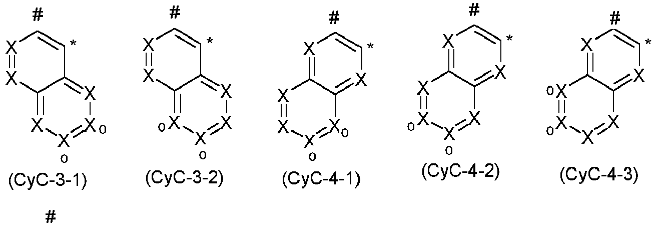 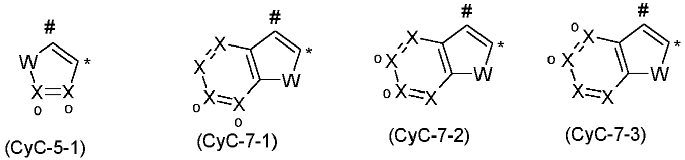 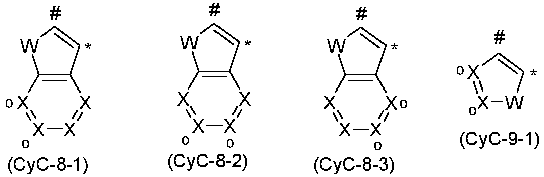 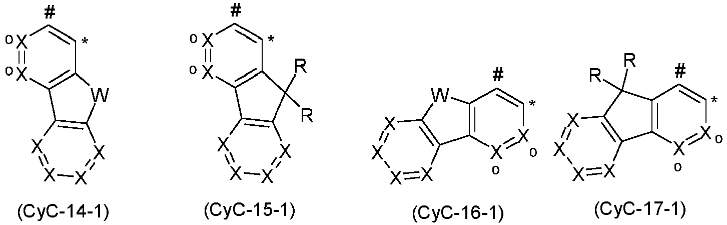 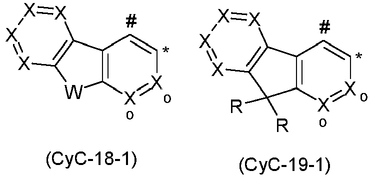 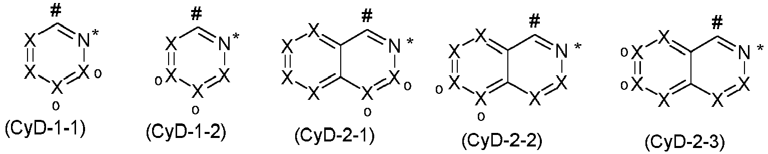 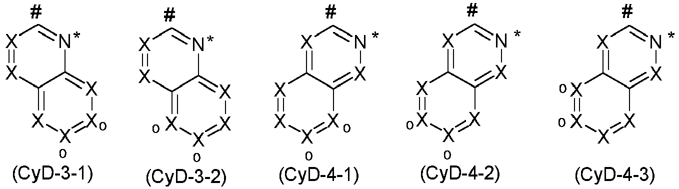 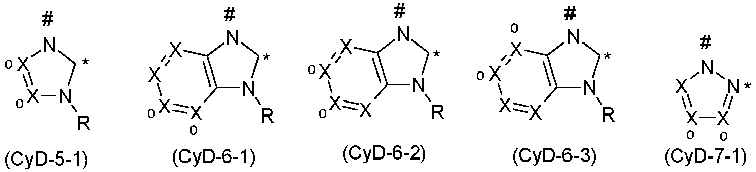 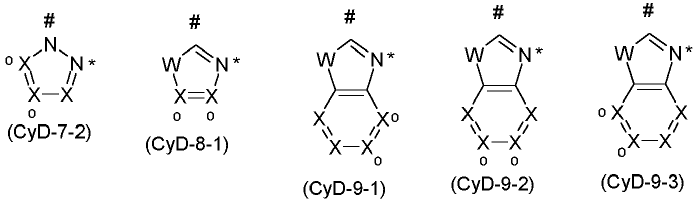 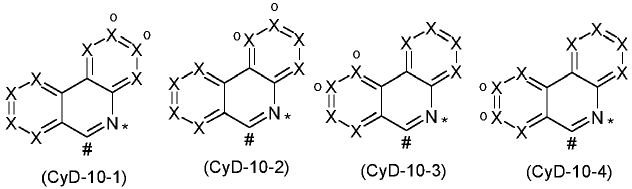 wobei die verwendeten Symbole und Indizes die oben genannten Bedeutungen aufweisen und ° jeweils die Positionen kennzeichnet, die für CR stehen, wobei die jeweiligen Reste R zusammen mit den C-Atomen, an die sie gebunden sind, einen Ring der oben genannten Formel (4) aufspannen.

Ebenso sind in den beiden oben aufgeführten Tabellen die Gruppen (CyC-1-1) bis (CyC-19-1) bzw. (CyD-1-1) bis (CyD-10-4) statt den in den Tabellen aufgeführten Gruppen (CyC-1) bis (CyC-19) oder (CyD-1) bis (CyD-19) bevorzugt.

Im Folgenden werden bevorzugte Ausführungsformen der Gruppen gemäß der Formel (4) ausgeführt.

Wesentlich bei den Gruppen der Formel (4) ist, dass diese keine aziden benzylischen Protonen aufweisen. Unter benzylischen Protonen werden Protonen verstanden, die an ein Kohlenstoffatom binden, welches direkt an den heteroaromatischen Liganden gebunden sind. Die Abwesenheit von aziden benzylischen Protonen ist in Formel (4) automatisch dadurch erreicht, dass es sich dabei um eine bicyclische Struktur handelt. Aufgrund der starren räumlichen Anordnung ist R¹, wenn es für H steht, deutlich weniger azide als benzylische Protonen, da das korrespondierende Anion der bicyclischen Struktur nicht mesomeriestabilisiert ist. Auch wenn R¹ in Formel (4) für H steht, handelt es sich dabei um ein nicht-azides Proton im Sinne der vorliegenden Anmeldung.

In einer bevorzugten Ausführungsform der Struktur gemäß Formel (4) stehen die Reste R¹, die an den Brückenkopf gebunden sind, für H, D, F oder CH₃. Weiterhin bevorzugt steht A² für C(R³)₂. Bevorzugte Ausführungsformen der Formel (4) sind somit eine Strukturen der Formel (4-A), und eine besonders bevorzugte Ausführungsform der Formel (4-A) ist eine Struktur der Formel (4-C), 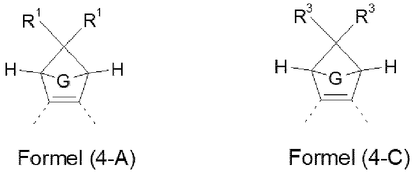 wobei die verwendeten Symbole die oben genannten Bedeutungen aufweisen und weiterhin gilt:
- R³: ist gleich oder verschieden bei jedem Auftreten F, eine geradkettige Alkyl- oder Alkoxygruppe mit 1 bis 20 C-Atomen, eine verzweigte oder cyclische Alkyl- oder Alkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann, oder eine Aralkyl- oder Heteroaralkylgruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Weiterhin bevorzugt steht die Gruppe G in den Formeln (4), (4-A) und (4-C) für eine Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, also eine Gruppe -C(R²)₂-C(R²)₂-, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in der Gruppe der Formel (4-C) gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in der Gruppe der Formel (4-C) gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (4) sind die im Folgenden aufgeführten Gruppen (4-1) bis (4-22):

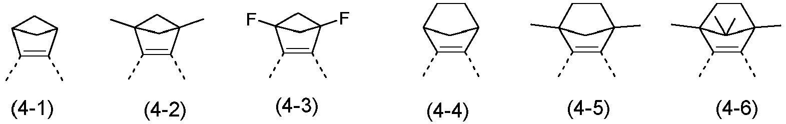

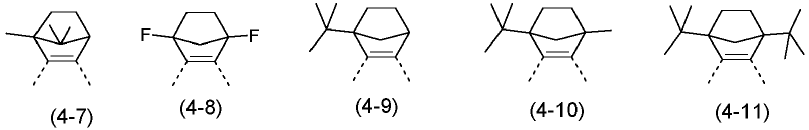

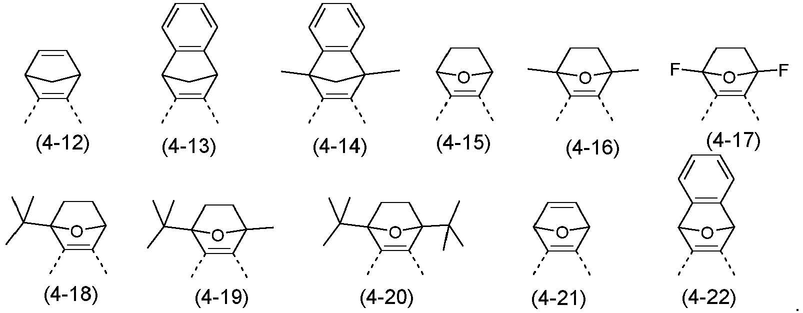

Wenn in der Teilstruktur der Formel (2) Reste R gebunden sind, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R¹ substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Weiterhin ist es möglich, dass der Substituent R, der in der ortho-Position zur Metallkoordination gebunden ist, eine Gruppe darstellt, die ebenfalls an das Metall M koordiniert bzw. bindet. Bevorzugte koordinierende Gruppen R sind Aryl- bzw. Heteroarylgruppen, beispielsweise Phenyl oder Pyridyl, Aryl- oder Alkylcyanide, Aryl- oder Alkylisocyanide, Amine oder Amide, Alkohole oder Alkoholate, Thioalkohole oder Thioalkoholate, Phosphine, Phosphite, Carbonylfunktionen, Carboxylate, Carbamide oder Aryl- oder Alkylacetylide. Beispiele für Teilstrukturen ML der Formel (2), in denen CyD für Pyridin und CyC für Benzol steht, sind die Strukturen der folgenden Formeln (5) bis (16): 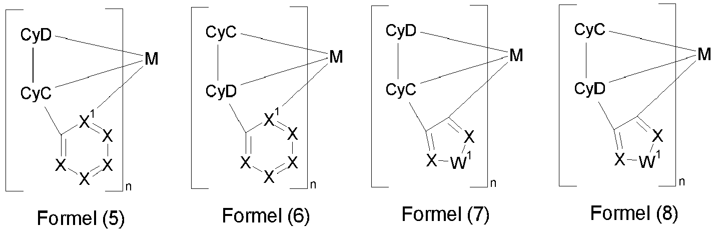 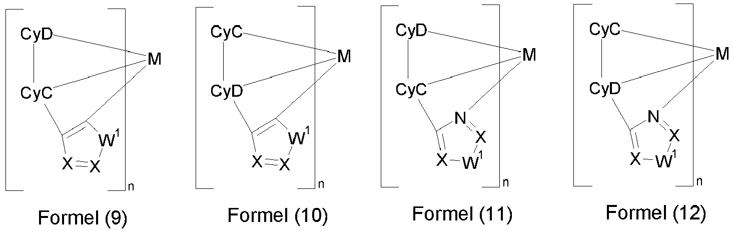 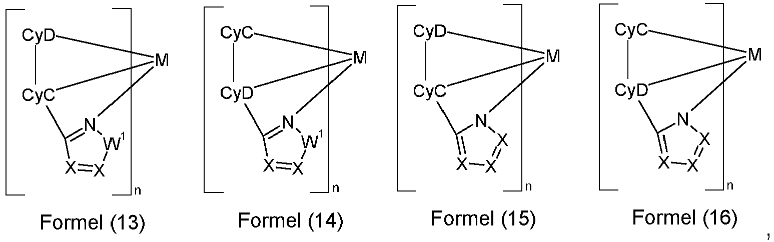 wobei die verwendeten Symbole und Indizes die gleichen Bedeutungen aufweisen, wie oben beschrieben, X¹ gleich oder verschieden bei jedem Auftreten für C oder N steht und W¹ gleich oder verschieden bei jedem Auftreten für S, O oder NR¹ steht.

Die Formeln (5) bis (16) zeigen nur exemplarisch, wie der Substituent R zusätzlich an das Metall koordinieren kann. Ganz analog sind ohne weiteres erfinderisches Zutun auch andere an das Metall koordinierende Gruppen R zugänglich, beispielsweise auch Carbene.

Wie oben beschrieben, kann auch statt einem der Reste R eine verbrückende Einheit vorhanden sein, die diesen Liganden L mit einem oder mehreren weiteren Liganden L bzw. L' verknüpft. In einer bevorzugten Ausführungsform der Erfindung ist statt einem der Reste R, insbesondere statt der Reste R, die in ortho- oder meta-Position zum koordinierenden Atom stehen, eine verbrückende Einheit vorhanden, so dass die Liganden dreizähnigen oder mehrzähnigen oder polypodalen Charakter aufweisen. Es können auch zwei solcher verbrückenden Einheiten vorhanden sein. Dies führt zur Bildung makrocyclischer Liganden bzw. zur Bildung von Kryptaten.

Bevorzugte Strukturen mit mehrzähnigen Liganden bzw. mit polydentaten Liganden sind die Metallkomplexe der folgenden Formeln (17) bis (22), 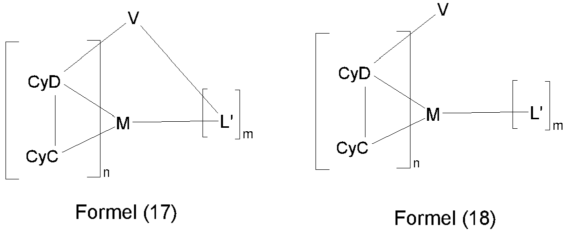 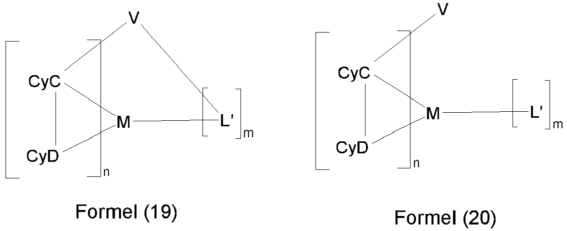 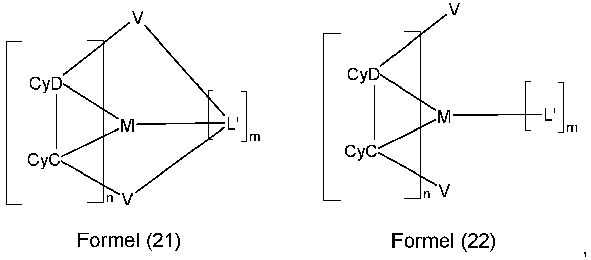 wobei die verwendeten Symbole und Indizes die oben genannten Bedeutungen aufweisen.

Ebenso können die Liganden über die cyclische Gruppe der Formel (4) miteinander verbrückt sein.

Dabei stellt in den Strukturen der Formeln (17) bis (22) V bevorzugt eine Einfachbindung oder eine verbrückende Einheit dar, enthaltend 1 bis 80 Atome aus der dritten, vierten, fünften und/oder sechsten Hauptgruppe (Gruppe 13, 14, 15 oder 16 gemäß IUPAC) oder einen 3- bis 6-gliedrigen Homo- oder Heterocyclus, die die Teilliganden L miteinander oder L mit L' miteinander kovalent verbindet. Dabei kann die verbrückende Einheit V auch unsymmetrisch aufgebaut sein, d. h. die Verknüpfung von V zu L bzw. L' muss nicht identisch sein. Die verbrückende Einheit V kann neutral, einfach, zweifach oder dreifach negativ oder einfach, zweifach oder dreifach positiv geladen sein. Bevorzugt ist V neutral oder einfach negativ oder einfach positiv geladen, besonders bevorzugt neutral. Dabei wird die Ladung von V bevorzugt so gewählt, dass insgesamt ein neutraler Komplex entsteht. Dabei gelten für die Liganden die oben für die Teilstruktur MLₙ genannten Bevorzugungen und n ist bevorzugt mindestens 2.

Die genaue Struktur und chemische Zusammensetzung der Gruppe V hat keinen wesentlichen Einfluss auf die elektronischen Eigenschaften des Komplexes, da die Aufgabe dieser Gruppe im Wesentlichen darin liegt, durch die Verbrückung von L miteinander bzw. mit L' die chemische und thermische Stabilität der Komplexe zu erhöhen.

Wenn V eine trivalente Gruppe ist, also drei Liganden L miteinander bzw. zwei Liganden L mit L' oder einen Liganden L mit zwei Liganden L' verbrückt, ist V bevorzugt gleich oder verschieden bei jedem Auftreten gewählt aus der Gruppe bestehend aus B, B(R¹)⁻, B(C(R¹)₂)₃, (R¹)B(C(R¹)₂)₃⁻, B(O)₃, (R¹)B(O)₃⁻, B(C(R¹)₂C(R¹)₂)₃, (R¹)B(C(R¹)₂C(R¹)₂)₃⁻, B(C(R¹)₂O)₃, (R¹)B(C(R¹)₂O)₃⁻, B(OC(R¹)₂)₃, (R¹)B(OC(R¹)₂)₃⁻, C(R¹), CO⁻, CN(R¹)₂, (R¹)C(C(R¹)₂)₃, (R¹)C(O)₃, (R¹)C(C(R¹)₂C(R¹)₂)₃, (R¹)C(C(R¹)₂O)₃, (R¹)C(OC(R¹)₂)₃, (R¹)C(Si(R¹)₂)₃, (R¹)C(Si(R¹)₂C(R¹)₂)₃, (R¹)C(C(R¹)₂Si(R¹)₂)₃, (R¹)C(Si(R¹)₂Si(R¹)₂)₃, Si(R¹), (R¹)Si(C(R¹)₂)₃, (R¹)Si(O)₃, (R¹)Si(C(R¹)₂C(R¹)₂)₃, (R¹)Si(OC(R¹)₂)₃, (R¹)Si(C(R¹)₂O)₃, (R¹)Si(Si(R¹)₂)₃, (R¹)Si(Si(R¹)₂C(R¹)₂)₃, (R¹)Si(C(R¹)₂Si(R¹)₂)₃, (R¹)Si(Si(R¹)₂Si(R¹)₂)₃, N, NO, N(R¹)⁺, N(C(R¹)₂)₃, (R¹)N(C(R¹)₂)₃⁺, N(C=O)₃, N(C(R¹)₂C(R¹)₂)₃, (R¹)N(C(R¹)₂C(R¹)₂)⁺, P, P(R¹)⁺, PO, PS, P(O)₃, PO(O)₃, P(OC(R¹)₂)₃, PO(OC(R¹)₂)₃, P(C(R¹)₂)₃, P(R¹)(C(R¹)₂)₃⁺, PO(C(R¹)₂)₃, P(C(R¹)₂C(R¹)₂)₃, P(R¹) (C(R¹)₂C(R¹)₂)₃⁺, PO(C(R¹)₂C(R¹)₂)₃, S⁺, S(C(R¹)₂)₃⁺, S(C(R¹)₂C(R¹)₂)₃⁺, oder eine Einheit gemäß Formel (23) bis (27), 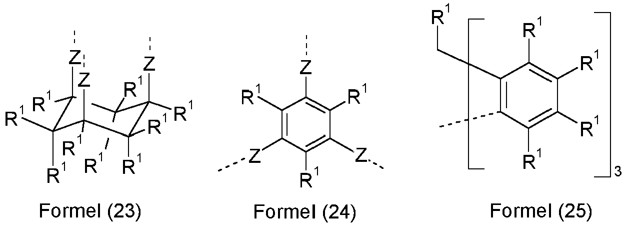 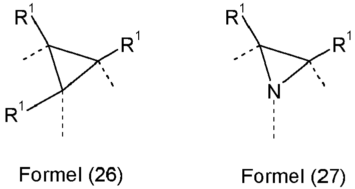 wobei die gestrichelten Bindungen jeweils die Bindung zu den Teilliganden L bzw. L' andeuten und Z gleich oder verschieden bei jedem Auftreten ausgewählt ist aus der Gruppe bestehend aus einer Einfachbindung, O, S, S(=O), S(=O)₂, NR¹, PR¹, P(=O)R¹, C(R¹)₂, C(=O), C(=NR¹), C(=C(R¹)₂), Si(R¹)₂ oder BR¹. Die weiteren verwendeten Symbole haben die oben genannten Bedeutungen.

Wenn V für eine Gruppe CR₂ steht, so können die beiden Reste R auch miteinander verknüpft sein, so dass auch Strukturen wie zum Beispiele 9,9-Fluoren geeignete Gruppen V sind.

Wenn V eine bivalente Gruppe ist, also zwei Liganden L miteinander bzw. einen Liganden L mit L' verbrückt, ist V bevorzugt gleich oder verschieden bei jedem Auftreten gewählt aus der Gruppe bestehend aus BR¹, B(R¹)₂⁻, C(R¹)₂, C(=O), Si(R¹)₂, NR¹, PR¹, P(R¹)₂⁺, P(=O)(R¹), P(=S)(R¹), O, S, Se, oder eine Einheit gemäß Formel (28) bis (37), 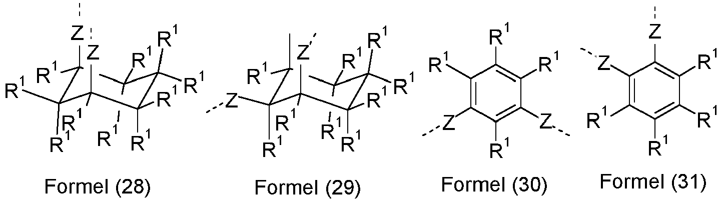 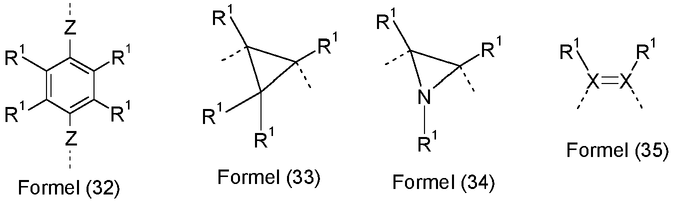 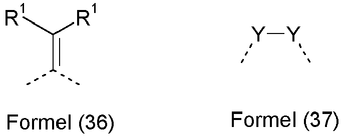 wobei die gestrichelten Bindungen jeweils die Bindung zu den Teilliganden L bzw. L' andeuten, Y bei jedem Auftreten gleich oder verschieden für C(R¹)₂, N(R¹), O oder S steht und die weiteren verwendeten Symbole jeweils die oben aufgeführten Bedeutungen haben.

Im Folgenden werden bevorzugte Liganden L' beschrieben, wie sie in Formel (1) vorkommen. Entsprechend können auch die Ligandengruppen L' gewählt sein, wenn diese über eine verbrückende Einheit V an L gebunden sind, wie in Formeln (17), (19) und (21) angedeutet.

Die Liganden L' sind bevorzugt neutrale, monoanionische, dianionische oder trianionische Liganden, besonders bevorzugt neutrale oder monoanionische Liganden. Sie sind bidentat, weisen also zwei Koordinationsstellen auf. Wie oben beschrieben, können die Liganden L' auch über eine verbrückende Gruppe V an L gebunden sein.

Bevorzugte neutrale oder mono- oder dianionische, bidentate Liganden L' sind ausgewählt aus Diaminen, wie z. B. Ethylendiamin, N,N,N',N'-Tetramethylethylendiamin, Propylendiamin, N,N,N',N-Tetramethylpropylendi-amin, cis- oder trans-Diaminocyclohexan, cis- oder trans-N,N,N',N'-Tetramethyldiaminocyclohexan, Iminen, wie z. B. 2-[1-(Phenylimino)ethyl]-pyridin, 2-[1-(2-Methylphenylimino)ethyl]pyridin, 2-[1-(2,6-Di-iso-propylphenylimino)ethyl]pyridin, 2-[1-(Methylimino)ethyl]pyridin, 2-[1-(ethylimino)-ethyl]pyridin, 2-[1-(*Iso*-Propylimino)ethyl]pyridin, 2-[1-(Tert-Butylimino)-ethyl]pyridin, Diiminen, wie z. B. 1,2-Bis(methylimino)ethan, 1,2-Bis(ethylimino)ethan, 1,2-Bis(*iso*-propylimino)ethan, 1,2-Bis(tert-butylimino)ethan, 2,3-Bis(methylimino)butan, 2,3-Bis(ethylimino)butan, 2,3-Bis(iso-propylimino)butan, 2,3-Bis(*tert*-butylimino)butan, 1,2-Bis(phenylimino)ethan, 1,2-Bis(2-methylphenylimino)ethan, 1,2-Bis(2,6-di-*iso*-propylphenylimino)-ethan, 1,2-Bis(2,6-di-*tert*-butylphenylimino)ethan, 2,3-Bis(phenylimino)-butan, 2,3-Bis(2-methylphenylimino)butan, 2,3-Bis(2,6-di-*iso*-propylphenylimino)butan, 2,3-Bis(2,6-di-*tert*-butylphenylimino)butan, Heterocyclen enthaltend zwei Stickstoffatome, wie z. B. 2,2'-Bipyridin, o-Phenanthrolin, Diphosphinen, wie z. B. Bis(diphenylphosphino)methan, Bis(diphenylphosphino)ethan, Bis(diphenylphosphino)propan, Bis(diphenylphosphino)butan, Bis(dimethylphosphino)methan, Bis(dimethylphosphino)-ethan, Bis(dimethylphosphino)propan, Bis(diethylphosphino)methan, Bis-(diethylphosphino)ethan, Bis(diethylphosphino)propan, Bis(di-*tert*-butylphosphino)methan, Bis(di-tert-butylphosphino)ethan, Bis(*tert*-butylphosphino)propan, 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 3-Ketonaten abgeleitet von 3-Ketoestern, wie z. B. Acetessigsäureethylester, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethylaminoalanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol, Dithiolaten abgeleitet von Dithiolen, wie z. B. 1,2-Ethylendithiol, 1,3-Propylendithiol, Bis(pyrazolylboraten), Bis(imidazolyl)boraten, 3-(2-Pyridyl)-diazolen oder 3-(2-Pyridyl)-triazolen.

Bevorzugt sind weiterhin bidentate monoanionische, neutrale oder dianionische Liganden L', insbesondere monoanionische Liganden, welche mit dem Metall einen cyclometallierten Fünfring oder Sechsring mit mindestens einer Metall-Kohlenstoff-Bindung aufweisen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L' für Verbindungen gemäß Formel (1) auswählen. Generell eignet sich dafür besonders die Kombination aus zwei Gruppen, wie sie durch die folgenden Formeln (38) bis (62) dargestellt sind, wobei eine Gruppe bevorzugt über ein neutrales Stickstoffatom oder ein Carben-kohlenstoffatom bindet und die andere Gruppe bevorzugt über ein negativ geladenes Kohlenstoffatom oder ein negativ geladenes Stickstoffatom bindet. Der Ligand L' kann dann aus den Gruppen der Formeln (38) bis (62) gebildet werden, indem diese Gruppen jeweils an der durch # gekennzeichneten Position aneinander binden. Die Position, an der die Gruppen an das Metall koordinieren, sind durch * gekennzeichnet. Diese Gruppen können auch über eine oder zwei verbrückende Einheiten V an den Liganden L gebunden sein.

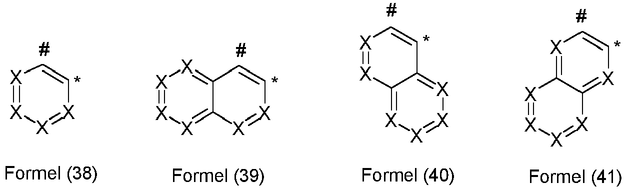

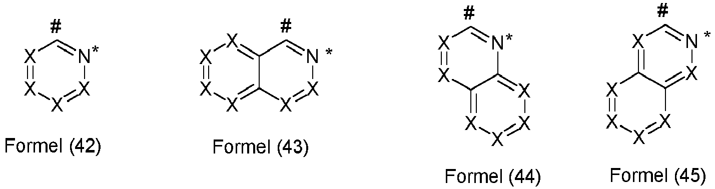

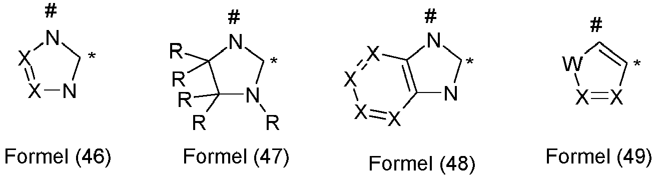

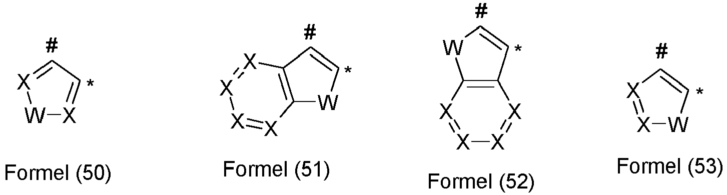

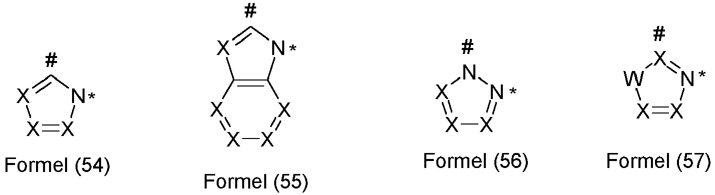

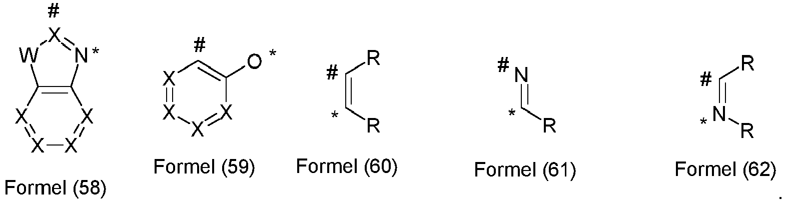

Dabei hat W die oben genannte Bedeutung und X steht bei jedem Auftreten gleich oder verschieden für CR oder N, wobei hier die oben genannte Limitierung, dass mindestens zwei benachbarte Gruppen X für CR stehen und die Reste R einen Ring der Formel (4) bilden, nicht gilt; und R hat dieselbe Bedeutung wie oben beschrieben. Bevorzugt stehen maximal drei Symbole X in jeder Gruppe für N, besonders bevorzugt stehen maximal zwei Symbole X in jeder Gruppe für N, ganz besonders bevorzugt steht maximal ein Symbol X in jeder Gruppe für N. Insbesondere bevorzugt stehen alle Symbole X für CR.

Bevorzugte Reste R in den oben aufgeführten Strukturen sind bei jedem Auftreten gleich oder verschieden ausgewählt aus der Gruppe bestehend aus H, D, F, Br, N(R¹)₂, CN, B(OR¹)₂, C(=O)R¹, P(=O)(R¹)₂, einer geradkettigen Alkylgruppe mit 1 bis 10 C-Atomen oder einer Alkenyl- oder Alkinylgruppe mit 2 bis 10 C-Atomen oder einer verzweigten oder cyclischen Alkylgruppe mit 3 bis 10 C-Atomen, die jeweils mit einem oder mehreren Resten R¹ substituiert sein kann, wobei ein oder mehrere H-Atome durch D oder F ersetzt sein können, oder einem aromatischen oder heteroaromatischen Ringsystem mit 5 bis 14 aromatischen Ringatomen, das jeweils durch einen oder mehrere Reste R¹ substituiert sein kann; dabei können zwei oder mehrere benachbarte Reste R auch miteinander ein mono- oder polycyclisches, aliphatisches, aromatisches und/oder benzoannelliertes Ringsystem bilden. Besonders bevorzugte Reste R sind bei jedem Auftreten gleich oder verschieden ausgewählt aus der Gruppe bestehend aus H, D, F, Br, CN, B(OR¹)₂, einer geradkettigen Alkylgruppe mit 1 bis 5 C-Atomen, insbesondere Methyl, oder einer verzweigten oder cyclischen Alkylgruppe mit 3 bis 5 C-Atomen, insbesondere iso-Propyl oder tert-Butyl, wobei ein oder mehrere H-Atome durch D oder F ersetzt sein können, oder einem aromatischen oder heteroaromatischen Ringsystem mit 5 bis 12 aromatischen Ringatomen, das jeweils durch einen oder mehrere Reste R¹ substituiert sein kann; dabei können zwei oder mehrere Reste R auch miteinander ein mono- oder polycyclisches, aliphatisches, aromatisches und/oder benzoannelliertes Ringsystem bilden.

Die erfindungsgemäßen Komplexe können facial bzw. pseudofacial sein, oder sie können meridional bzw. pseudomeridional sein.

Die Liganden L können je nach Struktur auch chiral sein. Dies ist insbesondere dann der Fall, wenn sie eine bicyclische Gruppe der Formel (4) enthalten oder wenn sie Substituenten enthalten, beispielsweise Alkyl-, Alkoxy, Dialkylamino- oder Aralkylgruppen, welche ein oder mehrere Stereozentren aufweisen. Da es sich bei der Grundstruktur des Komplexes auch um eine chirale Struktur handeln kann, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Die erfindungsgemäßen Metallkomplexe sind prinzipiell durch verschiedene Verfahren darstellbar. Es haben sich jedoch die im Folgenden beschriebenen Verfahren als besonders geeignet herausgestellt.

Daher ist ein weiterer Gegenstand der vorliegenden Erfindung ein Verfahren zur Herstellung der Metallkomplex-Verbindungen gemäß Formel (1) durch Umsetzung der entsprechenden freien Liganden L und gegebenenfalls L' mit Metallalkoholaten der Formel (67), mit Metallketoketonaten der Formel (68), mit Metallhalogeniden der Formel (69), mit dimeren Metallkomplexen der Formel (70) oder mit Metallkomplexen der Formel (71), 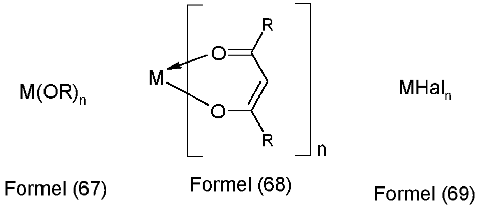 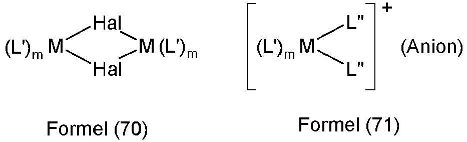 wobei die Symbole M, m, n und R die oben angegebenen Bedeutungen haben, Hal = F, Cl, Br oder I ist, L" für einen Alkohol, insbesondere für einen Alkohol mit 1 bis 4 C-Atomen oder ein Nitril, insbesondere Acetonitril oder Benzonitril, steht und (Anion) ein nicht-koordinierendes Anion ist, wie beispielsweise Triflat.

Es können ebenfalls Metallverbindungen, insbesondere Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht.

Geeignete Platin-Edukte sind beispielsweise PtCl₂, K₂[PtCl₄], PtCl₂(DMSO)₂, Pt(Me)₂(DMSO)₂ oder PtCl₂(Benzonitril)₂.

Die Synthese der Komplexe wird bevorzugt durchgeführt wie in WO 2002/060910, WO 2004/085449 und WO 2007/065523 beschrieben. Heteroleptische Komplexe können beispielsweise auch gemäß WO 2005/042548 synthetisiert werden. Dabei kann die Synthese beispielsweise auch thermisch, photochemisch und/oder durch Mikrowellenstrahlung aktiviert werden. In einer bevorzugten Ausführungsform der Erfindung wird die Reaktion ohne die Verwendung eines zusätzlichen Lösemittels in der Schmelze durchgeführt. Dabei bedeutet "Schmelze", dass der Ligand geschmolzen vorliegt und die Metall-Vorstufe in dieser Schmelze gelöst oder suspendiert ist. Zur Aktivierung der Reaktion ist es weiterhin auch möglich, eine Lewis-Säure, beispielsweise ein Silbersalz oder AlCl₃, zuzugeben.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Die erfindungsgemäßen Verbindungen können auch mit einem Polymer gemischt werden. Ebenso ist es möglich, diese Verbindungen kovalent in ein Polymer einzubauen. Dies ist insbesondere möglich mit Verbindungen, welche mit reaktiven Abgangsgruppen, wie Brom, Iod, Chlor, Boronsäure oder Boronsäureester, oder mit reaktiven, polymerisierbaren Gruppen, wie Olefinen oder Oxetanen, substituiert sind. Diese können als Monomere zur Erzeugung entsprechender Oligomere, Dendrimere oder Polymere Verwendung finden. Die Oligomerisation bzw. Polymerisation erfolgt dabei bevorzugt über die Halogenfunktionalität bzw. die Boronsäurefunktionalität bzw. über die polymerisierbare Gruppe. Es ist weiterhin möglich, die Polymere über derartige Gruppen zu vernetzen. Die erfindungsgemäßen Verbindungen und Polymere können als vernetzte oder unvernetzte Schicht eingesetzt werden.

Weiterer Gegenstand der Erfindung sind daher Oligomere, Polymere oder Dendrimere enthaltend eine oder mehrere der oben aufgeführten erfindungsgemäßen Verbindungen, wobei ein oder mehrere Bindungen der erfindungsgemäßen Verbindung zum Polymer, Oligomer oder Dendrimer vorhanden sind. Je nach Verknüpfung der erfindungsgemäßen Verbindung bildet diese daher eine Seitenkette des Oligomers oder Polymers oder ist in der Hauptkette verknüpft. Die Polymere, Oligomere oder Dendrimere können konjugiert, teilkonjugiert oder nicht-konjugiert sein. Die Oligomere oder Polymere können linear, verzweigt oder dendritisch sein. Für die Wiederholeinheiten der erfindungsgemäßen Verbindungen in Oligomeren, Dendrimeren und Polymeren gelten dieselben Bevorzugungen, wie oben beschrieben.

Zur Herstellung der Oligomere oder Polymere werden die erfindungsgemäßen Monomere homopolymerisiert oder mit weiteren Monomeren copolymerisiert. Bevorzugt sind Copolymere, wobei die Einheiten gemäß Formel (1) bzw. die oben ausgeführten bevorzugten Ausführungsformen zu 0.01 bis 99.9 mol%, bevorzugt 5 bis 90 mol%, besonders bevorzugt 20 bis 80 mol% vorhanden sind. Geeignete und bevorzugte Comonomere, welche das Polymergrundgerüst bilden, sind gewählt aus Fluorenen (z. B. gemäß EP 842208 oder WO 2000/022026), Spirobifluorenen (z. B. gemäß EP 707020, EP 894107 oder WO 2006/061181), Para-phenylenen (z. B. gemäß WO 92/18552), Carbazolen (z. B. gemäß WO 2004/070772 oder WO 2004/113468), Thiophenen (z. B. gemäß EP 1028136), Dihydrophenanthrenen (z. B. gemäß WO 2005/014689), cis- und trans-Indenofluorenen (z. B. gemäß WO 2004/041901 oder WO 2004/113412), Ketonen (z. B. gemäß WO 2005/040302), Phenanthrenen (z. B. gemäß WO 2005/104264 oder WO 2007/017066) oder auch mehreren dieser Einheiten. Die Polymere, Oligomere und Dendrimere können noch weitere Einheiten enthalten, beispielsweise Lochtransporteinheiten, insbesondere solche basierend auf Triarylaminen, und/oder Elektronentransporteinheiten.

Nochmals ein weiterer Gegenstand der vorliegenden Erfindung ist eine Formulierung, enthaltend eine erfindungsgemäße Verbindung bzw. ein erfindungsgemäßes Oligomer, Polymer oder Dendrimer und mindestens eine weitere Verbindung. Die weitere Verbindung kann beispielsweise ein Lösemittel sein. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Für die Verarbeitung aus Lösung sind Lösungen bzw. Formulierungen der Verbindungen gemäß Formel (1) erforderlich. Es kann dabei bevorzugt sein, Mischungen aus zwei oder mehr Lösemitteln zu verwenden. Geeignete Lösemittel sind beispielsweise Toluol, o-, m- oder p-Xylol, Anisole, Methylbenzoat, Dimethylanisole, Mesitylene, Tetralin, Veratrol, Chlorbenzol, Phenoxytoluol, insbesondere 3-Phenoxytoluol, Dioxan, THF, Methyl-THf, THP oder Gemische dieser Lösemittel. Wie solche Lösungen hergestellt werden können, ist dem Fachmann bekannt und beispielsweise in der WO 2002/072714, der WO 2003/019694 und der darin zitierten Literatur beschrieben.

Die oben beschriebenen Komplexe gemäß Formel (1) bzw. die oben aufgeführten bevorzugten Ausführungsformen können in der elektronischen Vorrichtung als aktive Komponente verwendet werden. Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten.

Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) und dem Matrixmaterial enthält zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% der Verbindung gemäß Formel (1) bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Komplexe gemäß Formel (1) als Co-Matrix für längerwellig emittierende Triplettemitter, beispielsweise für grün oder rot emittierende Triplettemitter, eingesetzt werden.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial oder als Elektronenblockiermaterial. Ebenso lassen sich die erfindungsgemäßen Komplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen. Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1. Organische Elektrolumineszenzvorrichtungen enthaltend Verbindungen gemäß Formel (1) als emittierende Materialien weisen eine sehr gute Lebensdauer auf.
2. Organische Elektrolumineszenzvorrichtungen enthaltend Verbindungen gemäß Formel (1) als emittierende Materialien weisen eine hervorragende Effizienz auf. Insbesondere ist die Effizienz deutlich höher gegenüber analogen Verbindungen, die keine Struktureinheit gemäß Formel (4) enthalten.
3. Die erfindungsgemäßen Metallkomplexe weisen teilweise ein sehr schmales Emissionsspektrum auf, was zu einer hohen Farbreinheit der Emission führt, wie sie insbesondere für Displayanwendungen wünschenswert ist.
4. Die erfindungsgemäßen Metallkomplexe weisen im Vergleich zu analogen Verbindungen, welche keine Struktureinheit gemäß Formel (4) enthalten, eine reduzierte Aggregation auf. Dies äußert sich in einer niedrigeren Sublimationstemperatur sowie einer höheren Löslichkeit sowie in der Elektrolumineszenzvorrichtung in einer verringerten Triplett-Triplett-Löschung.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beschreibung der Figuren

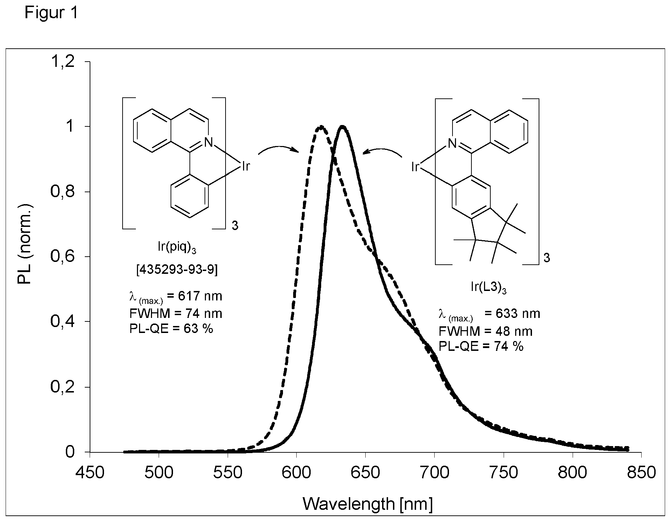

Figur 1 zeigt das Photolumineszenzspektrum eines Tris(phenylisochinolin)-iridium-Komplexes (nicht Gegenstand der Erfindung), welcher einen ankondensierten aliphatischen Fünfring enthält, im Vergleich zu dem Spektrum des entsprechenden Komplexes ohne diese ankondensierte Gruppe. Die Spektren wurden in einer ca. 10⁻⁵ molaren Lösung in entgastem Toluol bei Raumtemperatur gemessen. Es lässt sich deutlich die schmalere Emissionsbande mit einer Halbwertsbreite FWHM von 48 nm gegenüber 74 nm bei der Verbindung ohne eine Gruppe der Formel (3) erkennen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### A: Synthese der Synthone S:

### Beispiel S1: 1,1,2,2,3,3-Hexamethyl-indan-d18, S1

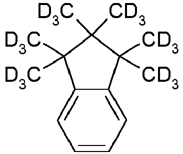

Darstellung analog zu J. Baran, et al., J. Org. Chem. 1988, 53, 19, 4626. Ein auf -78°C gekühltes Gemisch aus 160.7 g (1 mol) 2-Chlor-2-phenylpropan-d6 [53102-26-4], 230.8 g (2,4 mol) 2,3-Dimethylbut-2-en-d12 [69165-86-2] und 2500 ml wasserfreiem Dichlormethan wird tropfenweise unter gutem Rühren mit 18.7 ml (170 mmol) Titantetrachlorid versetzt und 2 h nachgerührt. Man gießt die kalte Reaktionsmischung unter gutem Rühren in 1500 ml 3N Salzsäure ein, rührt 20 min. nach, trennt die organische Phase ab, wäscht diese zweimal mit je 1000 ml Wasser, einmal mit 500 ml ges. Natriumcarbonat-Lösung, einmal mit 500 ml gesättigter Kochsalzlösung, trocknet über Magnesiumsulfat, filtriert vom Trockenmittel ab, befreit das Filtrat im Vakuum vom Dichlormethan und destilliert den Rückstand fraktioniert (Kernfraktion 60-65 °C, ca. 0.5 mbar). Ausbeute: 163.1 g (740 mmol), 74 %; Reinheit: ca. 95 %ig nach NMR.

Analog werden folgende Verbindungen dargestellt:

| Bsp. | Edukte | Produkt | Ausbeute |
|---|---|---|---|
| S2 | 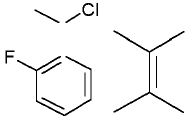 | 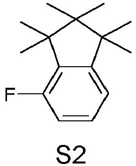 | 68 % |
| | 1716-38-7 / 563-79-1 | | |
| S3 | 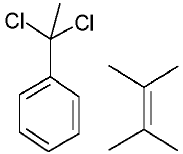 | 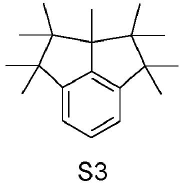 | 49 % |
| | 934-53-2 / 563-79-1 Verwendung von 4.4 mol 2,3-Dimethylbut-2-en | | |

### Beispiel S4: 1,1,3,3-Tetramethyl-indan-5-boronsäure-pinakolester, S4-B

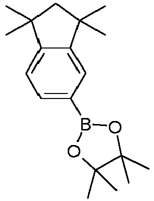

### A) 5-Brom-1,1,3,3-tetramethyl-indan [169695-24-3], S4-Br

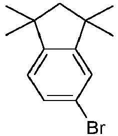

Eine auf 0 °C gekühlte Lösung von 87.2 g (500 mmol) 1,1,3,3-Tetramethylindan [4834-33-7] in 1000 ml Dichlormethan wird mit 0.6 g wasserfreiem Eisen(III)chlorid und dann unter Lichtausschluss tropfenweise mit einer Mischung von 25.6 ml (500 mol) Brom und 300 ml Dichlormethan so versetzt, dass die Temperatur + 5 °C nicht übersteigt. Man rührt die Reaktionsmischung 16 h bei Raumtemperatur nach, versetzt dann langsam mit 300 ml gesättigter Natriumsulfit-Lösung, trennt die wässrige Phase ab, wäscht die organische Phase dreimal mit je 1000 ml Wasser, trocknet über Natriumsulfat, filtriert über eine kurze Säule aus Kieselgel und zieht dann das Lösungsmittel ab. Abschießend wird der Feststoff einmal aus wenig (ca. 100 - 150 ml) Ethanol umkristallisiert. Ausbeute: 121.5 g (480 mmol), 96 %; Reinheit: ca. 95 %ig nach ¹H-NMR.

### B) 1,1,3,3-Tetramethyl-indan-5-boronsäure-pinakolester, S4-B

Ein Gemisch von 25.3 g (100 mmol) S4-Br, 25.4 g (120 mmol) Bis(pinacolato)diboran [73183-34-3], 29.5 g (300) mmol Kaliumacetat, wasserfrei, 561 mg (2 mmol) Tricyclohexylphosphin und 249 mg (1 mmol) Palladium(II)acetat und 400 ml Dioxan wird 16 h bei 80 °C gerührt. Nach Entfernen des Lösungsmittels im Vakuum wird der Rückstand in 500 ml Dichlormethan aufgenommen, über ein Celite-Bett filtriert, das Filtrat wird bis zur beginnenden Kristallisation im Vakuum eingeengt und abschließend noch tropfenweise mit ca. 100 ml Methanol versetzt, um die Kristallisation zu vervollständigen. Ausbeute: 27.9 g (93 mmol), 93 %; Reinheit: ca. 95 %ig nach ¹H-NMR. Als Öl anfallende Boronsäureester können auch ohne Reinigung weiter umgesetzt werden.

Analog werden folgende Verbindungen dargestellt:

| Bsp. | Edukte | Bromid | Produkt Boronsäureester | Ausbeute 2 Stufen |
|---|---|---|---|---|
| S5 | 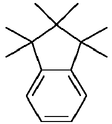 | 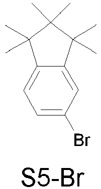 | 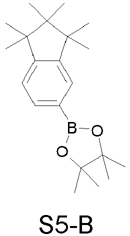 | 80% |
| | 91324-94-6 | | | |
| S6 | 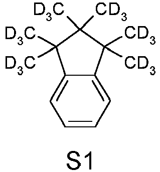 | 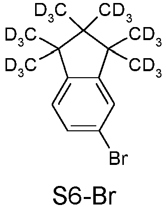 | 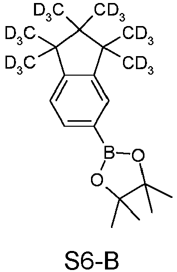 | 78% |
| S7 | 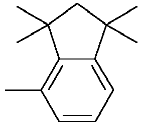 | 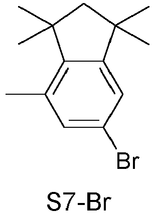 | 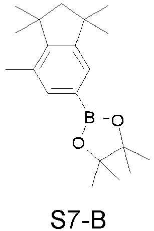 | 60% |
| | 479070-73-0 | destillative Regioisomerentrennung | | |
| S8 | 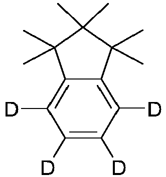 | 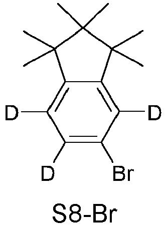 | 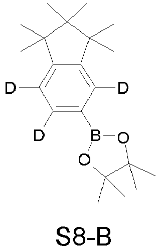 | 81% |
| | 142076-41-3 | | | |
| S9 | 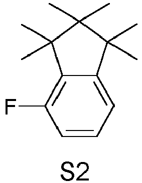 | 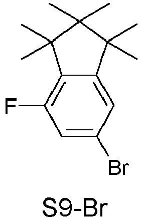 | 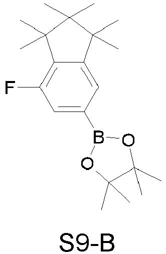 | 43% |
| | | destillative Regioisomerentrennung | | |
| S10 | 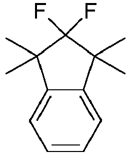 | 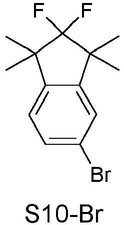 | 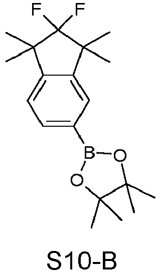 | 78% |
| | 59508-28-0 | | | |
| S11 | 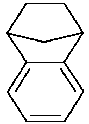 | 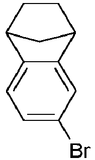 | 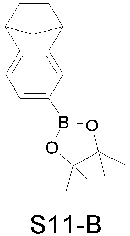 | 80% |
| | 4486-29-7 | 16499-72-2 S11-Br | | |
| S12 | 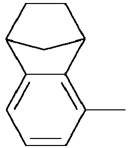 | 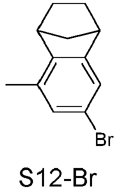 | 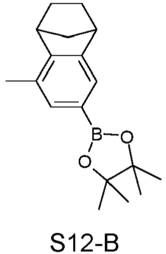 | 68% |
| | 215725-16-9 | desti llative Regioisomerentrennung | | |
| S13 | 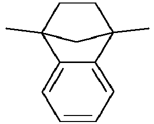 | 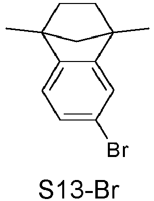 | 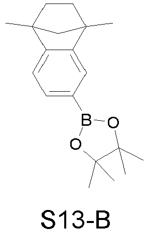 | 77% |
| | 66684-45-5 | | | |
| S14 | 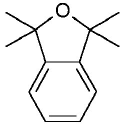 | 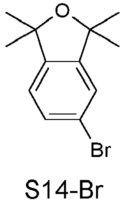 | 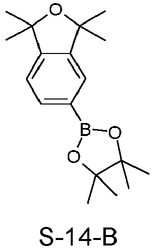 | 79% |
| | 113710-83-1 | | | |
| S15 | 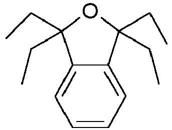 | 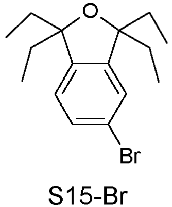 | 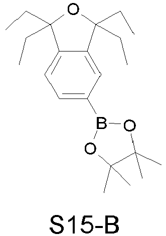 | 70% |
| | 65089-09-0 | | | |
| S16 | 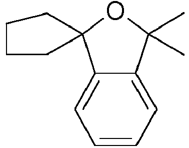 | 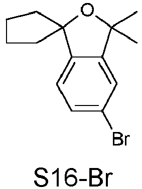 | 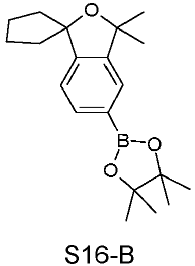 | 54% |
| | 1020726-74-2 | desti llative Regioisomerentrennung | | |
| S17 | 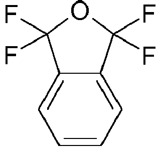 | 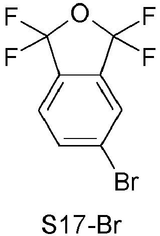 | 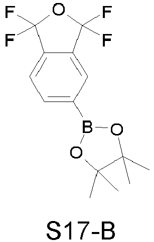 | 81% |
| | 651-39-8 | | | |
| S18 | 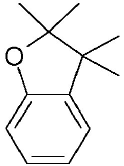 | 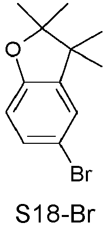 | 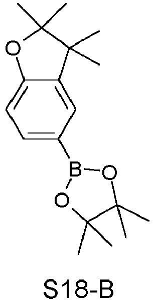 | 56% |
| | 124797-68-8 | destillative Regioisomerentrennung | | |
| S19 | | 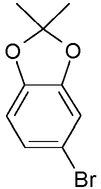 | 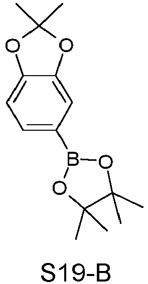 | 94% 1 Stufe |
| | | 73790-19-9 S19-Br | | |
| S20 | 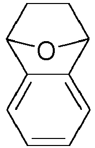 | 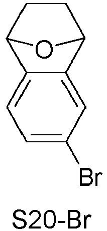 | 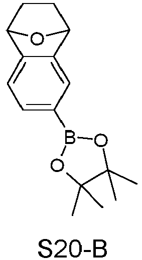 | 82% |
| | 35185-96-7 | | | |
| S21 | 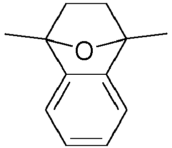 | 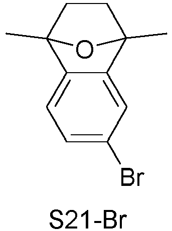 | 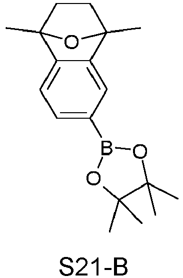 | 79% |
| | 61200-08-6 | | | |
| S22 | 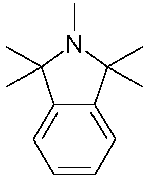 | 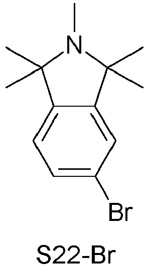 | 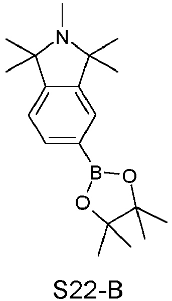 | 23% |
| | 3723-85-1 | | | |
| S23 | 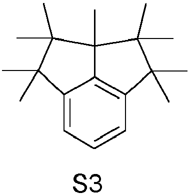 | 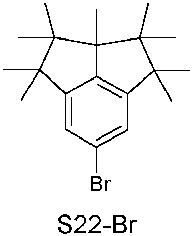 | 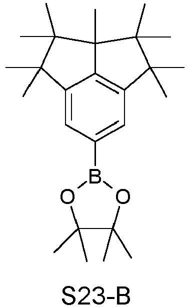 | 77% |

### Beispiel S24: 5,5,7,7-Tetramethyl-6,7-dihydro-5H-[2]pyridin, S24

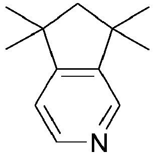

Durchführung analog D. L. Boger et al., J. Org. Chem., 1981, 46, 10, 2180. Ein Gemisch aus 14.0 g (100 mmol) 2,2,4,4-Tetramethyl-cyclo-pentanon [4694-11-5], 9.0 ml (110 mmol) Pyrrolidin [123-75-1], 951 mg (5 mmol) p-Toluolsulfonsäure-Monohydrat [6192-52-5] und 500 ml Toluol wird so lange am Wasserabscheider erhitzt, bis die Wasserabscheidung beendet ist (typischerweise ca. 16 h). Danach wird das Toluol im Vakuum entfernt und der ölige Rückstand einer Kugelrohrdestillation unterzogen. Die so als bernsteinfarbenenes Öl erhaltenen 17.4 g (90 mmol) 1-(3,3,5,5-Tetramethyl-cyclopent-1-enyl)-pyrrolidin werden in 50 ml Chloroform aufgenommen und bei Raumtemperatur langsam zu einer Lösung von 10.5 g (130 mmol) 1,2,4-Triazin in 50 ml Chloroform getropft. Nach beendeter Zugabe rührt man die orangenfarbene Lösung weitere 2 h bei Raumtemperatur nach und steigert dann die Temperatur auf 50 °C und rührt 45 h nach. Nach Entfernen das Chloroforms im Vakuum wird der Rückstand an Kieselgel mit Diethylether:n-Heptan (1:1, vv) chromatographiert. Ausbeute: 8.9 g (51 mmol), 51 %; Reinheit: ca. 97 %ig nach ¹H NMR.

Analog werden folgende Verbindungen dargestellt:

| Bsp. | Edukte | Produkt | Ausbeute |
|---|---|---|---|
| S25 | 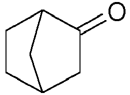 | 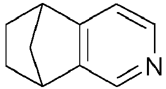 | 42% |
| | 497-38-1 | 105275-30-7 S25 | |
| S26 | 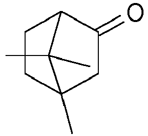 | 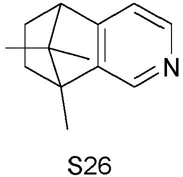 | 37 % |
| | 70897-07-3 | | |

### Beispel S27: 5,6-Dibrom-1,1,2,2,3,3-hexamethyl-indan, S27

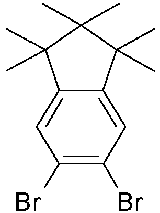

Eine Lösung von 101.2 g (500 mmol) 1,1,2,2,3,3-Hexamethyl-indan [91324-94-6] in 2000 ml Dichlormethan wird mit 1.3 g wasserfreiem Eisen(III)chlorid und dann unter Lichtausschluss tropfenweise mit einer Mischung von 64.0 ml (1.25 mol) Brom und 300 ml Dichlormethan so versetzt, dass die Temperatur 25 °C nicht übersteigt, gegebenenfalls wird mit einem Kaltwasserbad gegengekühlt. Man rührt die Reaktionsmischung 16 h bei Raumtemperatur nach, versetzt dann langsam mit 500 ml gesättigter Natriumsulfit-Lösung, trennt die wässrige Phase ab, wäscht die organische dreimal mit je 1000 ml Wasser, trocknet über Natriumsulfat, filtriert über eine kurze Säule aus Kieselgel und zieht dann das Lösungsmittel ab. Abschießend wird der Feststoff einmal aus wenig (ca. 100 ml) Ethanol umkristallisiert. Ausbeute: 135.8 g (377 mmol), 75 %; Reinheit: ca. 95 %ig nach ¹H NMR.

Analog werden folgende Verbindungen dargestellt:

| Bsp. | Edukte | Produkt | Ausbeute |
|---|---|---|---|
| S28 | 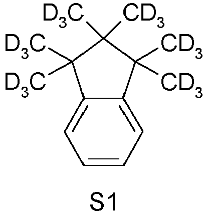 | 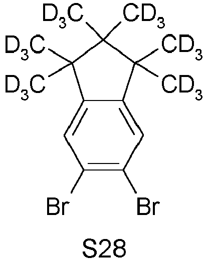 | 78 % |
| S29 | 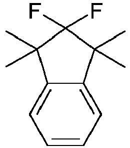 | 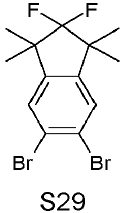 | 73 % |
| | 59508-28-0 | | |
| S30 | 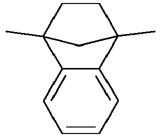 | 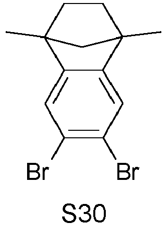 | 76 % |
| | 66684-45-5 | | |
| S31 | 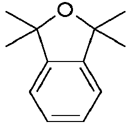 | 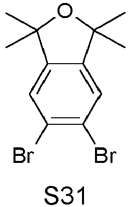 | 80 % |
| | 113710-83-1 | | |
| S32 | 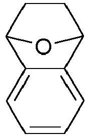 | 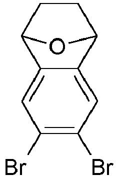 | 77 % |
| | 35185-96-7 | 749859-07-2 S32 | |
| S33 | 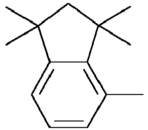 | 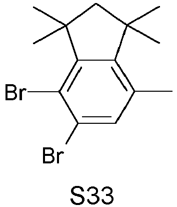 | 19 % |
| | | chromatographische Trennung der Regioisomeren | |
| S34 | 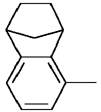 | 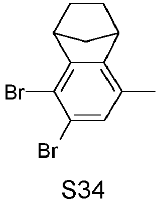 | 23 % |
| | | chromatographische Trennung der Regioisomeren | |

### Beispel S35: 5,6-Diamino-1,1,2,2,3,3-hexamethyl-indan, S35

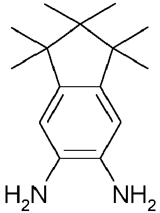

### A: 5,6-Dinitro-1,1,2,2,3,3-tetramethyl-indan, S35a

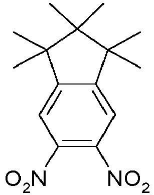

Zu einer gut gerührten, auf 0° C gekühlten Mischung aus 101,2 g (500 mmol) 1,1,2,2,3,3-Hexamethyl-indan [91324-94-6] und 350 ml 95 Gew.-%iger Schwefelsäure tropft man langsam 350 ml 100 Gew.-%ige Salpetersäure so zu, dass die Temperatur + 5° C nicht übersteigt. Anschließend lässt man während 2 - 3 h langsam auf Raumtemperatur erwärmen und gießt die Reaktionsmischung dann in ein gut gerührtes Gemisch aus 6 kg Eis und 2 kg Wasser. Man stellt durch Zugabe von 40 Gew.-%iger NaOH auf pH = 8-9 ein, extrahiert dreimal mit je 1000 ml Ethylacetat, wäscht die vereinigten org. Phasen zweimal mit je 1000 ml Wasser, trocknet über Magnesiumsulfat, entfernt dann das Ethylacetat im Vakuum fast vollständig, bis zur beginnenden Kristallisation, und vervollständigt die Kristallisation durch Zusatz von 500 ml Heptan. Man saugt von den so erhaltenen beigefarbenen Kristallen ab und trocknet diese im Vakuum. Ausbeute: 136.2 g (466 mmol), 93 %; Reinheit: ca. 94 %ig nach ¹H-NMR, Rest ca. 4 % 4,6-Dinitro-1,1,3,3-tetramethyl-indan. Aus der ML können ca. 3 % 4,5-Dinitro-1,1,3,3-tetramethyl-indan, S35b isoliert werden.

### B: 5,6-Diamino-1,1,2,2,3,3-hexamethyl-indan, S35

136.2 g (466 mmol) 5,6-Dinitro-1,1,2,2,3,3-hexamethyl-indan, S35a werden bei Raumtemperatur in 1200 ml Ethanol an 10 g Palladium/Kohle bei 3 bar Wasserstoffdruck während 24 h hydriert. Die Reaktionsmischung wird zweimal über ein Celite-Bett filtriert, der nach Entferen des Ethanols erhaltene braune Feststoff wird Kugelrohr-destilliert (T ca. 160 °C, p ca. 10⁻⁴ mbar). Ausbeute: 98.5 g (424 mmol), 91 %; Reinheit: ca. 95 % nach ¹H-NMR.

Analog werdem folgende Verbindungen dargestellt:

| Bsp. | Edukte | Produkt | Ausbeute |
|---|---|---|---|
| S35 b | 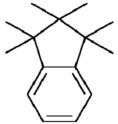 | 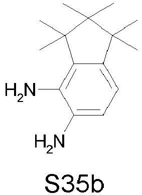 | 2% |
| | 91324-94-6 | | |
| S36 | 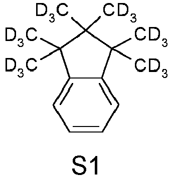 | 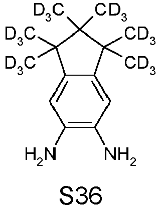 | 80 % |
| S37 | 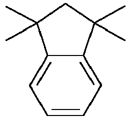 | 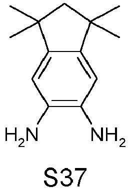 | 84 % |
| | 4834-33-7 | | |
| S38 | 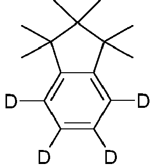 | 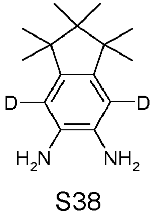 | 76 % |
| | 142076-41-3 | | |
| S39 | 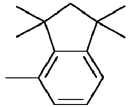 | 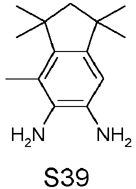 | 68 % |
| | 479070-73-0 | | |
| S40 | 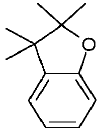 | 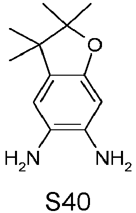 | 63 % |
| | 124797-68-8 | | |
| S41 | 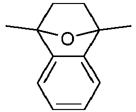 | 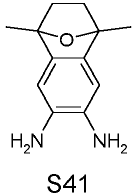 | 77 % |
| | 61200-08-6 | | |
| S42 | 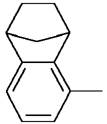 | 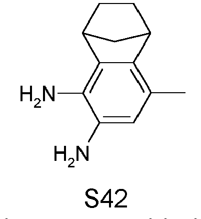 | 16 % |
| | 215725-16-9 | chromatographische Trennung der Regioisomeren | |

### Beispel S43: N-[2-(1,1,2,2,3,3-Hexamethylindan-5-yl)-ethyl]-benzamid, S43

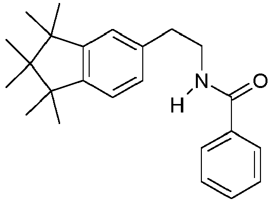

### A: 1,1,2,2,3,3-Hexamethylindan-5-carboxaldehyd, S43a

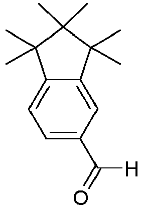

Eine auf -78 °C gekülte, gut gerührte Lösung von 140.6 g (500 mmol) 5-Brom-1,1,2,2,3,3-hexamethylindan, S5-Br, in 1000 ml THF wird tropfenweise so mit 200 ml (500 mmol) n-BuLi, 2.5 M in n-Hexan versetzt, dass die Tempertur -55 °C nicht übersteigt. Nach beendeter Zugabe rührt man noch 30 min. nach und lässt dann eine Mischung aus 42.3 ml (550 mmol) DMF und 50 ml THF unter gutem Rühren zulaufen. Man rührt 1 h bei -78 °C nach, lässt dann auf Raumtemperatur erwärmen und quencht durch Zugabe von 300 ml gesättigter Ammoniumchlorid-Lösung. Man trennt die organische Phase ab, entfernt das THF im Vakuum, nimmt den Rückstand in 500 ml Ethylacetat auf, wäscht einmal mit 300 ml 5 %iger Salzsäure, zweimal mit je 300 ml Wasser, einmal mit 300 ml gesättigter Kochsalzlösung, trocknet die organische Phase über Magnesiumsulfat und entfernt dann das Lösungsmittel im Vakuum. Der Rückstand wird ohne weitere Reinigung in Stufe B eingesetzt. Ausbeute: 107.1 g (465 mmol), 93 %; Reinheit: ca. 95 % nach ¹H-NMR.

Analog können folgende Verbindungen dargestellt werden:

| Bsp. | Edukt | Produkt | Ausbeute |
|---|---|---|---|
| S44a | 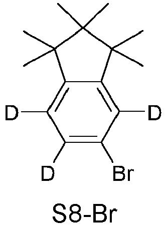 | 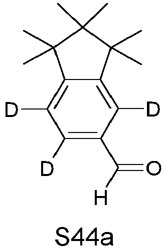 | 91% |
| S45a | 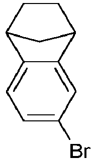 | 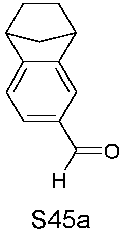 | 89% |
| | 16499-72-2 S11-Br | | |
| S46a | 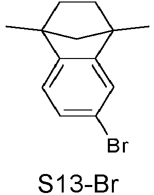 | 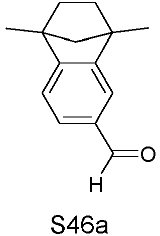 | 95% |
| S47a | 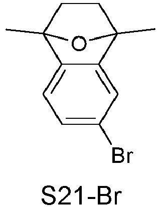 | 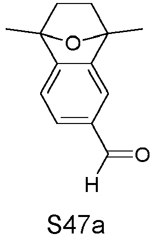 | 90% |

### B: 2-(1,1,2,2,3,3-Hexamethyl-5-indanyl)-ethylamin, S43b

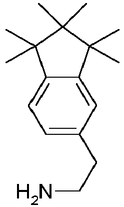

Ein Gemisch aus 80.6 g (350 mmol) 1,1,2,2,3,3-Hexamethylindan-5-carboxaldehyd, S43a, 400 ml Nitromethan und 4.6 g (70 mmol) Ammoniumacetat, wasserfrei wird 2 h unter Rückfluss erhitzt, bis das Edukt verbraucht ist (DC-Kontrolle). Nach Erkalten gießt man die Reaktionsmischung in 1000 ml Wasser, extrahiert dreimal mit je 300 ml Dichlormethan, wäscht die vereinigten organischen Phasen dreimal mit gesättigter Natriumhydrogencarbonat-Lösung, dreimal mit je 300 ml Wasser und einmal mit 300 ml gesätigter Kochsalzlösung, trocknet über Magnesiumsulfat und entfernt das Lösungsmittel im Vakuum. Der dunkle ölige Rückstand wird in 1000 ml THF gelöst und unter Eiskühlung langsam zu einer Lösung von 38.0 g (1.0 mol) Lithiumaluminiumhydrid in 1000 ml THF getropft (Vorsicht: Exotherme Reaktion!). Nach beendeter Zugabe lässt man auf Raumtemperatur erwärmen und rührt die Reaktionsmischung 20 h bei Raumtemperatur nach. Die Reaktionsmischung wird unter Eiskühlung durch langsame Zugabe von 500 ml gesättigter Natriumsulfat-Lösung hydrolysiert. Man saugt von den Salzen ab, wäscht diese mit 500 ml THF nach, entfernt das THF im Vakuum, nimmt den Rückstand in 1000 ml Dichlormethan auf, wäscht die Lösung dreimal mit je 300 ml Wasser, einmal mit 300 ml gesättigter Kochsalzlösung, trocknet über Magnesiumsulfat und entfernt dann das Lösungsmittel im Vakuum. Die Reinigung erfolgt durch Kugelrohrdestillation (p ca. 10⁻⁴ mbar, T = 200 °C). Ausbeute: 67.0 g (273 mmol), 78 %; Reinheit: ca. 95 % nach ¹H-NMR.

Analog können folgende Verbindungen dargestellt werden:

| Bsp. | Edukt | Produkt | Ausbeute |
|---|---|---|---|
| S44b | 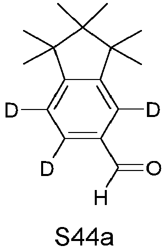 | 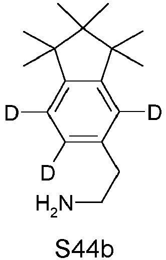 | 74% |
| S45b | 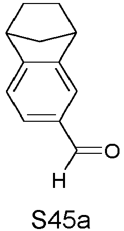 | 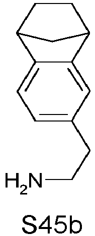 | 77% |
| S46b | 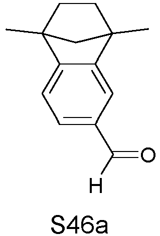 | 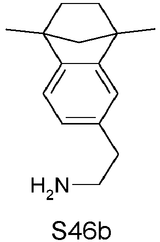 | 75% |
| S47b | 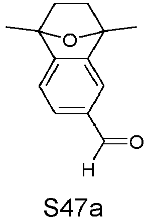 | 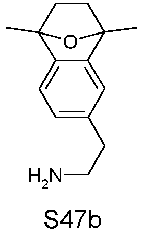 | 71% |

### C: N-[2-(1,1,2,2,3,3-Hexamethylindan-5-yl)-ethyl]-benzamid, S43

Eine Mischung von 24.5 g (100 mmol) 2-(1,1,2,2,3,3-Hexamethyl-5-indanyl)-ethylamin, S43b, 14.1 ml (100 mmol) Triethylamin und 150 ml Dichlormethan wird bei 0 °C mit einer Lösung von 14.1 g (100 mmol) Benzoesäurechlorid [98-88-4] in 100 ml Dichlormethan unter gutem Rühren tropfenweise so versetzt, dass die Temperatur 30 °C nicht übersteigt. Anschließend wird 1 h bei Raumtemperatur nachgerührt. Das Dichlormethan wird im Vakuum entfernt, der farblose Feststoff wird mit 100 ml Methanol versetzt, abgesaugt, dreimal mit 50 ml Methanol gewaschen und im Vakuum getrocknet. Ausbeute: 31.1 g (89 mmol), 89 %; Reinheit: ca. 98 % nach ¹H-NMR.

Analog können folgende Verbindungen dargestellt werden:

| Bsp. | Edukt | Carbonsäurechlorid | Produkt | Ausbeute |
|---|---|---|---|---|
| S44 | 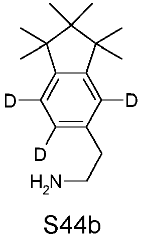 | 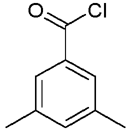 | 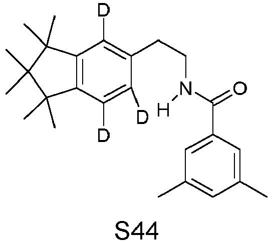 | 74% |
| S45 | 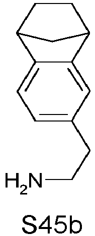 | 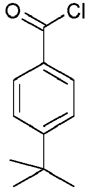 | 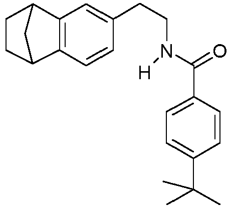 | 77% |
| | | | 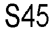 | |
| S46 | 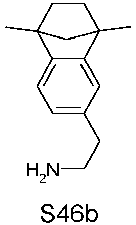 | 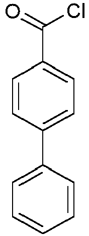 | 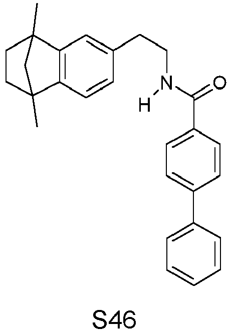 | 75% |
| S47 | 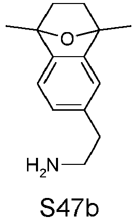 | 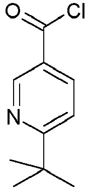 | 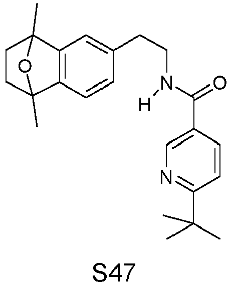 | 71% |
| S48 | 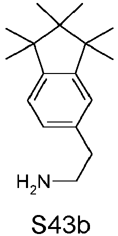 | 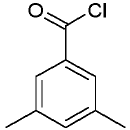 | 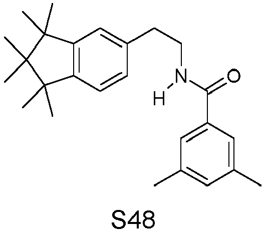 | 86 % |
| S49 | 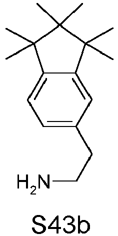 | 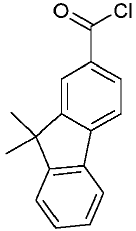 | 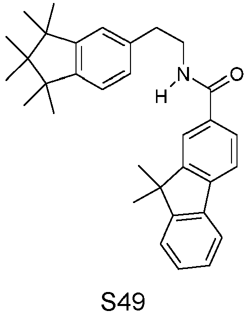 | 88 % |

### Beispiel S50: 2,7-Di-tert-butyl-9,9'-(6-brompyridin-2-yl)xanthen, S50

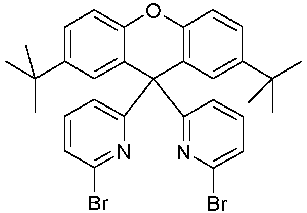

Eine Lösung von 84.7 g (300 mmol) Di(4-tert-butylphenyl)ether [24085-65-2] in 1500 ml Diethylether wird bei Raumtemperatur mit 120 ml (300 mmol) n-BuLi, 2.5 M in n-Hexan versetzt und dann 60 h unter Rückfluss gerührt. Nach Abkühlen auf -10 °C wird die Reaktionsmischung portionsweise mit 82.1 g (240mmol) Bis-(6-brom-pyridin-2-yl)methanon versetzt und dann 1.5 h bei -10 °C nachgerührt. Man quencht die Reaktionsmischung durch Zugabe von 30 ml Ethanol, rotiert das Lösungsmittel komplett im Vakuum ab, nimmt den Rückstand in 1000 ml Eisessig auf, gibt unter Rühren 150 ml Essigsäureanhydrid und dann tropfenweise 30 ml konz. Schwefelsäure zu und rührt 3 h bei 60 °C nach. Dann entfernt man das Lösungsmittel im Vakuum, nimmt den Rückstand in 1000 ml Dichlormethan auf und stellt unter Eiskühlung durch Zugabe von 10 Gew.-%iger, wässriger NaOH alkalisch. Man trennt die organische Phase ab, wäscht diese dreimal mit je 500 ml Wasser, trocknet über Magnesiumsulfat, engt die organische Phase komplett ein und nimmt den Rückstand in 500 ml Methanol auf, homogenisiert in der Wärme und rührt dann 12 h nach, wobei das Produkt kristallisiert. Der nach Absaugen erhaltene Feststoff wird in 1000 ml Dichlormethan gelöst, die Lösung wird über ein Celite-Bett filtriert, das Filtrat wird zur Tockene eingeengt, der Rückstand wird zweimal aus Toluol: Methanol (1:1) umkristallisiert und dann im Vakuum getrocknet. Ausbeute: 56.3 g (87 mmol), 36 %; Reinheit: ca. 95 % nach ¹H-NMR.

Analog kann folgende Verbindung dargestellt werden:

| Bsp. | Edukt | Produkt | Ausbeute |
|---|---|---|---|
| S51 | 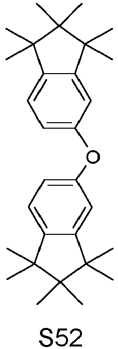 | 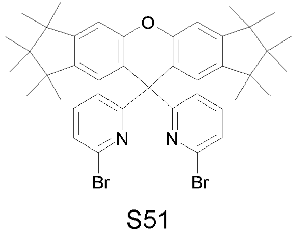 | 28% |

### Beispel S52: 2,7-Di-tert-butyl-9,9'-(6-brompyridin-2-yl)xanthen, S52

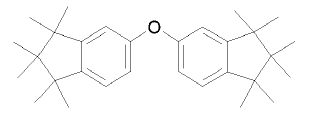

Durchführung analog zu G. Chen et al., Tetrahedron Letters 2007, 48, 3, 47. Ein gut gerührtes Gemisch aus 56.2 g (200 mmol) 5-Brom-1,1,2,2,3,3-hexamethylindan, S5-Br, 212.2 g (800 mmol) Trikalium-phosphat-trihydrat, 300 Glaskugeln (3 mm Durchmesser), 449 mg (2 mmol) Palladium(II)-acetat, 809 mg (4 mmol) Tri-tert-butylphosphin und 1000 ml Dioxan wird 20 h unter Rückfluss erhitzt. Nach Erkalten saugt man von den Salzen ab, wäscht diese mit 300 ml Dioxan nach, engt das Filtrat im Vakuum ein, nimmt den Rückstand in 500 ml Ethylacetat auf, wäscht die Lösung dreimal mit je 300 ml Wasser, einmal mit 300 ml gesättigter Kochsalzlösung, trocknet über Magnesiumsulfat und entfernt dann das Ethylacetat im Vakuum. Der Rückstand wird durch Kugelrohrdestillation (p ca. 10⁻⁴ mbar, T ca, 180 °C) gereinigt. Ausbeute: 32.6 g (78 mmol), 78 %; Reinheit: ca. 97 % nach ¹H-NMR.

### Beispiel S53: 7-Brom-1,2,3,4-tetrahydro-1,4-methano-naphthalin-6-carbaldehyd, S53

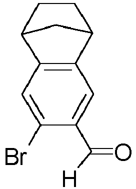

Durchführung analog L. S. Chen et al., J. Organomet. Chem. 1980, 193, 283-292. Eine auf -110 °C gekühlte Lösung von 30.2 g (100 mmol) 6,7-Dibrom-1,2,3,4-tetrahydro-1,4-methano-naphthalin [42810-32-2] in einem Gemisch aus 1000 ml THF und 1000 ml Diethylether wird so mit 40 ml (100 mmol) n-BuLi, 2.5 M in Hexan, vorgekühlt auf -110 °C, versetzt, dass die Temperatur - 105 °C nicht übersteigt. Man rührt 30 min. nach, versetzt dann trofenweise mit einem auf - 110 °C vorgekühlten Gemisch aus 9.2 ml (120 mmol) DMF und 100 ml Diethylether, rührt dann 2 h nach, lässt auf -10 °C erwärmen, fügt 1000 ml 2 N HCl zu und rührt 2 h bei Raumtemperatur nach. Man trennt die organische Phase ab, wäscht diese einmal mit 500 ml Wasser, einmal mit 500 ml gesättigter Kochsalzlösung, trocknet über Magnesiumsulfat, entfernt das Lösungsmittel im Vakuum und unterwirft den Rückstand einer Kugelrohrdestillation (T ca. 90 °C, p ca. 10⁻⁴ mbar). Ausbeute: 15.8 g (63 mmol), 63 %; Reinheit: ca. 95 % nach ¹H-NMR.

Analog können folgende Verbindungen dargestellt werden:

| Bsp. | Edukte | Produkt | Ausbeute |
|---|---|---|---|
| S54 | 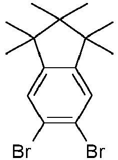 | 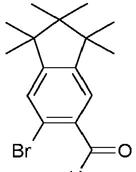 | 68 % |
| | S27 | S54 | |
| S55 | 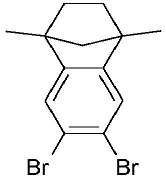 | 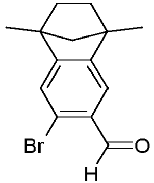 | 66 % |
| | S30 | S55 | |
| S56 | 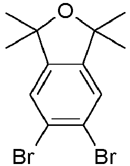 | 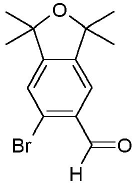 | 60 % |
| | S31 | S56 | |
| S57 | 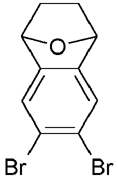 | 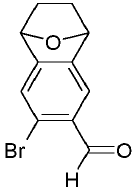 | 54 % |
| | 749859-07-2 S32 | S57 | |

### Beispiel S58: 7-(3,3-Dimethyl-but-1-ynyl)-1,2,3,4-tetrahydro-1,4-methano-naphthalin-6-carbaldehyd, S58

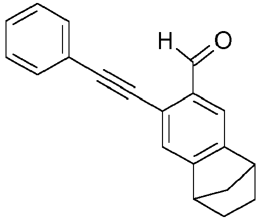

Eine Lösung von 25.1 g (100 mmol) 7-Brom-1,2,3,4-tetrahydro-1,4-methano-naphthalin-6-carbaldehyd, S53 in einem Gemisch aus 200 ml DMF und 100 ml Triethylamin wird konsekutiv mit 1.6 g (6 mmol) Triphenylphosphin, 674 mg (3 mmol) Palladium(II)acetat, 571 mg (30 mmol) Kupfer-(I)iodid und 15.3 g (150 mmol) Phenylacetylen [536-74-3] versetzt und 4 h bei 65 °C gerührt. Nach Erkalten wird vom ausgefallenen Triethylammonium-hydrochlorid abgesaugt, dieses wird mit 30 ml DMF nachgewaschen. Das Filtrat wird im Vakuum von den Lösungsmitteln befreit. Der ölige Rückstand wird in 300 ml Ethylacetat aufgenommen, die Lösung wird fünfmal mit je 100 ml Wasser und einmal mit 100 ml gesättigter Kochsalzlösung gewaschen, und die organische Phase wird über Magnesiumsulfat getrocknet. Nach Entfernen des Ethylacetats im Vakuum wird der ölige Rückstand an Kieselgel chromatographiert (n-Heptan:Ethylacetat 99:1). Ausbeute: 19.6 g (72 mmol), 72 %; Reinheit: ca. 97 % nach ¹H-NMR.

Analog können folgende Derivate dargestellt werden:

| **Bsp.** | **Bromarylaldeyd** | **Alkin** | **Produkt** | **Ausbeute** |
|---|---|---|---|---|
| S59 | 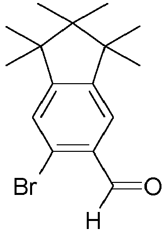 | 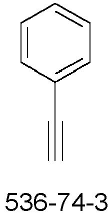 | 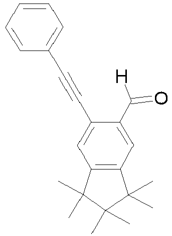 | 69 % |
| | S54 | 536-74-3 | S59 | |
| S60 | 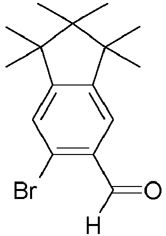 | 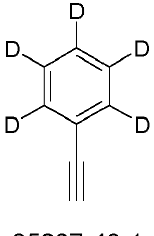 | 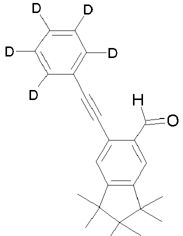 | 69 % |
| | S54 | 25837-46-1 | S60 | |
| S61 | 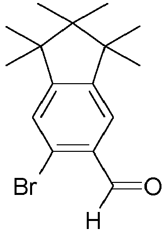 | 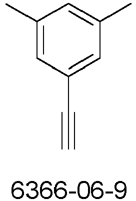 | 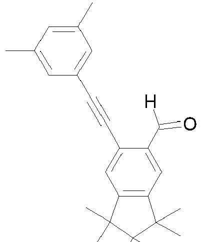 | 70 % |
| | S54 | 6366-06-9 | S61 | |
| S62 | 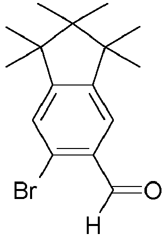 | 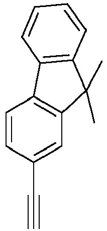 | 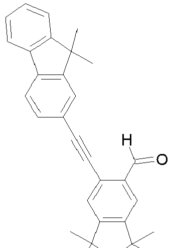 | 66 % |
| | S54 | 876726-86-2 | S62 | |
| S63 | 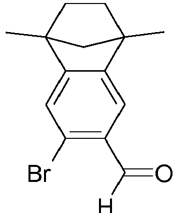 | 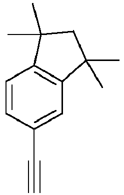 | 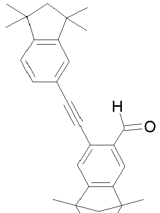 | 67 % |
| | S55 | 188889-51-2 | S62 | |
| S64 | 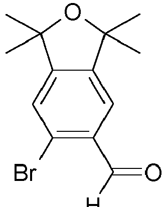 | 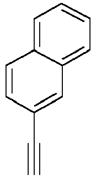 | 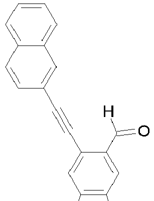 | 70 % |
| | S56 | 2949-26-0 | S64 | |
| S65 | 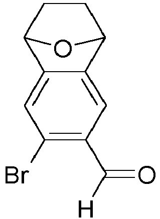 | 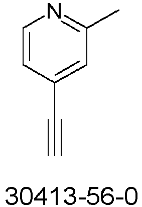 | 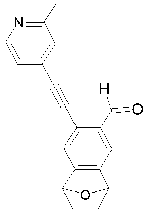 | 56 % |
| | S57 | 30413-56-0 | S65 | |

### B: Synthese der Liganden L:

### Beispiel L1: 2-(1,1,3,3-Tetramethyl-indan-5-yl)pyridin, L1

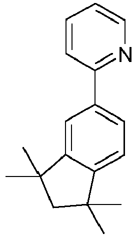

Ein Gemisch aus 30.0 g (100 mmol) 1,1,3,3-Tetramethyl-indan-5-boronsäure-pinakolester, S4-B, 17.4 g (110 mmol) 2-Brompyridin [109-04-6], 46.1 g (200 mmol) Trikaliumphosphat-mono-hydrat, 300 ml Dioxan und 100 ml Wasser wird mit 821 mg (2 mmol) S-Phos und dann mit 249 mg (1 mmol) Palladium(II)acetat versetzt und 16 h unter Rückfluss erhitzt. Nach Erkalten trennt man die wässrige Phase ab, engt die organische zur Trockene ein, nimmt den Rückstand in 500 ml Ethylacetat auf, wäscht die organische Phase dreimal mit je 200 ml Wasser, einmal mit 200 ml gesättigter Kochsalzlösung, trocknet über Magnesiumsulfat, filtriert über ein Celite-Bett vom Trockenmittel ab, und engt erneut zur Trockene ein. Das so erhaltene Öl wird durch zweimalige fraktionierte Kugelrohrdestillation von Leichtsiedern und nicht flüchtigen Nebenkomponenten befreit. Ausbeute: 15.3 g (61 mmol), 61 %; Reinheit: ca. 99.5 %ig nach ¹H NMR.

Analog werden folgende Verbindungen dargestellt. Feststoffe werden durch Umkristallistion und fraktionierte Sublimation (p ca. 10⁻⁴ - 10⁻⁵ mbar, T ca. 160 - 240 °C) von Leichtsiedern und nicht flüchtigen Nebenkomponenten befreit. Öle werden chromatographisch gereinigt, fraktioniert Kugelrohr-destilliert oder im Vakuum getrocknet, um Leichtsieder zu entfernen.

| Bsp. | Produkt Boronsäureester | Bromid | Ligand | Ausbeute |
|---|---|---|---|---|
| L9 | 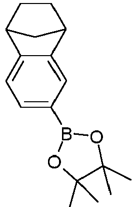 | 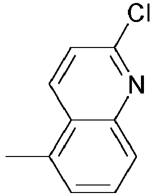 | 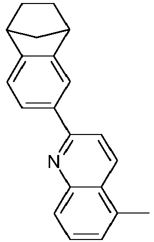 | 58 % |
| | S11-B | 23952-31-0 | | |
| L10 | 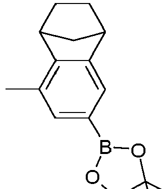 | 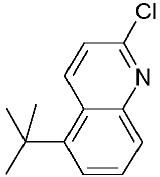 | 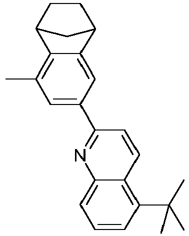 | 60 % |
| | S12-B | 1251922-06-1 | | |
| L11 | 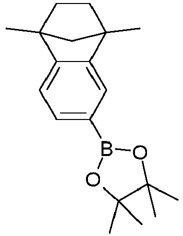 | 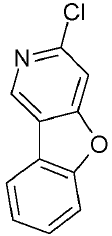 | 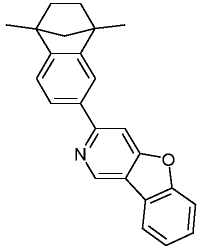 | 54 % |
| | S13-B | 1251041-55-0 | | |
| L18 | 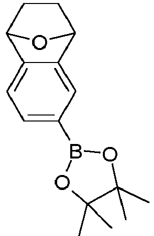 | 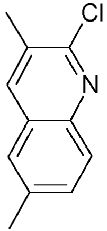 | 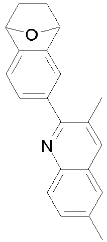 | 59 % |
| | S20-B | 132118-28-6 | | |
| L19 | 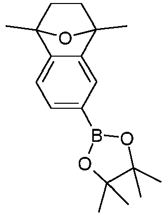 | 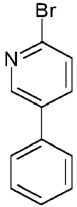 | 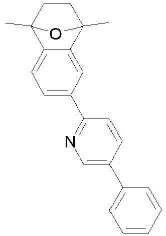 | 63 % |
| | S21-B | 107351-82-6 | | |
| L22 | 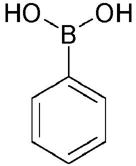 | 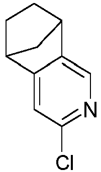 | 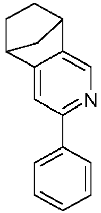 | 64 % |
| | 98-80-6 | 106203-65-0 | | |
| L23 | 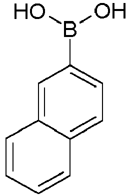 | 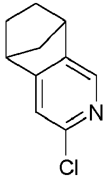 | 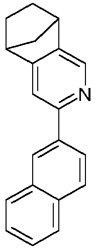 | 66 % |
| | 32316-92-0 | 106203-65-0 | | |
| L24 | 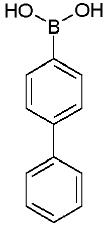 | 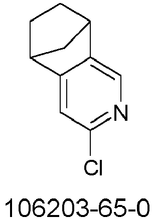 | 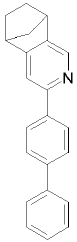 | 68 % |
| | 5122-94-1 | 106203-65-0 | | |
| L25 | 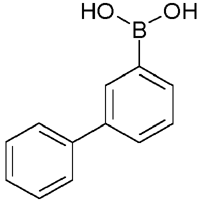 | 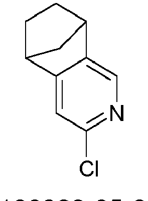 | 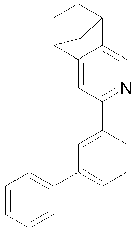 | 63 % |
| | 5122-95-2 | 106203-65-0 | | |
| L26 | 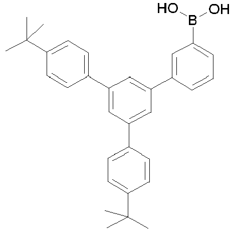 | 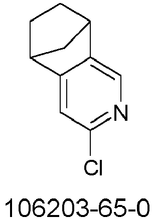 | 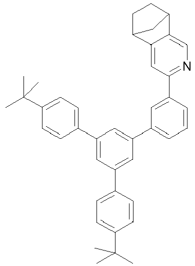 | 45 % |
| | 253280-21-6 | 106203-65-0 | | |
| L27 | 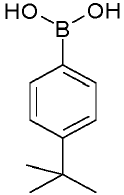 | 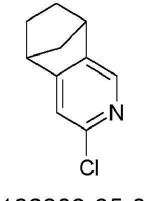 | 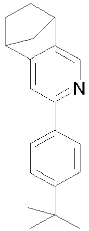 | 64 % |
| | 123324-71-0 | 106203-65-0 | | |
| L28 | 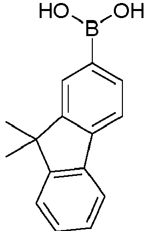 | 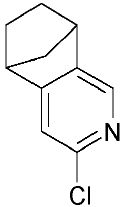 | 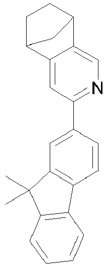 | 65 % |
| | 333432-28-3 | 106203-65-0 | | |
| L29 | 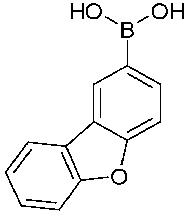 | 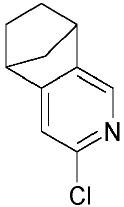 | 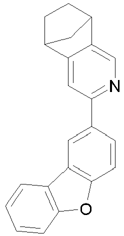 | 66 % |
| | 402936-15-6 | 106203-65-0 | | |
| L30 | 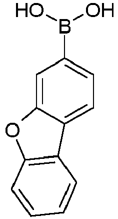 | 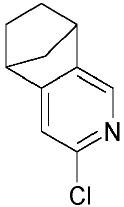 | 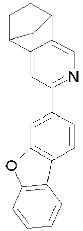 | 67 % |
| | 395087-89-5 | 106203-65-0 | | |
| L31 | 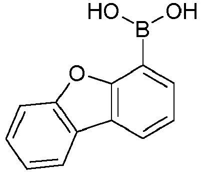 | 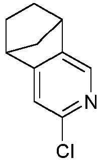 | 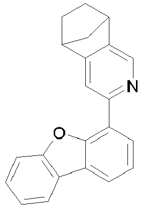 | 51 % |
| | 100124-06-9 | 106203-65-0 | | |
| L32 | 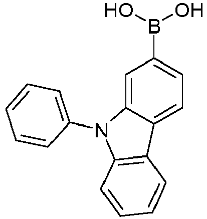 | 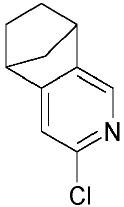 | 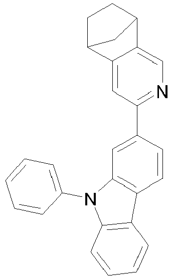 | 64 % |
| | 1001911-63-2 | 106203-65-0 | | |
| L33 | 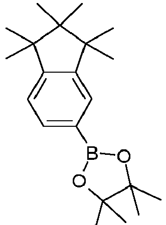 | 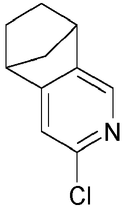 | 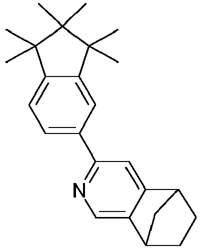 | 63 % |
| | S5-B | 106203-65-0 | | |
| L34 | 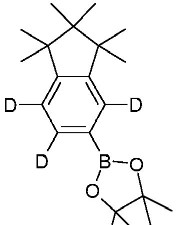 | 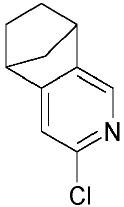 | 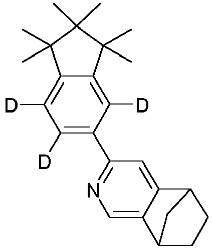 | 61 % |
| | S8-B | 106203-65-0 | | |
| L35 | 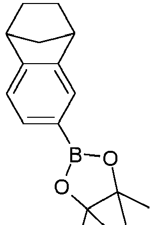 | 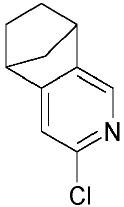 | 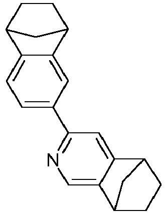 | 61 % |
| | S11-B | 106203-65-0 | Diastereomerenmischung | |
| L36 | 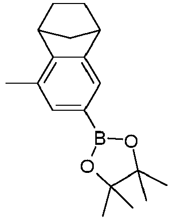 | 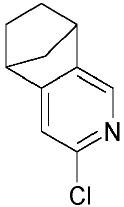 | 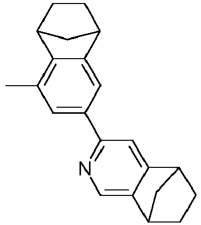 | 62 % |
| | S12-B | 106203-65-0 | Diastereomerenmischung | |
| L37 | 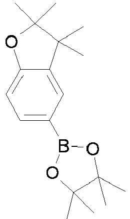 | 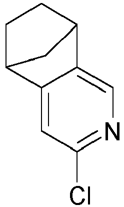 | 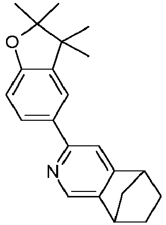 | 49 % |
| | S18-B | 106203-65-0 | | |
| L38 | 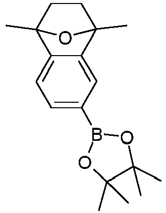 | 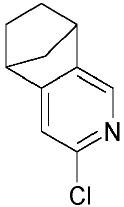 | 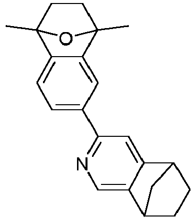 | 57 % |
| | S21-B | 106203-65-0 | Diastereomerenmischung | |
| L39 | 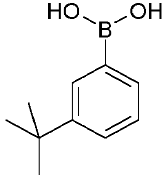 | 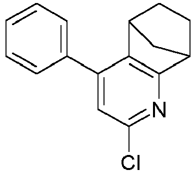 | 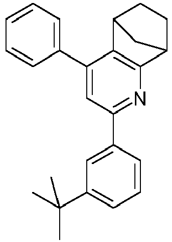 | 60 % |
| | 560132-24-3 | 132813-32-2 | | |
| L40 | 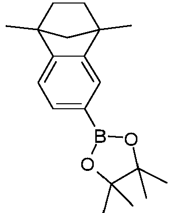 | 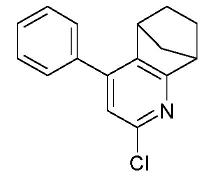 | 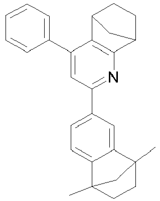 | 59 % |
| | S13-B | 132813-32-2 | Diastereomerenmischung | |
| L41 | 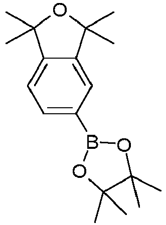 | 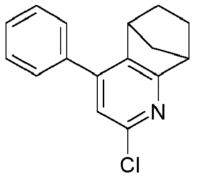 | 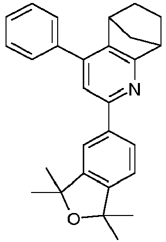 | 53 % |
| | S-14-B | 132813-32-2 | | |

### Beispiel 42: 5,5,7,7-Tetramethyl-3-phenyl-6,7-dihydro-5H-[2]pyridine, L42

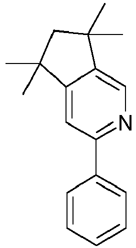

Durchführung analog A. Mazzanti et al., Eur. J. Org. Chem., 2011, 6725. Ein auf -78 °C gekühltes Gemisch aus 10.5 ml (100 mmol) Brombenzol und 500 ml Diethylether wird tropfenweise mit 40 ml (100 mmol) n-Butyllithium, 2.5 M in n-Hexan versetzt und 30 min. nachgerührt. Dann tropft man 17.5 g (100 mmol) 5,5,7,7-Tetramethyl-6,7-dihydro-5H-[2]pyridin, S24 zu, lässt auf Raumtemperatur erwärmen, rührt 12 h nach, quencht durch Zugabe von 100 ml Wasser, trennt die organische Phase ab, trocknet diese über Magnsiumsulfat. Nach Entfernen das Lösungsmittels wird der ölige Rückstand an Kieselgel mit Diethylether:n-Heptan (3:7, v:v) chromatographiert und anschließend zweimal fraktioniert Kugelrohr-destilliert. Ausbeute: 12.1 g (48 mmol), 48 %; Reinheit: ca. 99.5 %ig nach ¹H NMR.

Analog können folgende Verbindungen dargestellt werden. Feststoffe werden durch Umkristallistion und fraktionierte Sublimation (p ca. 10⁻⁴ - 10⁻⁵ mbar, T ca. 160 - 240 °C) von Leichtsiedern und nicht flüchtigen Nebenkomponenten befreit werden. Öle werden chromatographisch gereinigt, fraktioniert Kugelrohr-destilliert oder im Vakuum getrocknet, um Leichtsieder zu entfernen.

| Bsp. | Pyridin | Bromid | Ligand | Ausbeute |
|---|---|---|---|---|
| L49 | 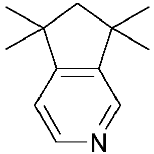 | 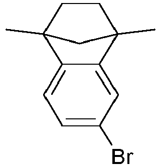 | 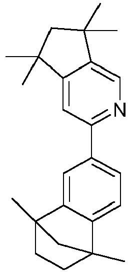 | 49 % |
| | S24 | S13-Br | | |
| L50 | 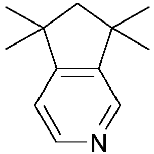 | 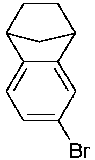 | 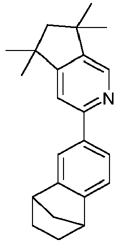 | 45 % |
| | S24 | 16499-72-2 S11-Br | | |
| L51 | 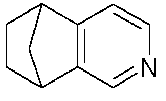 | 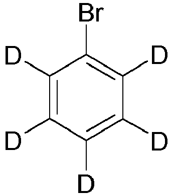 | 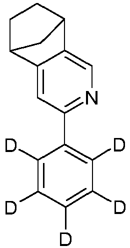 | 46 % |
| | S25 | 4165-57-5 | | |
| L52 | 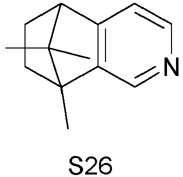 | 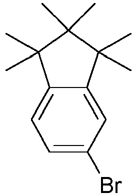 | 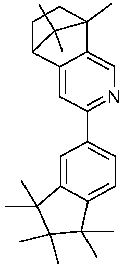 | 40 % |
| | S26 | S5-Br | | |

### Beispiel 53: 6,6,7,7,8,8-Hexamethyl-2-phenyl-7,8-dihydro-6H-cyclopenta[g]chinoxalin, L53

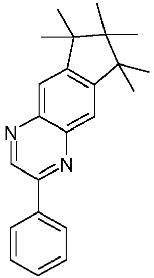

Durchführung analog S. V. More et al., Tetrahedron Lett. 2005, 46, 6345. Ein Gemisch aus 23.2 g (100 mmol) 1,1,2,2,3,3-Hexamethyl-indan-5,6-diamin, S35, 13.4 g (100 mmol) Oxo-phenyl-acetaldehyd [1074-12-0], 767 mg (3 mmol) Iod und 75 ml Acetonitril wird 16 h bei Raumtemperatur gerührt. Man saugt vom ausgefallenen Feststoff ab, wäscht diesen einmal mit 20 ml Acetonitril, zweimal mit je 75 ml n-Heptan und kristallisiert dann zweimal aus Ethanol/Ethylacetat um. Abschließend wird der Feststoff durch fraktionierte Sublimation (p ca. 10⁻⁴ - 10⁻⁵ mbar, T ca. 220 °C) von Leichtsiedern und nicht flüchtigen Nebenkomponenten befreit. Ausbeute: 22.1 g (67 mmol), 67 %; Reinheit: ca. 99.5 %ig nach ¹H NMR. Analog werden folgende Verbindungen dargestellt. Feststoffe werden durch Umkristallistion und fraktionierte Sublimation (p ca. 10⁻⁴ - 10⁻⁵ mbar, T ca. 160 - 240 °C) von Leichtsiedern und nicht flüchtigen Nebenkomponenten befreit werden. Öle werden chromatographisch gereinigt, fraktioniert Kugelrohr-destilliert oder im Vakuum getrocknet, um Leichtsieder zu entfernen.

| Bsp. | Diamin | Diketon | Ligand | Ausbeute |
|---|---|---|---|---|
| L59 | 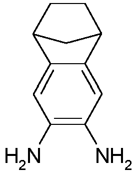 | 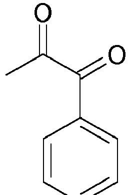 | 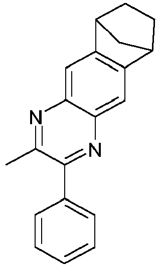 | 55 % |
| | 124639-03-8 | 579-07-7 | | |
| L61 | 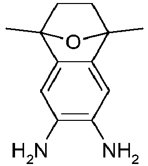 | 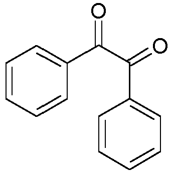 | 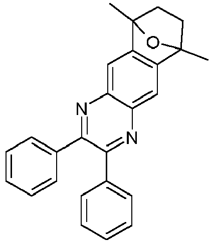 | 59 % |
| | S41 | 134-81-6 | | |
| L63 | 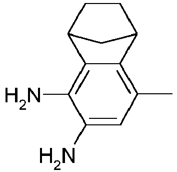 | 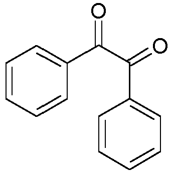 | 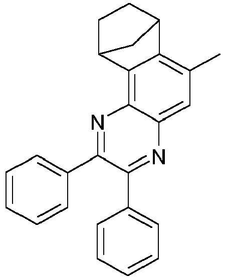 | 51 % |
| | S42 | 134-81-6 | | |

### Beispiel 64: 5,5,6,6,7,7-Hexamethyl-1,2-diphenyl-1,5,6,7-tetrahydro-indeno[5,6-d]imidazol, L64

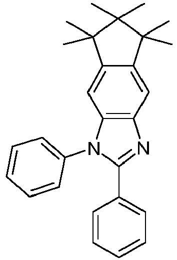

Durchführung analog D. Zhao et al., Org. Lett., 2011, 13, 24, 6516. Ein Gemisch aus 36.0 g (100 mmol) 5,6-Dibrom-1,1,2,2,3,3-hexamethyl-indan, 21.6 g (110 mmol) N-Phenyl-benzamidin [1527-91-9], 97.8 g (300 mmol) Cäsiumcarbonat, 100 g Molsieb 4A, 1.2 g (2 mmol) Xanthphos, 449 mg (2 mmol) Palladium(II)acetat und 600 ml o-Xylol wird unter gutem Rühren 24 h unter Rückfluss erhitzt. Nach Erkalten saugt man von den Salzen über ein Celite-Bett ab, wäscht diese mit 500 ml o-Xylol nach, entfernt das Lösungsmittel im Vakuum und kristallisiert den Rückstand dreimal aus Cyclohexan/Ethylacetat um. Abschließend wird der Feststoff durch fraktionierte Sublimation (p ca. 10⁻⁴ - 10⁻⁵ mbar, T ca. 230 °C) von Leichtsiedern und nicht flüchtigen Nebenkomponenten befreit. Ausbeute: 28.0 g (71 mmol), 71 %; Reinheit: ca. 99.5 %ig nach ¹H NMR.

Analog werden folgende Verbindungen dargestellt. Feststoffe werden durch Umkristallistion und fraktionierte Sublimation (p ca. 10⁻⁴ - 10⁻⁵ mbar, T ca. 160 - 240 °C) von Leichtsiedern und nicht flüchtigen Nebenkomponenten befreit werden. Öle können chromatographisch gereinigt, fraktioniert Kugelrohr-destilliert oder im Vakuum getrocknet werden, um Leichtsieder zu entfernen.

| Bsp. | 1,2-DihalogenVerbindung | Benzamidin | Ligand | Ausbeute |
|---|---|---|---|---|
| L68 | 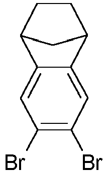 | 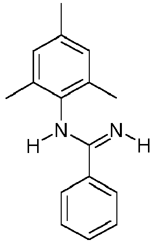 | 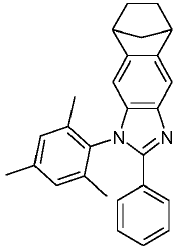 | 68 % |
| | 42810-32-2 | | | |
| | | 72340-27-3 | | |
| L69 | 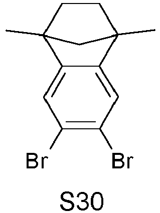 | 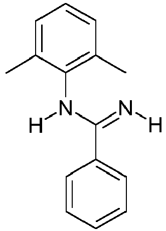 | 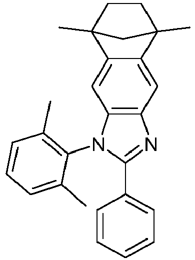 | 69 % |
| | | 16239-27-3 | | |
| L71 | 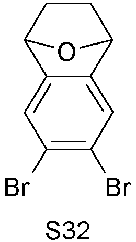 | 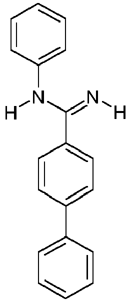 | 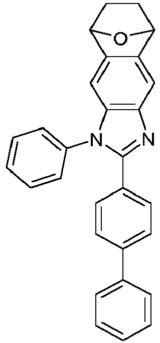 | 64 % |
| | | 64499-61-2 | | |
| L72 | 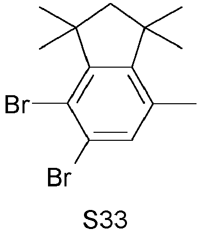 | 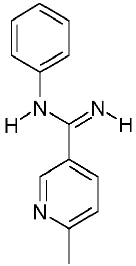 | 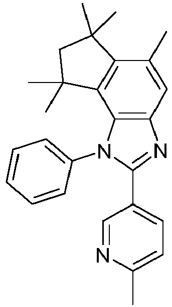 | 36 % |
| | | 787563-35-3 | | |
| L73 | 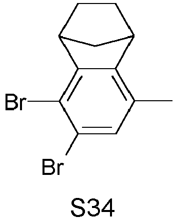 | 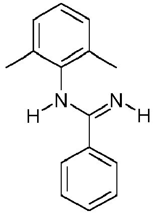 | 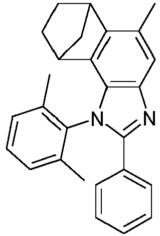 | 44 % |
| | | 16239-27-3 | | |
| L74 | 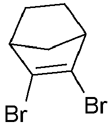 | 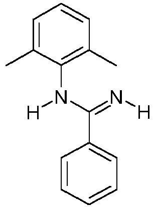 | 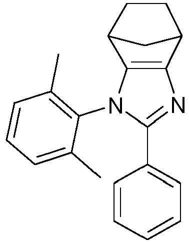 | 43 % |
| | 75267-72-0 | 16239-27-3 | | |
| L75 | 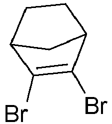 | 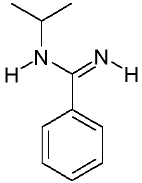 | 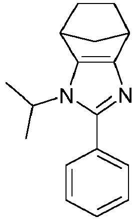 | 40 % |
| | 75267-72-0 | 53510-31-9 | | |
| L76 | 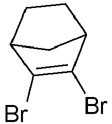 | 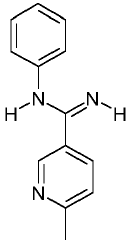 | 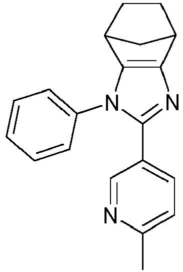 | 38 % |
| | 75267-72-0 | 787563-35-3 | | |
| L77 | 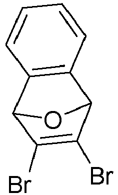 | 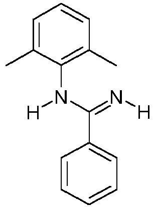 | 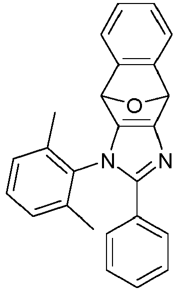 | 39 % |
| | 301829-08-3 | 16239-27-3 | | |

### Beispiel 78: 1,5,5,6,6,7,7-Heptamethyl-3-phenyl-1,5,6,7-tetrahydro-indeno[5,6-d]imidazolium-iodid, L78

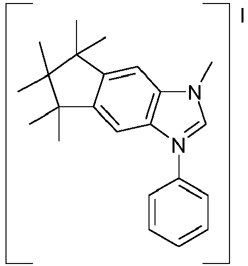

### A) 5,5,6,6,7,7-Hexamethyl-1,5,6,7-tetrahydro-indeno[5,6-d]imidazol

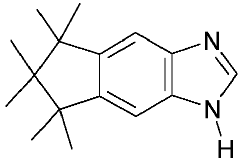

Durchführung analog Z.-H. Zhang et al., J. Heterocycl. Chem. 2007, 44, 6, 1509. Ein gut gerührtes Gemisch aus 116.2 g (500 mmol) 1,1,2,2,3,3-Hexamethyl-indan-5,6-diamin, S35, 90.9 ml (550 mmol) Triethoxymethan [122-51-0] und 400 ml Acetonitril wird mit 1.3 g (5 mmol) Iod versetzt und 5 h bei Raumtemperatur gerührt. Man saugt vom ausgefallenen Feststoff ab, wäscht diesen einmal mit wenig Acetonitril, dreimal mit je 100 ml n-Heptan und trocknet im Vakuum. Ausbeute: 108.8 g (449 mmol), 90 %; Reinheit: ca. 97 %ig nach ¹H NMR.

### B) 5,5,6,6,7,7-Hexamethy)-1-phenyl-1,5,6,7-tetrahydro-indeno[5,6-d]imidazol

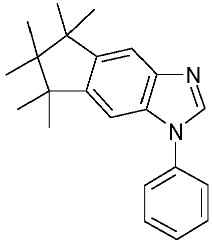

Durchführung analog S. Zhang et al., Chem. Commun. 2008, 46, 6170. Ein Gemisch aus 24.2 g (100 mmol) 5,5,6,6,7,7-Hexamethyl-1,5,6,7-tetrahydro-indeno[5,6-d]imidazol, A), 12.6 ml (120 mmol) Brombenzol [108-86-1], 27.6 g (200 mmol) Kaliumcarbonat, 952 mg (5 mmol) Kupfer(I)-iodid, 1.0 g (10 mmol) N,N-Dimethylglycin, 200 g Glaskugeln (3 mm Durchmesser) und 300 ml DMSO wird unter gutem Rühren 36 h auf 120 °C erhitzt. Nach Erkalten saugt man von den Salzen ab, wäscht diese mit 1000 ml Ethylacetat nach, wäscht die vereinigten org. Phasen fünfmal mit je 500 ml Wasser, einmal mit 500 ml ges. Kochsalzlösung, trocknet über Magnesiumsulfat, entfernt das Lösungsmittel im Vakuum und kristallisiert den Rückstand zweimal aus Cyclohexan um. Ausbeute: 28.3 g (89 mmol), 89 %; Reinheit: ca. 97 %ig nach ¹H NMR.

### C) 1,5,5,6,6,7,7-Heptamethyl-3-phenyl-1,5,6,7-tetrahydro-indeno[5,6-d]imidazolium-iodid, L78

Eine Suspension von 28.3 g (89 mmol) 5,5,6,6,7,7-Hexamethyl-1-phenyl-1,5,6,7-tetrahydro-indeno[5,6-d]imiazol, B), in 100 ml THF wird unter Rühren mit 12.6 ml (200 mmol) Methyliodid [74-88-4] versetzt und 24 h bei 45 °C gerührt. Nach Erkalten saugt man vom ausgefallenen Feststoff ab, wäscht diesen dreimal mit je 50 ml Ethanol und trocknet im Vakuum. Ausbeute: 23.5 g (51 mmol), 57 %; Reinheit: ca. 99 %ig nach ¹H NMR.

Analog werden folgende Verbindungen dargestellt:

| Bsp. | 1,2-Diamin | Bromaromat Alkylhalogenid | Ligand | Ausbeute 3 Stufen |
|---|---|---|---|---|
| L82 | 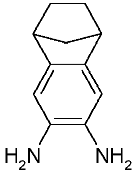 | 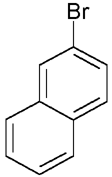 | 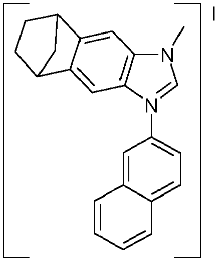 | 41 % |
| | 124639-03-8 | 580-13-2 Mel | | |
| L84 | 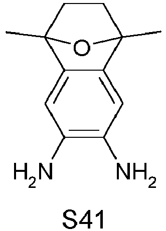 | 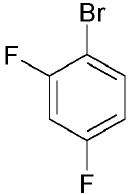 | 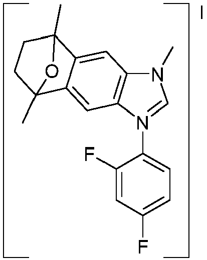 | 37 % |
| | | 348-57-2 Mel | | |
| L85 | 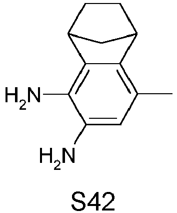 | 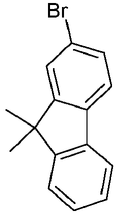 | 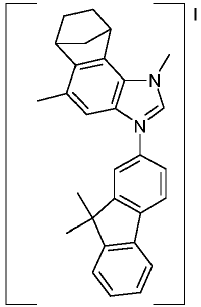 | 34 % |
| | | 28320-31-2 Mel | | |
| L88 | 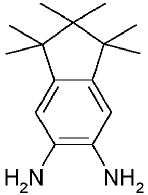 | 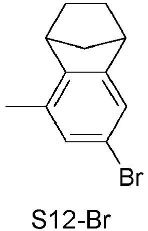 | 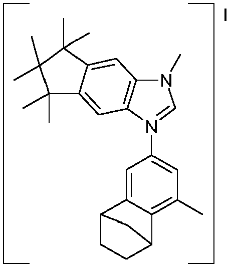 | 40 % |
| | 95-54-5 S35 | Mel | | |

### Beispiel 89: 1,4,4,6,6-Pentamethyl-3-phenyl-1,4,5,6-tetrahydro-cyclopentaimidazolium-iodid, L89

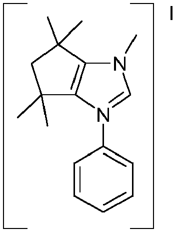

### A) 4,4,6,6-Tetramethyl-1,4,5,6-tetrahydro-cyclopentaimidazol

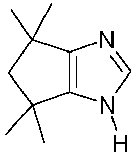

Darstellung analog G. Bratulescu, Synthesis, 2009, 14, 2319. Ein inniges Gemisch aus 1.54 g (10.0 mmol) 3,3,5,5-Tetramethyl-cyclophentan-1,2-dion [20633-06-1], 4.21 g (3.0 mmol) Urotropin, 7.7 g (10 mmol) Ammoniumacetat und 0.3 ml Eisessig wird in einer temperaturgesteuerten Mikrowelle so lange erhitzt, bis eine Innentemperatur von ca. 120 °C erreicht ist, und dann ca. 15 min. bei dieser Temperatur gehalten. Nach Erkalten gibt man die Masse in 150 ml Wasser, stellt unter Rühren mit wässriger Ammoniak-Lösung (10 Gew.-% ig) auf pH = 8 ein, saugt dann vom ausgefallenen Feststoff ab und wäscht diesen mit Wasser. Nach Trocknen wird aus Ethanol/Ethylacetat umkristallisiert. Ausbeute: 1.17 g (7.1 mmol), 71 %; Reinheit: ca. 98 %ig nach ¹H NMR.

### B) 4,4,6,6-Tetramethyl-1-phenyl-1,4,5,6-tetrahydro-cyclopentaimidazol

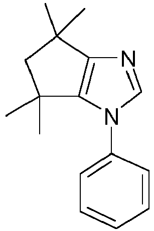

Darstellung analog Beispiel 78, B). Einsatz von 1.64 g (10.0 mmol) 4,4,6,6-Tetramethyl-1,4,5,6-tetrahydro-cyclopentaimidazol, A), die restlichen Edukte und Lösungsmittel werden entsprechend stöchiometrisch angepasst. Ausbeute: 1.53 g (6.3 mmol), 63 %; Reinheit: ca. 98 %ig nach ¹H NMR.

### C) 1,4,4,6,6-Pentamethyl-3-phenyl-1,4,5,6-tetrahydrocyclopentaimidazolium-iodid, L89

Darstellung analog Beispiel 78, C). Einsatz von 2.4 g (10.0 mmol) 4,4,6,6-Tetramethyl-1-phenyl-1,4,5,6-tetrahydro-cyclopentaimidazol, B), die restlichen Edukte und Lösungsmittel werden entsprechend stöchiometrisch angepasst. Ausbeute: 2.26 g (5.9 mmol), 59 %; Reinheit: ca. 99 %ig nach ¹H NMR.

Analog werden folgende Verbindungen dargestellt.

| Bsp. | 1,2-Dion | Bromaromat Alkylhalogenid | Ligand | Ausbeute 3 Stufen |
|---|---|---|---|---|
| L91 | 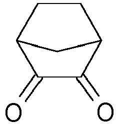 | 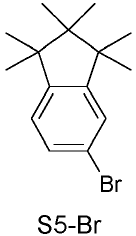 | 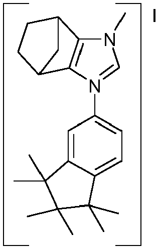 | 40 % |
| | 6236-71-1 | Mel | | |
| L92 | 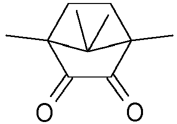 | 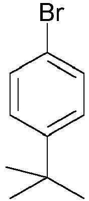 | 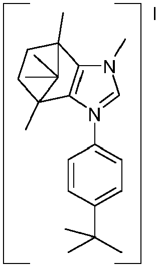 | 33 % |
| | 62292-65-3 | 3972-65-4 Mel | | |

### Beispiel 93: Liganden vom Benzo[4,5]imidazo[2,1-c]chinazolin-Typ Allgemeine Ligandensynthese:

### Aus 2-Amido-aryl-aldehyden und 1,2-Diamino-benzolen:

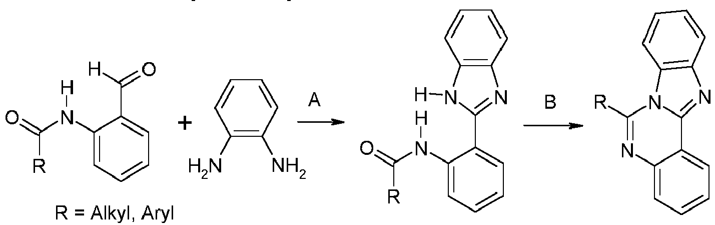

### Schritt A:

Eine Lösung von 100 mmol des 2-Amido-arylaldehyds und 110 mmol des 1,2-Diaminobenzols in 70 ml Ethanol wird in einem 500 ml Rundkolben mit Wasserabscheider platziert und 30 min. bei 50 °C gerührt. Dann gibt man 70 ml Nitrobenzol zu und steigert die Temperatur schrittweise bis zum schwachen Rückfluss des Nitrobenzols, wobei man beim Hochheizen das Ethanol und gebildetes Wasser abdestilliert. Nach 4 h unter schwachem Rückfluss lässt man auf 50 °C erkalten, gibt 40 ml Methanol zu, lässt dann unter Rühren ganz erkalten, rührt 2 h bei Raumtemperatur nach, saugt dann von den gebildeten Kristallen des 2-(2-Amido-phenyl)-benzimidazols ab, wäscht diese zweimal mit je 20 ml Methanol und trocknet im Vakuum. Falls das 2-(2-Amido-phenyl)-benzimidazol nicht auskristallisiert, entfernt man das Lösungsmittel im Vakuum und setzt den Rückstand in Schritt B ein.

### Schritt B:

### Variante A:

Eine gut gerührte Mischung (KPG-Rührer) aus 100 mmol des 2-(2-Amido-phenyl)-benzimidazols und 150 ml Dioxan oder Diethylenglykoldimethylether wird mit 350 mmol des entsprechenden Carbonsäurechlorids und 50 mmol der entsprechenden Carbonsäure versetzt und so lange (typischerweise 4 - 48 h) unter Rückfluss erhitzt, bis das 2-(2-Amido-phenyl)-benzimidazol umgesetzt ist. Entsprechende Carbonsäurechloride und Carbonsäuren sind die, die den jeweiligen Amidrest bilden. Nach Erkalten wird die Reaktionsmischung unter gutem Rühren in ein Gemisch aus 1000 g Eis und 300 ml wässrigem konz. Ammoniak eingerührt. Fällt das Produkt als Feststoff an, wird dieser abgesaugt, mit Wasser gewaschen und trocken gesaugt. Fällt das Produkt als Öl an, wird dieses mit drei Portionen zu je 300 ml Ethylacetat oder Dichlormethan extrahiert. Die organische Phase wird abgetrennt, mit 500 ml Wasser gewaschen und im Vakuum eingeengt. Das Rohprodukt wird in Ethylacetat oder Dichlormethan aufgenommen, über eine kurze Säule aus Alox, basisch, Aktivitätsstufe 1 oder Kieselgel filtriert, um braune Verunreinigungen zu entfernen. Nach Umkristallisation (Methanol, Ethanol, Aceton, Dioxan, DMF, etc.) des so erhaltenen Benzo[4,5]-imidazo[2,1-c]-chinazolins wird dieses, durch Kugelrohrdestillation oder fraktionierte Sublimation (p ca. 10⁻⁴ - 10⁻⁵ mbar, T ca. 160 - 240 °C) von Leichtsiedern und nicht flüchtigen Nebenkomponenten befreit. Verbindungen mit aliphatischen Resten, die mehr als 6 C-Atome aufweisen, bzw. solche mit Aralkylgruppen, die mehr als 9 C-Atome aufweisen, werden typischerweise chromatographisch gereinigt und dann im Vakuum getrocknet, um Leichtsieder zu entfernen. Reinheit nach ¹H-NMR typischerweise > 99.5 % ig.

### Variante B:

Analoge Durchführung zu Variante A, jedoch werden anstatt der Carbonsäure 50 mmol Wasser zugesetzt.

### Variante C:

Analoge Durchführung zu Variante A, jedoch wird keine Carbonsäure zugesetzt.

### Beispiel L95: 1,1,2,2,3,3-Hexamethyl-5-phenyl-2,3-dihydro-1H-6-azacyclopenta[b]naphthalin, L95

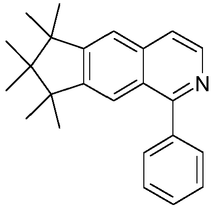

Eine Lösung von 34.8 g (100 mmol) N-[2-(1,1,2,2,3,3-Hexamethylindan-5-yl)-ethyl]-benzamid, S43 in 150 ml o-Xylol wird bei 90 °C unter gutem Rühren portionsweise mit 17.0 g (120 mmol) Phosphorpentoxid versetzt. Zu dieser Reaktionsmischung tropft man 28.0 ml (300 mmol) Phosphorylchlorid zu und rührt weitere 4 h unter Rückfluss nach. Die auf 80 °C abgekühlte Reaktionsmischung wird unter gutem Rühren auf 1000 g Eis gegossen und dann durch Zugabe von fester NaOH alkalisch (pH ca. 12) gestellt. Man extrahiert das Gemisch dreimal mit je 300 ml Toluol, wäscht die organische Phase dreimal mit Wasser, trocknet über Magnesiumsulfat und entfernt das Lösungsmittel im Vakuum. Der ölige Rückstand wird in 200 ml o-Dichlorbenzol gelöst, die Lösung wird mit 86.9 g (1 mol) Mangandioxid versetzt und anschließend 16 h unter Rückfluss am Wasserabscheider gekocht. Nach Erkalten wird vom Mangandioxid über eine Celite-Schicht abfiltriert, der Feststoff wird mit 500 ml eines Gemischs aus Dichlormethan und Ethanol (10:1) gewaschen und die vereinigten Filtrate werden im Vakuum von den Lösungsmitteln befreit. Der Rückstand wird aus Cyclohexan / Ethylacetat umkristallisiert und abschließend durch fraktionierte Sublimation (p ca. 10⁻⁴ - 10⁻⁵ mbar, T ca. 230 °C) von Leichtsiedern und nicht flüchtigen Nebenkomponenten befreit. Ausbeute: 20.1 g (61 mmol), 61 %; Reinheit: ca. 99.5 %ig nach ¹H NMR.

Analog können folgende Verbindungen dargestellt werden:

| Bsp. | Edukt | Produkt | Ausbeute |
|---|---|---|---|
| L97 | 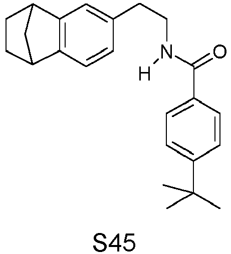 | 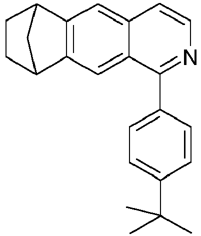 | 64 % |
| L98 | 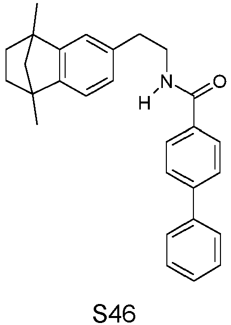 | 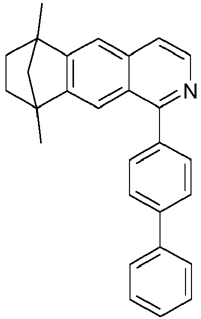 | 60 % |
| L99 | 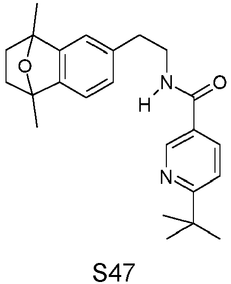 | 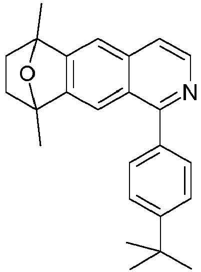 | 41% |

### Beispiel L102: 7,8,9,10-Tetrahydro-7,10-methano-6-phenylphenanthridin, L102

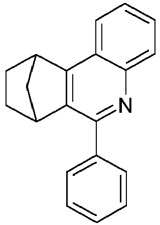

Ein gut gerührtes Gemisch aus 46.6 g (500 mmol) Anilin, 58.4 (550 mmol) Benzaldehyd, 94.2 g (1 mol) Norbornen und 1300 ml Dichlormethan wird tropfenweise mit 14.2 g (100 mmol) Bortrifluoridetherat versetzt und dann 40 h unter Rückfluss erhitzt. Nach Erkalten wäscht man die Reaktionsmischung zweimal mit je 400 ml Wasser, trocknet die orgische Phase über Magnesiumsulfat und entfernt dann das Dichlormethan im Vakuum. Der Rückstand wird in 1000 ml o-Dichlorbenzol aufgenommen, mit 435 g (5 mol) Mangandioxid versetzt und 16 h am Wasserabscheider unter Rückfluss erhitzt. Nach Erkalten fügt man 1000 ml Ethylacetat zu, saugt vom Mangandioxid über eine Celite-Schicht ab, wäscht das Mangandioxid mit 1000 ml Ethylacetat nach und befreit die vereinigten Filtrate im Vakuum von den Lösungsmitteln. Der Rückstand wird zweimal aus Cyclohexan umkristallisiert und abschließend durch fraktionierte Sublimation (p ca. 10⁻⁴ - 10⁻⁵ mbar, T ca. 230 °C) von Leichtsiedern und nicht flüchtigen Nebenkomponenten befreit. Ausbeute: 76.0 g (280 mmol), 56 %; Reinheit: ca. 99.5 %ig nach ¹H NMR.

Analog können folgende Verbindungen dargestellt werden:

| Bsp. | Edukt | Produkt | Ausbeute |
|---|---|---|---|
| L103 | 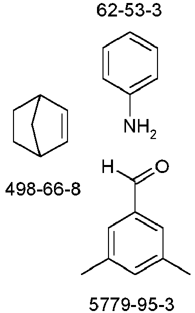 | 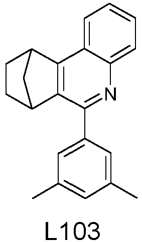 | 66% |
| L104 | 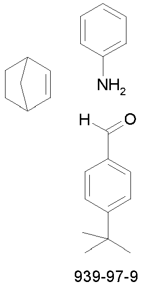 | 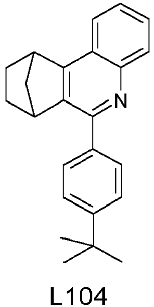 | 64 |
| L105 | 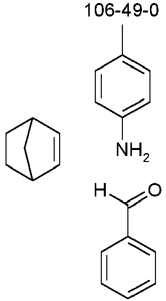 | 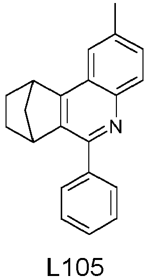 | 56 % |
| L106 | 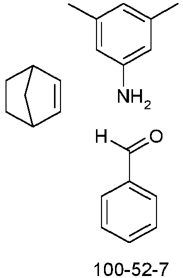 | 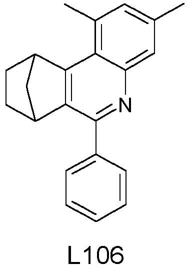 | 58 % |
| L107 | 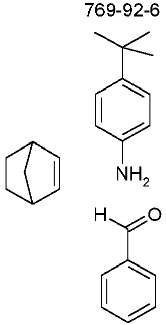 | 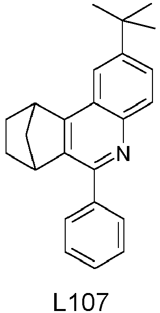 | 61 % |
| L108 | 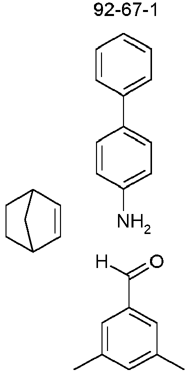 | 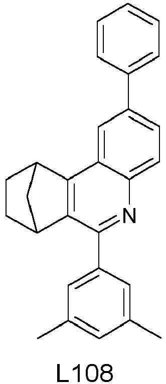 | 63 % |
| L109 | 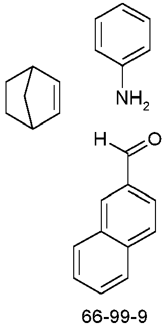 | 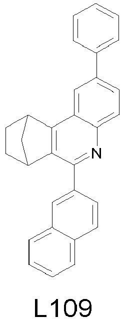 | 58 % |
| L110 | 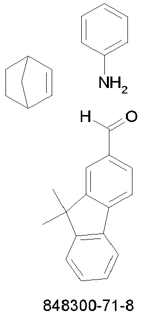 | 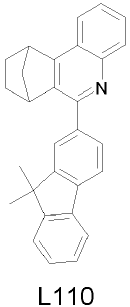 | 55 % |
| L111 | 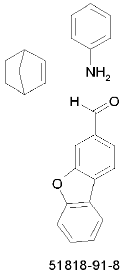 | 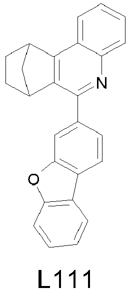 | 60 % |
| L112 | 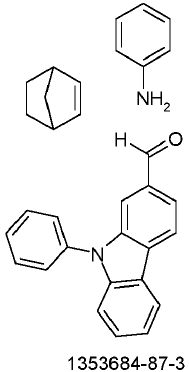 | 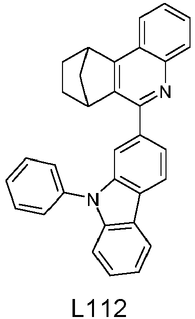 | 34 % |
| L113 | 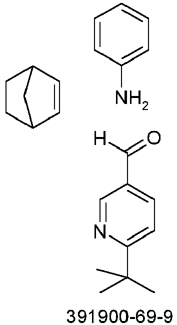 | 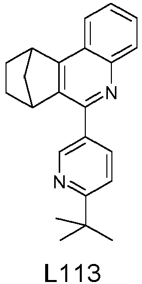 | 69 % |
| L114 | 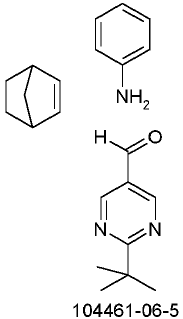 | 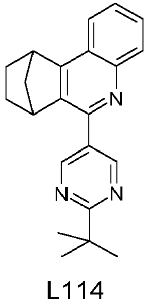 | 67 % |
| L115 | 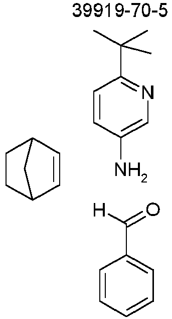 | 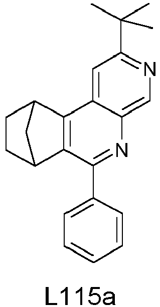 | 23 % |
| | | 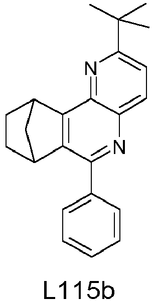 | 17 % |
| | | Chromatographische Trennung der Regioisomeren | |
| L116 | 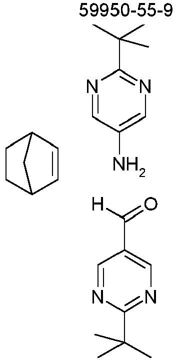 | 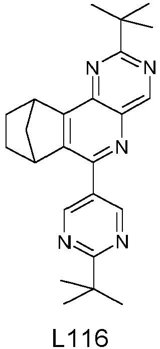 | 50 % |
| L117 | 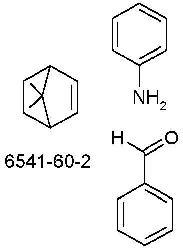 | 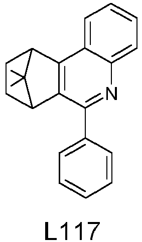 | 48 % |
| L118 | 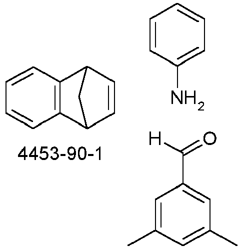 | 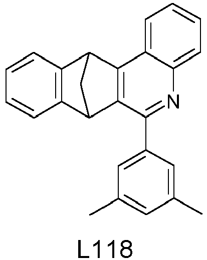 | 68 % |
| L119 | 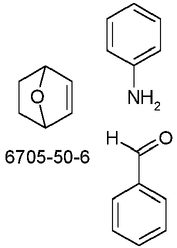 | 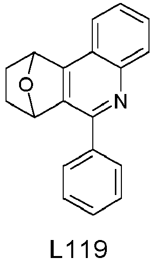 | 45 % |
| L120 | 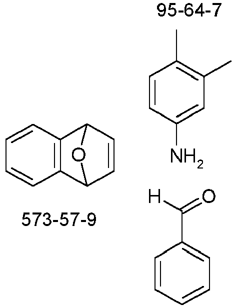 | 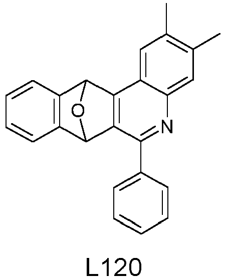 | 65 % |
| L121 | 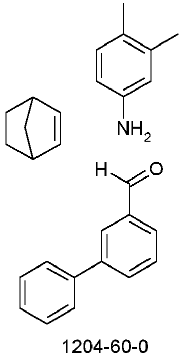 | 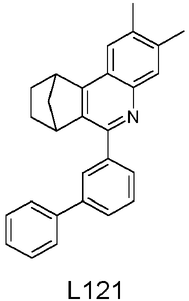 | 54 % |
| L122 | 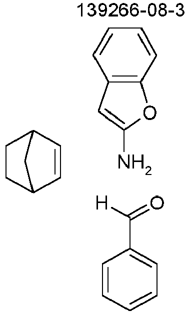 | 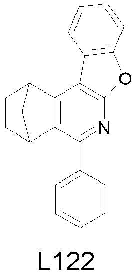 | 38 % |
| L123 | 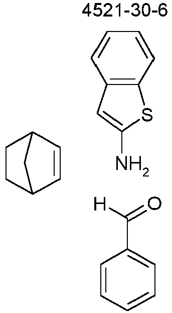 | 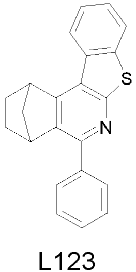 | 34 % |
| L124 | 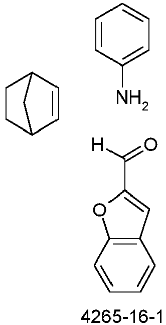 | 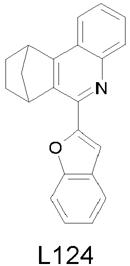 | 36 % |
| L125 | 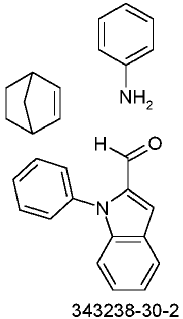 | 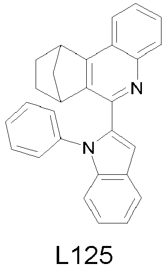 | 28 % |
| L126 | 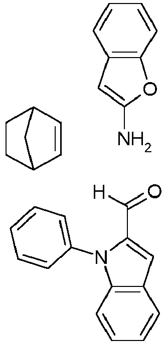 | 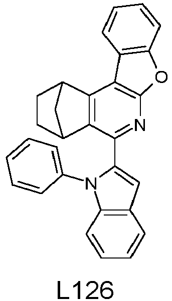 | 32 % |

### Beispiel L128: 5,8-Methano-5,6,7,8-tetrahydro-3-phenyl-2-aza-anthracen, L128

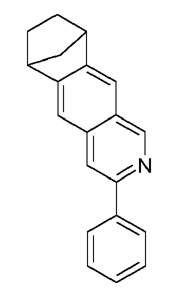

Ein Gemisch aus 13.6 g (50 mmol) 7-(3,3-Dimethyl-but-1-ynyl)-1,2,3,4-tetrahydro-1,4-methanonaphthalin-6-carbaldehyd, S58 und 500 ml methanolische Ammoniak-Lösung (2M) wird in einem Autoklaven 5 h bei 140 °C gerührt. Nach Erkalten wird das Methanol im Vakuum entfernt, der ölige Rückstand wird an Kieselgel chromatographiert (n-Heptan:Ethylacetat 95:5) und abschließend durch fraktionierte Sublimation (p ca. 10⁻⁴ - 10⁻⁵ mbar, T ca. 230 °C) von Leichtsiedern und nicht flüchtigen Nebenkomponenten befreit. Ausbeute: 5.1 g (17 mmol), 34 %; Reinheit: ca. 99.5 %ig nach ¹H NMR.

Analog können folgende Derivate dargestellt werden:

| **Bsp.** | **Edukt** | **Produkt** | **Ausbeute** |
|---|---|---|---|
| L133 | 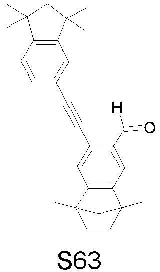 | 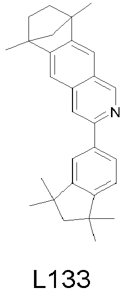 | 27 % |
| L135 | 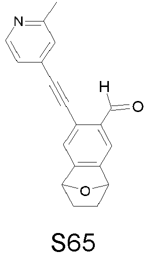 | 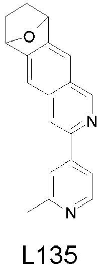 | 36 % |

### Beispiel L136: 1R,4S-Methano-1,2,3,4-tetrahydro -9-phenyl-10-aza-phenanthren, L136

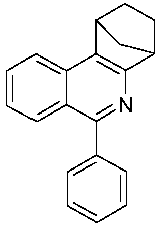

Ein Gemisch aus 26.1 g (100 mmol) 2-Bromphenyl-phenyl-methanon [13047-06-8], 11.1 g (100 mmol) (1R,2R,4S)-Bicyclo[2.2.1]-heptan-2-amin [7242-92-4] und 23.3 ml (105 mmol) Tetraethoxysilan [78-10-4] wird mit einem Tropfen konz. Schwefelsäure versetzt und dann 16 h am Wasserabscheider bei 160 °C erhitzt, wobei das Ethanol abdestilliert. Nach Erkalten versetzt man den Rückstand mit 500 ml Diethylether, wäscht zweimal mit je 100 ml gesättigter Natriumhydrogencarbonat-Lösung und zweimal mit je 300 ml Wasser und trocknet dann über Magnesiumsulfat. Nach Entfernen des Diethylethers versetzt man den öligen Rückstand mit 27.6 g (200 mmol) Kaliumcarbonat, 5 g Palladium-Kohle (5 Gew.-%ig), 2.6 g (10 mmol) Triphenylphosphin, 100 g Glaskugeln (3 mm Durchmesser) und 300 ml Mesitylen und erhitzt erneut 16 h unter Rückfluss. Nach Erkalten saugt man von den Salzen über eine Celite-Schicht ab, wäscht diese mit 500 ml Toluol nach und engt die vereinigten Filtrate im Vakuum zur Trockene ein. Der Rückstand wird dreimal aus DMF / Ethanol umkristallisiert und abschließend durch fraktionierte Sublimation (p ca. 10⁻⁴ - 10⁻⁵ mbar, T ca. 230 °C) von Leichtsiedern und nicht flüchtigen Nebenkomponenten befreit. Ausbeute: 14.9 g (55 mmol), 55 %; Reinheit: ca. 99.5 %ig nach ¹H NMR.

Analog können folgende Derivate dargestellt werden:

| **Bsp.** | **Edukt** | **Produkt** | **Ausbeute** |
|---|---|---|---|
| L137 | 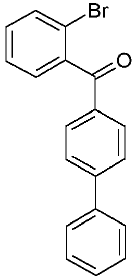 | 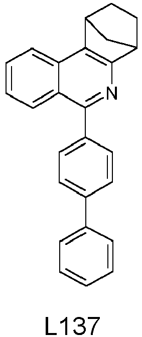 | 47 % |
| | 80874-61-9 | | |
| L138 | 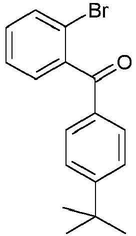 | 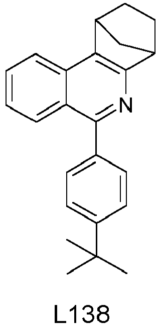 | 45 % |
| | 951889-08-0 | | |

### Beispiel L139: Tetradentate Liganden

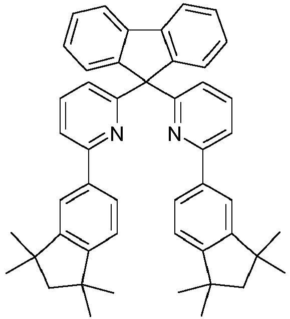

Ein Gemisch aus 47.8 g (100 mmol) 9,9-Bis(6-brom-pyrid-2-yl)fluoren [1323362-54-4], 69.1 g (230 mmol) 1,1,3,3-Tetramethyl-indan-5-boron-säure-pinakolester, S4-B, 42.4 g (400 mmol) Natriumcarbonat, 1.2 g (1 mmol) Tetrakis-triphenylphosphino-palladium(0), 300 ml Toluol, 200 ml Dioxan und 300 ml Wasser wird 30 h unter Rückfluss erhitzt. Nach Erkalten wird die organische Phase abgetrennt, über ein Celite-Bett filtriert, wobei das Celite mit 300 ml Toluol nachgewaschen wird, die vereinigten Filtrate werden dreimal mit je 300 ml Wasser gewaschen, über Magnesiumsulfat getrocknet und dann im Vakuum vom Toluol befreit. Der Rückstand wird dreimal aus Ethanol unter Zusatz von wenig Ethylacetat umkristallisiert und abschließend durch fraktionierte Sublimation (p ca. 10⁻⁵ mbar, T ca. 310 °C) von Leichtsiedern und nicht flüchtigen Nebenkomponenten befreit. Ausbeute: 36.6 g (55 mmol), 55 %; Reinheit: ca. 99.5 %ig nach ¹H NMR.

Analog können folgende Verbindungen dargestellt werden:

| Bsp. | Edukt | Edukt | Produkt | Ausbeute |
|---|---|---|---|---|
| L144 | 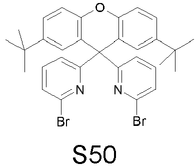 | 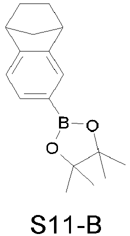 | 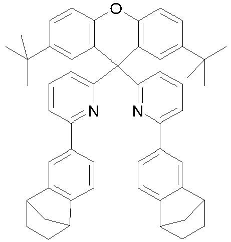 | 32 % |
| | | | Diastereomerengemisch | |

### Beispiel L147: Tetradentate Liganden

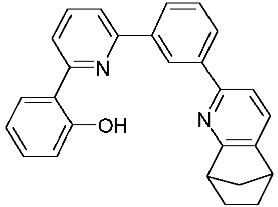

Eine gut gerührte auf -78 °C gekühlte Löung von 15.0 g (50 mmol) 4-(3-Bromphenyl)-3-aza-tricyclo[6.2.1.0*2,7*]undeca-2(7),3,5-trien [1421789-46-9] in 200 ml THF wird tropfenweise mit 20 ml (50 mmol) n-BuLi, 2.5 M in n-Hexan, versetzt und dann 1 h bei -78 °C nachgerührt. Dann fügt man auf einmal ein Gemisch aus 13.9 ml (60 mmol) Triisopropylborat und 30 ml THF zu, rührt 1 h bei -78 °C nach und lässt dann auf Raumtemperatur erwärmen. Man versetzt die Reaktionsmischung mit 200 ml Toluol, 200 ml gesättigter Natriumhydrogencarbonat-Lösung, 13.8 g (55 mmol) 2-(6-brom-pyridin-2-yl)-phenol [1394900-18-5], 1.2 g (1 mmol) Tetrakistriphenylphosphino-palladium(0) und erhitzt für 16 h unter Rückfluss. Nach Erkalten gibt man 200 ml gesättigte Ammoniumchlorid-Lösung und 300 ml Ethylacetat zu, trennt die wässrige Phase ab, filtriert die organische Phase über ein Celite-Bett, wäscht dieses mit 200 ml Ethylacetat nach, wäscht die vereinigten Filtrate dreimal mit Wasser und einmal mit gesättigter Kochsalzlösung und trocknet über Magnsesiumsulfat. Der nach Entfernen des Lösungsmittels erhaltene ölige Rückstand wird dreimal aus Ethanol unter Zusatz von wenig Ethylacetat umkristallisiert und abschließend durch fraktionierte Sublimation (p ca. 10⁻⁵ mbar, T ca. 270 °C) von Leichtsiedern und nicht flüchtigen Nebenkomponenten befreit. Ausbeute: 7.0 g (18 mmol), 36 %; Reinheit: ca. 99.5 %ig nach ¹H NMR.

### Beispiel L148: Tetradentate Liganden

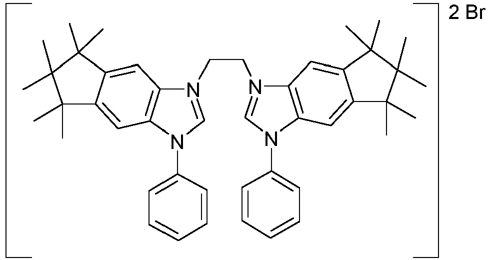

Durchführung analog C. Cao et al., Synth. Commun. 2012, 42, 380. Ein Gemisch aus 15.9 g (50 mmol) 5,5,6,6,7,7-Hexamethyl-1-phenyl-1,5,6,7-tetrahydro-indeno[5,6-d]imidazol, L78 B) und 4.7 g (25 mmol) 1,2-Dibromethan [106-93-4] wird in einem Autoklaven 6 h auf 120 °C erhitzt. Nach Erkalten nimmt man die feste Masse in 100 ml tert-Butyl-methyl-ether auf, homogeniert unter Rühren, filtriert vom weißen Feststoff ab, wäscht diesen zweimal mit je 50 ml tert-Butyl-methyl-ether und trocknet im Vakuum. Ausbeute: 18.1 g (22 mmol), 88 %; Reinheit: ca. 98.0 %ig nach ¹H NMR.

Analog können folgende Verbindungen dargestellt werden:

| Bsp. | Imidazol | Ligand | Ausbeute |
|---|---|---|---|
| L151 | 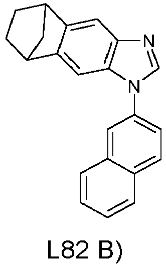 | 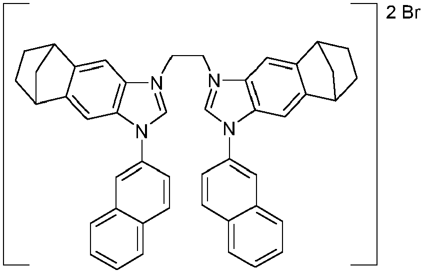 | 91 % |
| | | Diastereomerengemisch | |

### C: Synthese der Metallkomplexe

### 1) Homoleptische tris-faciale Iridium-Komplexe vom Phenyl-Pyridin-, Phenyl-Imidazol- bzw. Phenyl-Benzimidazol-Typ: Variante A: Tris-acetylacetonato-iridium(III) als Iridium-Edukt

Ein Gemisch aus 10 mmol Tris-acetylacetonato-iridium(III) [15635-87-7] und 60 mmol des Liganden L und ein glasummantelter Magnetrührkern werden unter Vakuum (10⁻⁵ mbar) in eine dickwandige 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Um eine Sublimation der Liganden an kältere Stellen der Ampulle zu vermeiden, muss die gesamte Ampulle die angegebene Temperatur besitzen. Alternativ kann die Synthese in einem Rührautoklaven mit Glaseinsatz erfolgen. Nach Erkalten (ACHTUNG: die Ampullen stehen meist unter Druck!) wird die Ampulle geöffnet, der Sinterkuchen wird mit 100 g Glaskugeln (3 mm Durchmesser) in 100 ml eines Suspensionsmittels (das Suspensionsmittel wird so gewählt, dass der Ligand gut, der Metallkomplex jedoch schlecht darin löslich ist, typische Suspensionsmittel sind Methanol, Ethanol, Dichlormethan, Aceton, THF, Ethylacetat, Toluol, etc.) 3 h gerührt und dabei mechanisch aufgeschlossen. Man dekantiert die feine Suspension von den Glaskugeln ab, saugt den Feststoff ab, wäscht mit 50 ml des Suspensionsmittels nach und trocknet diesen im Vakuum. Der trockene Feststoff wird in einem kontinuierlichen Heißextraktor auf einem 3-5 cm hohen Alox-Bett (Alox, basisch Aktivitätsstufe 1) platziert und dann mit einem Extraktionsmittel (Vorlagemenge ca. 500 ml, das Extraktionsmittel wird so gewählt, dass der Komplex darin in der Hitze gut und in der Kälte schlecht löslich ist, besonders geeignete Extraktionsmittel sind Kohlenwasserstoffe wie Toluol, Xylole, Mesitylen, Naphthalin, o-Dichlorbenzol, halogenierte aliphatische Kohlenwasserstoffe sind in der Regel ungeeignet, da sie die Komplexe gegebenenfalls halogenieren oder zersetzen) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Zutropfen von 200 ml Methanol zur Kristallisation gebracht. Der Feststoff der so erhaltenen Suspensionen wird abgesaugt, einmal mit ca. 50 ml Methanol gewaschen und getrocknet. Nach Trocknen wird die Reinheit des Metallkomplexes mittels NMR und / oder HPLC bestimmt. Liegt die Reinheit unter 99.5 % wird der Heißextraktionsschritt wiederholt, wobei ab der 2. Extraktion das Alox-Bett weggelassen wird. Ist eine Reinheit von 99.5 - 99.9 % erreicht, wird der Metallkomplex getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 230 - 400 °C, wobei die Sublimation bevorzugt in Form einer fraktionierten Sublimation durchgeführt wird. Gut in organischen Lösungsmitteln lösliche Komplexe können alternativ auch an Kieselgel chromatograpiert werden. Werden Liganden der Punktgruppe C1 racemisch eingesetzt, fallen die abgeleiteten fac- Metallkomplexe als Diastereomerenmischung an. Das Enantiomerenpaar Λ,Δ der Punktgruppe C3 weist in der Regel eine deutlich geringere Löslichkeit im Extraktionsmittel auf als das der Punktgruppe C1, das sich folglich in der Mutterlauge anreichert. Eine Trennung der Diasteromeren auf diesem Wege ist häufig möglich. Daneben können die Diastereomeren auch chromatographisch getrennt werden. Werden Liganden der Punktgruppe C1 Enantiomeren-rein eingesetzt, entsteht das Enantiomerenpaar Λ,Δ der Punktgruppe C3.

### Variante B: Tris-(2,2,6,6-tetramethyl-3,5-heptandionato)iridium(III) als Iridium-Edukt

Durchführung analog zu Variante A, wobei anstelle von 10 mmol Tris-acetylacetonato-iridium(III) [15635-87-7] 10 mmol Tris-(2,2,6,6-tetramethyl-3,5-heptandionato)iridium [99581-86-9] eingesetzt werden. Die Verwendung dieses Edukts ist vorteilhaft, da die Reinheit der erhaltenen Rohprodukte häufig besser ist als bei Variante A. Außerdem ist der Druckaufbau in der Ampulle häufig nicht so ausgeprägt.

### Vaiante C: Natrium[cis-,trans-di-chloro-(bis-acetylacetonato]iridat(III) als Iridium-Edukt

Ein Gemisch aus 10 mmol Natrium[cis-,trans-di-chloro-(bis-acetyl-acetonato]iridat(III) [876296-21-8] und 60 mmol das Liganden in 50 ml Ethylen-, Proylen- oder Diethylenglykol wird unter einem leichten Argonstrom für die angegebene Zeit unter schwachem Rückfluss erhitzt. Nach Erkalten auf 60 °C verdünnt man unter Rühren mit einem Gemisch aus 50 ml Ethanol und 50 ml 2 N Salzsäure, rührt 1 h nach, saugt vom ausgefallenen Feststoff ab, wäscht diesen dreimal mit je 30 ml Ethanol und trocknet dann im Vakuum. Reinigung durch Heißextraktion oder Chromatographie und fraktionierte Sublimation, wie unter A beschrieben.

| **Bsp.** | **Ligand L** | **Ir-Komplex Diastereomer** | **Variante** | **Aus-beute** |
|---|---|---|---|---|
| | | | **Reaktionsmedium** | |
| | | | **Reaktionstemp.** | |
| | | | **Reaktionszeit** | |
| | | | **Suspensionsmittel** | |
| | | | **Extraktionsmittel** | |
| Ir(L9)₃ | L9 | 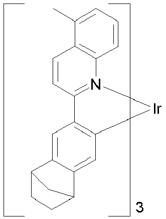 | C | 28 % |
| | | | Propylenglykol | |
| | | | RF | |
| | | | 130 h | |
| | | | --- | |
| | | Λ,Δ-C3 | o-Xylol | |
| Ir(L10)₃ | L10 | 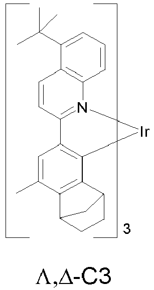 | B | 22 % |
| | | | --- | |
| | | | 250 °C | |
| | | | 130 h | |
| | | | Aceton | |
| | | Λ,Δ-C3 | o-Xylol | |
| Ir(L11)₃ | L11 | 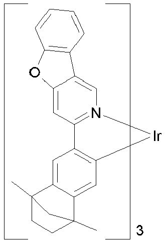 | B | 23 % |
| | | | --- | |
| | | | 230 °C | |
| | | | 130 h | |
| | | | Aceton | |
| | | | o-Xylol | |
| Ir(L18)₃ | L18 | lr(L18)₃ | wie lr(L9)₃ | 31 % |
| | | Λ,Δ-C3 | | |
| Ir(L19)₃ | L19 | lr(L19)₃ | wie lr(L9)₃ | 26 % |
| | | Λ,Δ-C3 | | |
| Ir(L22)₃ | L22 | 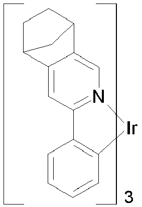 | C | 26 % |
| | | | Propylenglykol | |
| | | | RF | |
| | | | 130 h | |
| | | | --- | |
| | | Λ,Δ-C3 | o-Xylol | |
| Ir(L23)₃ | L23 | 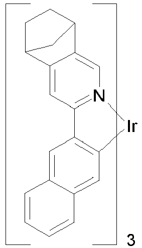 | C | 24 & |
| | | | Propylenglykol | |
| | | | RF | |
| | | | 120 h | |
| | | | --- | |
| | | Λ,Δ-C3 | o-Xylol | |
| Ir(L24)₃ | L24 | lr(L24)₃ | wie lr(L22)₃ | 25 % |
| | | Λ,Δ-C3 | | |
| lr(L25)₃ | L25 | 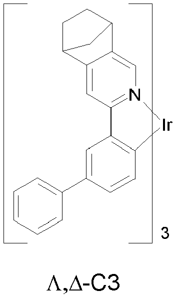 | C | 23 % |
| | | | Ethylenglykol | |
| | | | RF | |
| | | | 140 h | |
| | | | --- | |
| | | Λ,Δ-C3 | ChromatographischeReinigung | |
| Ir(L26)₃ | L26 | lr(L26)₃ | C | 25 % |
| | | Λ,Δ-C3 | Diethylenglykol | |
| | | | 220 °C | |
| | | | 140 h | |
| | | | | |
| | | | Chrom. Reinigung | |
| | | | Metallkomplex wird getempert | |
| Ir(L27)₃ | L27 | Ir(L27)₃ | wie lr(L22)₃ | 27 % |
| | | Λ,Δ-C3 | | |
| Ir(L28)₃ | L28 | 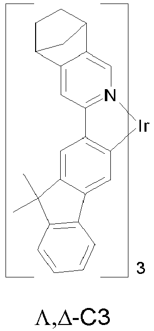 | B | 26 % |
| | | | --- | |
| | | | 230 °C | |
| | | | 130 h | |
| | | | Aceton | |
| | | Λ,Δ-C3 | o-Xylol | |
| Ir(L29)₃ | L29 | 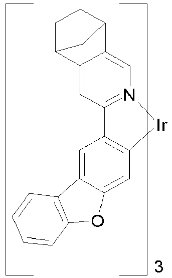 | wie lr(L28)₃ | 24% |
| | | Λ,Δ-C3 | | |
| Ir(L30)₃ | L30 | 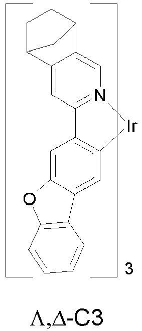 | wie lr(L28)₃ | 25 % |
| Ir(L31)₃ | L31 | lr(L31)₃ | wie lr(L28)₃ | 19 % |
| | | Λ,Δ-C3 | | |
| Ir(L32)₃ | L32 | 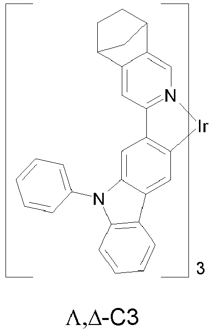 | wie lr(L26)₃ | 23 % |
| | | Λ,Δ-C3 | | |
| Ir(L33)₃ | L33 | 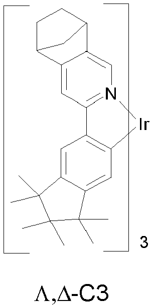 | A | 27 % |
| | | | --- | |
| | | | 230 °C | |
| | | | 100 h | |
| | | | Aceton | |
| | | Λ,Δ-C3 | o-Xylol | |
| Ir(L34)₃ | L34 | wie Ir(L34)₃ | A | 24 % |
| | | Λ,Δ-C3 | --- | |
| | | | 230 °C | |
| | | | 100 h | |
| | | | Aceton | |
| | | | o-Xylol | |
| Ir(L35)₃ | L35 | 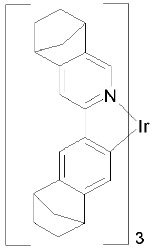 | wie Ir(L11)₃ | 46 % |
| | | Diastereomerengemisch | | |
| Ir(L36)₃ | L36 | 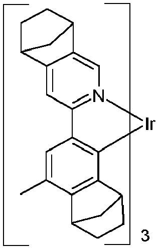 | wie Ir(L11)₃ | 16 % |
| | | Diastereomerengemisch | | |
| Ir(L37)₃ | L37 | 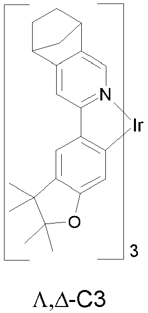 | C | 24 % |
| | | | Ethylenglykol | |
| | | | RF | |
| | | | 140 h | |
| | | | --- | |
| | | | Chromatographische Reinigung | |
| | | Λ,Δ-C3 | | |
| Ir(L38)₃ | L38 | 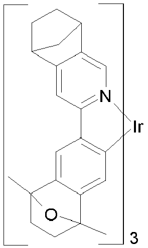 | wie Ir(L11)₃ | 39 % |
| | | Diastereomerengemisch | | |
| Ir(L39)₃ | L39 | 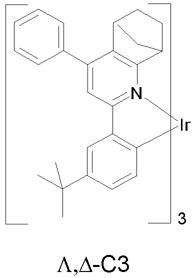 | C | 23 % |
| | | | Diethylenglykol | |
| | | | RF | |
| | | | 130 h | |
| | | | --- | |
| | | Λ,Δ-C3 | Chromatographische Reinigung | |
| Ir(L40)₃ | L40 | 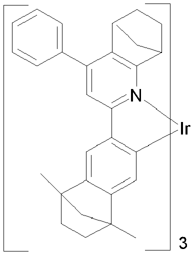 | C | 19 % |
| | | | Diethylenglykol | |
| | | | RF | |
| | | | 130 h | |
| | | | --- | |
| | | Diastereomerengemisch | Chromatographische Reinigung | |
| Ir(L41)₃ | L41 | 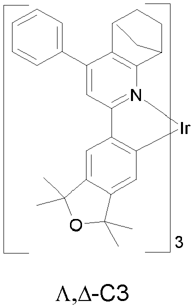 | C | 26 % |
| | | | Diethylenglykol | |
| | | | RF | |
| | | | 130 h | |
| | | | --- | |
| | | Λ,Δ-C3 | Chromatographische Reinigung | |
| Ir(L42)₃* | L42 | 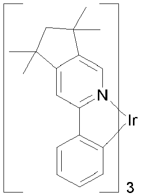 | C | 50% |
| | | | Propylenglykol | |
| | | | RF | |
| | | | 100 h | |
| | | | --- | |
| | | | o-Xylol | |
| Ir(L49)₃ | L49 | 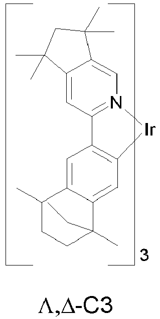 | A | 23 % |
| | | | --- | |
| | | | 230 °C | |
| | | | 150 h | |
| | | | Aceton | |
| | | Λ,Δ-C3 | o-Xylol | |
| Ir(L50)₃ | L50 | Ir( L50)₃ | A | 27 % |
| | | Λ,Δ-C3 | --- | |
| | | | 230 °C | |
| | | | 150 h | |
| | | | Aceton | |
| | | | o-Xylol | |
| Ir(L51)₃ | L51 | Ir(L51)₃ | C | 38 % |
| | | Λ,Δ-C3 | Propylenglykol | |
| | | | RF | |
| | | | 100 h | |
| | | | --- | |
| | | | o-Xylol | |
| Ir(L52)₃ | L52 | 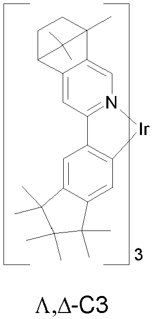 | A | 25 % |
| | | | --- | |
| | | | 230 °C | |
| | | | 150 h | |
| | | | Aceton | |
| | | | o-Xylol | |
| Ir(L68)₃ | L68 | 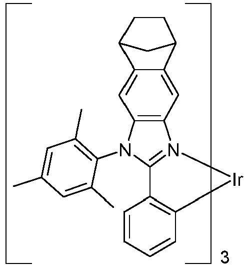 | B | 26 % |
| | | | --- | |
| | | | 240 °C | |
| | | | 130 h | |
| | | | Aceton | |
| | | | o-Xylol | |
| | | Λ,Δ-C3 | | |
| Ir(L69)₃ | L69 | Ir(L69)₃ | wie Ir(L68)₃ | 16 % |
| | | Λ,Δ-C3 | | |
| Ir(L71)₃ | L71 | Ir(L71)₃ | wie Ir(L68)₃ | 21 % |
| | | Λ,Δ-C3 | | |
| Ir(L73)₃ | L73 | 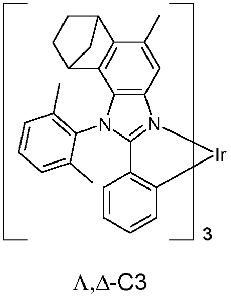 | wie Ir(L68)₃ | 23 % |
| | | | | |
| Ir(L74)₃ | L74 | 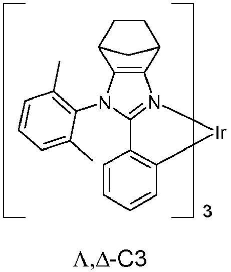 | B | 38 % |
| | | | --- | |
| | | | 245 °C | |
| | | | 130 h | |
| | | | Aceton o-Xylol | |
| | | Λ,Δ-C3 | | |
| Ir(L75)₃ | L75 | Ir(L75)₃ | wie Ir(L74)₃ | 31 % |
| | | Λ,Δ-C3 | | |
| Ir(L76)₃ | L76 | 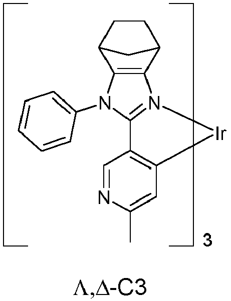 | B | 28 % |
| | | | --- | |
| | | | 260 °C | |
| | | | 140 h | |
| | | | Aceton o-Xylol | |
| | | Λ,Δ-C3 | | |
| Ir(L77)₃ | L77 | 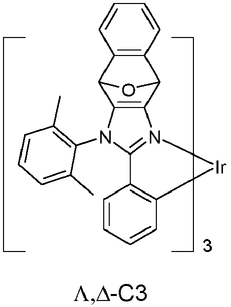 | wie Ir(L74)₃ | 34 % |
| Ir(L97)₃ | L97 | Ir(L97)₃ | A | 30 % |
| | | Λ,Δ-C3 + C1 | --- | |
| | | | 250 °C | |
| | | | 40 h | |
| | | | Ethanol | |
| | | | Cyclohexan | |
| Ir(L98)₃ | L98 | Ir(L98)₃ | A | 26 % |
| | | Λ,Δ-C3 + C1 | --- | |
| | | | 250 °C | |
| | | | 40 h | |
| | | | Ethanol | |
| | | | Cyclohexan | |
| Ir(L99)₃ | L99 | Ir(L99)₃ | A | 23 % |
| | | Λ,Δ-C3 + C1 | --- | |
| | | | 250 °C | |
| | | | 40 h | |
| | | | Ethanol | |
| | | | Cyclohexan | |
| Ir(L102)₃ | L102 | 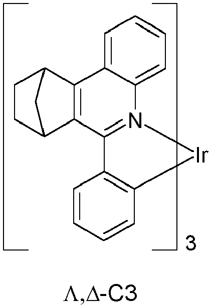 | A | 3.6 % |
| | | | --- | |
| | | | 270 °C | |
| | | | 60 h | |
| | | | Ethanol | |
| | | Λ,Δ-C3 | Cyclohexan | |
| Ir(L128)₃ | L128 | 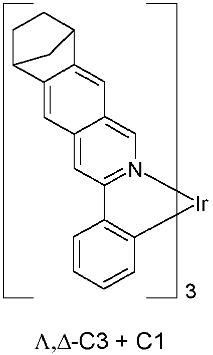 | B | 34 % |
| | | | --- | |
| | | | 250 °C | |
| | | | 40 h | |
| | | | Ethanol | |
| | | | Cyclohexan / Ethylacetat | |
| | | Λ,Δ-C3 + C1 | 8/2, v:v | |
| Ir(L133)₃ | L133 | Ir(L133)₃ Λ,Δ-C3 + C1 | wie Ir(L128)₃ | 25 % |
| Ir(L135)₃ | L135 | Ir(L135)₃ | B | 20 % |
| | | Λ,Δ-C3 + C1 | --- | |
| | | | 260 °C | |
| | | | 40 h | |
| | | | Ethanol | |
| | | | Cyclohexan / Ethylacetat | |
| | | | 8/2, v:v | |

| | | | | |
|---|---|---|---|---|
| * nicht Gegenstand der Erfindung | | | | |

### 2) Homoleptische Iridium-Komplexe vom Arduengo-Carben-Typ:

Darstellung analog K. Tsuchiya, et al., Eur. J. Inorg. Chem., 2010, 926. Ein Gemisch aus 10 mmol des Liganden, 3 mmol Iridium(III)chlorid-Hydrat, 10 mmol Silbercarbonat, 10 mmol Natriumcarbonat in 75 ml 2-Ethoxyethanol wird 24 h unter Rückfluss erwärmt. Nach Erkalten gibt man 300 ml Wasser zu, saugt vom ausgefallenen Feststoff ab, wäscht diesen einmal mit 30 ml Wasser und dreimal mit je 15 ml Ethanol und trocknet im Vakuum. Das so erhaltene fac-/mer-Isomerengemisch wird an Kieselgel chromatographiert. Die so erhaltenen Isomere werden wie unter 1) Variante A beschrieben fraktioniert sublimiert.

| **Bsp.** | **Ligand L** | **Ir-Komplex Diastereomer** | **Ausbeute** |
|---|---|---|---|
| fac-Ir(L82)₃ | L82 | 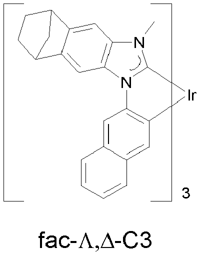 | 23 % |
| mer-Ir(L82)₃ | | fac-Λ,Δ-C3 | --- |
| fac-Ir(L84)₃ | L84 | 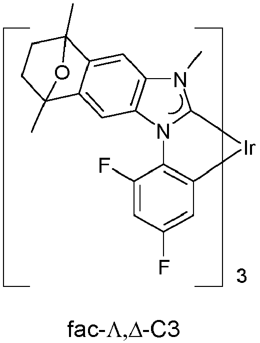 | 12 % |
| mer-Ir(L84)₃ | | fac-Λ,Δ-C3 | 16 % |
| fac-Ir(L85)₃ | L85 | 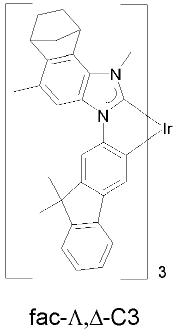 | 25 % |
| mer-Ir(L85)₃ | | fac-Λ,Δ-C3 | --- |
| fac-Ir(L88)₃ | L88 | 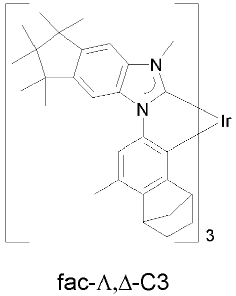 | 19 % |
| mer-Ir(L88)₃ | | fac-Λ,Δ-C3 | 15 % |
| fac-Ir(L91)₃ | L91 | 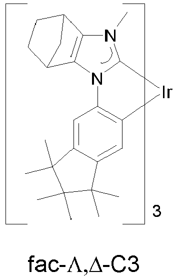 | 18 % |
| mer-Ir(L91)₃ | | fac-Λ,Δ-C3 | --- |
| fac-Ir(L92)₃ | L92 | 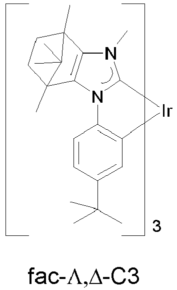 | 16 % |
| mer-Ir(L92)₃ | | fac-Λ,Δ-C3 | --- |

### 3) Iridium-Komplexe vom Typ [Ir(L)₂Cl]₂

### Variante A:

Ein Gemisch aus 22 mmol des Liganden, 10 mmol Iridium(III)chlorid-Hydrat, 75 ml 2-Ethoxyethanol und 25 ml Wasser wird unter gutem Rühren 16 - 24 h unter Rückfluss erhitzt. Falls sich der Ligand nicht oder nicht vollständig im Lösungsmittelgemisch unter Rückfluss löst, wird so lange 1,4-Dioxan zugesetzt, bis eine Lösung entstanden ist. Nach Erkalten saugt man vom ausgefallenen Feststoff ab, wäscht diesen zweimal mit Ethanol/Wasser (1:1, vv) und trocknet dann im Vakuum. Das so erhaltene Chloro-Dimer der Formel [Ir(L)₂Cl]₂ wird ohne Reinigung weiter umgesetzt.

### Variante B:

Ein Gemisch aus 10 mmol Natrium-bis-acetylacetonato-dichloro-iridat(III) [770720-50-8], 24 mmol des Liganden L und ein glasummantelter Magnetrührkern werden unter Vakuum (10⁻⁵ mbar) in eine dickwandige 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Nach Erkalten - ACHTUNG: die Ampullen stehen meist unter Druck! - wird die Ampulle geöffnet, der Sinterkuchen wird mit 100 g Glaskugeln (3 mm Durchmesser) in 100 ml des angegebenen Suspensionsmittels (das Suspensionsmittel wird so gewählt, dass der Ligand gut, das Chloro-Dimer der Formel [Ir(L)₂Cl]₂ jedoch schlecht darin löslich ist, typische Suspensionsmittel sind Dichlormethan, Aceton, Ethylacetat, Toluol, etc.) 3 h gerührt und dabei mechanisch aufgeschlossen. Man dekantiert die feine Suspension von den Glaskugeln ab, saugt den Feststoff [Ir(L)₂Cl]₂, der noch ca. 2 eq NaCl enthält, nachfolgend das rohe Chloro-Dimer genannt, ab und trocknet diesen im Vakuum. Das so erhaltene rohe Chloro-Dimer der Formel [Ir(L)₂Cl]₂ wird ohne Reinigung weiter umgesetzt.

| **Bsp.** | **Ligand L** | **Ir-Komplex Variante Temp. / Zeit Diastereomer** | **Ausbeute** |
|---|---|---|---|
| [Ir(L10)₂Cl]₂ | L10 | 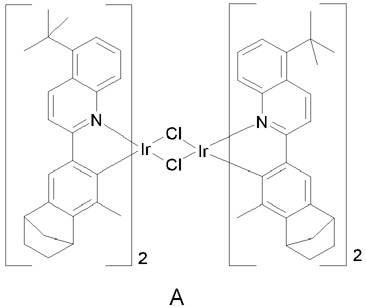 | 63 % |
| | | Diastereomerengemisch | |
| [Ir(L11)₂Cl]₂ | L11 | 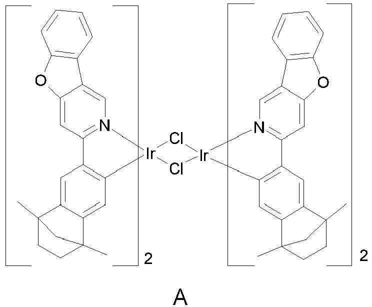 | 69 % |
| | | Diastereomerengemisch | |
| [Ir(L25)₂Cl]₂ | L25 | 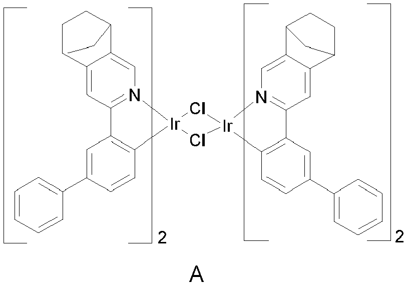 | 73 % |
| | | Diastereomerengemisch | |
| [Ir(L59)₂Cl]₂ | L59 | 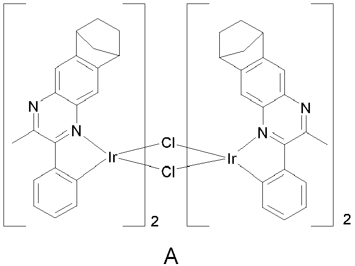 | 57 % |
| | | Diastereomerengemisch | |
| [Ir(L72)₂Cl]₂ | L72 | 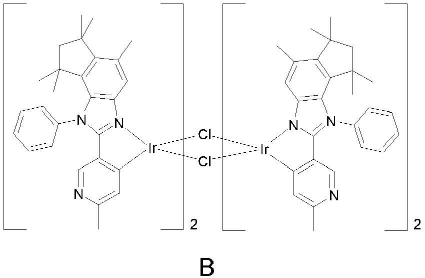 | 78 % |
| | | 270 °C / 80 h | |
| [Ir(L74)₂Cl]₂ | L74 | 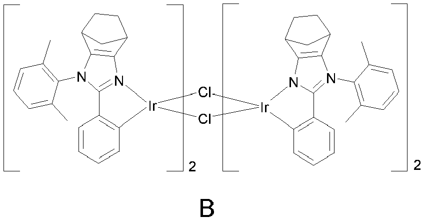 | 66 % |
| | | 250 °C / 80 h | |
| [Ir(L102)₂Cl]₂ | L102 | 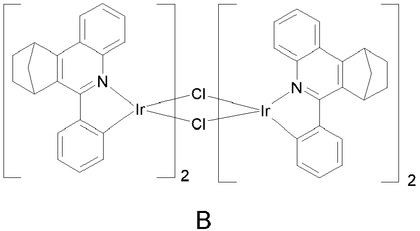 | 92 % |
| | | 250 °C / 60 h | |
| | | Diastereomerengemisch | |
| [Ir(L103)₂Cl]₂ | L103 | [Ir(L103)₂Cl]₂ | 90 % |
| | | wie [Ir(L102)₂Cl]₂ | |
| [Ir(L104)₂Cl]₂ | L104 | [Ir(L104)₂Cl]₂ | 90 % |
| | | wie [Ir(L1 02)₂Cl]₂ | |
| [Ir(L105)₂Cl]₂ | L105 | [Ir(L105)₂Cl]₂ | 83% |
| | | wie [Ir(L102)₂Cl]₂ | |
| [Ir(L106)₂Cl]₂ | L106 | [Ir(L106)₂Cl]₂ | 91% |
| | | wie [Ir(L102)₂Cl]₂ | |
| [Ir(L107)₂Cl]₂ | L107 | [Ir(L107)₂Cl]₂ | 90 % |
| | | wie [Ir(L102)₂Cl]₂ | |
| [Ir(L108)₂Cl]₂ | L108 | [Ir(L108)₂Cl]₂ | 87 % |
| | | wie [Ir(L102)₂Cl]₂ | |
| [Ir(L109)₂Cl]₂ | L109 | [Ir(L109)₂Cl]₂ | 90 % |
| | | wie [Ir(L102)₂Cl]₂ | |
| [Ir(L110)₂Cl]₂ | L110 | [Ir(L110)₂Cl]₂ | 92 % |
| | | wie [Ir(L1 02)₂Cl]₂ | |
| [Ir(L111)₂Cl]₂ | L111 | [Ir(L111)₂Cl]₂ | 89 % |
| | | wie [Ir(L102)₂Cl]₂ | |
| [Ir(L112)₂Cl]₂ | L112 | [Ir(L112)₂Cl]₂ | 84 % |
| | | wie [Ir(L102)₂Cl]₂ | |
| [Ir(L113)₂Cl]₂ | L113 | [Ir(L113)₂Cl]₂ | 78 % |
| | | B | |
| | | 260 °C / 60 h | |
| | | Diastereom erengem isch | |
| [Ir(L114)₂Cl]₂ | L114 | [Ir(L114)₂Cl]₂ | 64 % |
| | | B | |
| | | 280 °C / 60 h | |
| | | Diastereomerengem isch | |
| [Ir(L115a)₂Cl]₂ | L115a | [Ir(L115a)₂Cl]₂ | 89 % |
| | | wie [Ir(L102)₂Cl]₂ | |
| [Ir(L115b)₂Cl]₂ | L115b | [Ir(L115b)₂Cl]₂ | 91 % |
| | | wie [Ir(L102)₂Cl]₂ | |
| [Ir(L116)₂Cl]₂ | L116 | [Ir(L116)₂Cl]₂ | 87 % |
| | | wie [Ir(L114)₂Cl]₂ | |
| [Ir(L117)₂Cl]₂ | L117 | [Ir(L117)₂Cl]₂ | 88 % |
| | | wie [Ir(L102)₂Cl]₂ | |
| [Ir(L118)₂Cl]₂ | L118 | [Ir(L118)₂Cl]₂ | 88 % |
| | | wie [Ir(L102)₂Cl]₂ | |
| [Ir(L119)₂Cl]₂ | L119 | [Ir(L119)₂Cl]₂ | 90 % |
| | | wie [Ir(L102)₂Cl]₂ | |
| [Ir(L120)₂Cl]₂ | L120 | [Ir(L120)₂Cl]₂ | 89 % |
| | | wie [Ir(L102)₂Cl]₂ | |
| [Ir(L121)₂Cl]₂ | L121 | [Ir(L121)₂Cl]₂ | 89 % |
| | | wie [Ir(L102)₂Cl]₂ | |
| [Ir(L122)₂Cl]₂ | L122 | [Ir(L122)₂Cl]₂ | 87 % |
| | | wie [Ir(L102)₂Cl]₂ | |
| [Ir(L123)₂Cl]₂ | L123 | [Ir(L123)₂Cl]₂ | 93 % |
| | | wie [Ir(L102)₂Cl]₂ | |
| [Ir(L124)₂Cl]₂ | L124 | [Ir(L124)₂Cl]₂ | 78 % |
| | | B | |
| | | 250 °C / 30 h | |
| | | Diastereom erengem isch | |
| [Ir(L125)₂Cl]₂ | L125 | [Ir(L125)₂Cl]₂ | 80 % |
| | | wie [Ir(L124)₂Cl]₂ | |
| [Ir(L126)₂Cl]₂ | L126 | [Ir(L126)₂Cl]₂ | 67 % |
| | | wie [Ir(L124)₂Cl]₂ | |
| [Ir(L136)₂Cl]₂ | L136 | 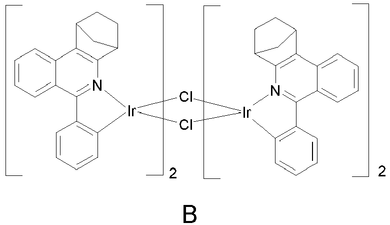 | 85 % |
| | | 280 °C / 40 h | |
| | | Diastereomerengemisch | |
| [Ir(L137)₂Cl]₂ | L137 | [Ir(L137)₂Cl]₂ | 86 % |
| | | wie [Ir(L136)₂Cl]₂ | |
| [Ir(L138)₂Cl]₂ | L138 | [Ir(L138)₂Cl]₂ | 84 % |
| | | wie [Ir(L136)₂Cl]₂ | |

### 4) Iridium-Komplexe vom Typ [Ir(L)₂(HOMe)₂]OTf

Eine Suspension von 5 mmol des Chloro-Dimers [Ir(L)₂Cl]₂ in 150 ml Dichlormethan wird mit 5 ml Methanol und dann mit 10 mmol Silber(I)trifluormethansulfonat [2923-28-6] versetzt und 18 h bei Raumtemperatur gerührt. Man saugt vom ausgefallenen Silber(I)chlorid über ein Celite-Bett ab, engt das Filtrat zur Trockene ein, nimmt den gelben Rückstand in 30 ml Toluol oder Cyclohexan auf, filtriert vom Feststoff ab, wäscht diesen mit n-Heptan und trocknet im Vakuum. Das so erhaltene Produkt der Formel [Ir(L)₂(HOMe)₂]OTf wird ohne Reinigung weiter umgesetzt.

| **Bsp.** | **[Ir(L)₂Cl]₂** | **[Ir(L)₂(HOMe)₂]OTf** | **Ausbeute** |
|---|---|---|---|
| [Ir(L10)₂(HOMe)₂]OTf | [Ir(L10)₂Cl]₂ | [Ir(L10)₂(HOMe)₂]OTf | 80 % |
| [Ir(L11)₂(HOMe)₂]OTf | [Ir(L11)₂Cl]₂ | [Ir(L11)₂(HOMe)₂]OTf | 76 % |
| [Ir(L25)₂(HOMe)₂]OTf | [Ir(L25)₂Cl]₂ | [Ir(L25)₂(HOMe)₂]OTf | 80 % |
| [Ir(L59)₂(HOMe)₂]OTf | [Ir(L59)₂Cl]₂ | [Ir(L59)₂(HOMe)₂]OTf | 80 % |
| [Ir(L72)₂(HOtMe)₂]OTf | [Ir(L72)₂Cl]₂ | [Ir(L72)₂(HOMe)₂]OTf | 79 % |
| [Ir(L74)₂(HOMe)₂]OTf | [Ir(L74)₂Cl]₂ | [Ir(L74)₂(HOMe)₂]OTf | 83 % |
| [Ir(L102)₂(HOMe)₂]OTf | [Ir(L102)₂Cl]₂ | [Ir(L102)₂(HOMe)₂]OTf | 76 % |

### 5) Heteroleptische tris-faciale Iridium-Komplexe vom Phenylpyridin-, Phenylimidazol- bzw. Phenylbenzimidazol-Typ :

Ein Gemisch aus 10 mmol des Liganden L, 10 mmol Bis(methanol)bis[2-(2-pyridinyl-κN]phenyl-κC]iridium(III)-triflourmethansulfonat [1215692-14-0] bzw. Bis(methanol)bis[2-(6-methyl-2-pyridinyl-κN]phenyl-κC]iridium(III)-triflourmethansulfonat [1215692-29-7] bzw. erfindungsgemäße Iridium-Komplexe vom Typ [Ir(L)₂(HOMe)₂]OTf, 11 mmol 2,6-Dimethylpryridin und 150 ml Ethanol wird 40 h unter Rückfluss erhitzt. Nach Erkalten saugt man vom ausgefallenen Feststoff ab, wäscht diesen dreimal mit je 30 ml Ethanol und trocknet im Vakuum. Das so erhaltene Rohprodukt wird an Kieselgel (Lösemittel bzw. deren Gemische, z.B. DCM, THF, Toluol, n-Heptan, Cyclohexan) chromatographiert, und wie unter 1) Variante A beschrieben fraktioniert sublimiert.

| **Bsp.** | **[Ir(L)₂(HOMe)₂]OTf** | **Ir-Komplex** | **Ausbeute** |
|---|---|---|---|
| | **Ligand L** | **Diastereomer** | |
| Ir503 | 1215692-29-7 | 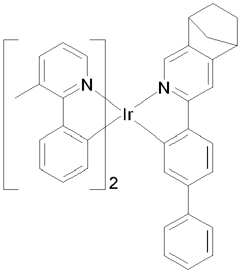 | 45 % |
| | L24 | | |
| Ir504 | 1215692-14-0 | 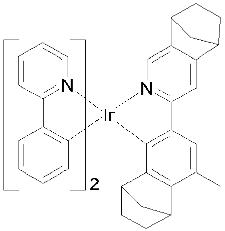 | 24 % |
| | L36 | Diastereomerengemisch | |
| Ir509 | 1215692-14-0 | | 45 % |
| | L61 | 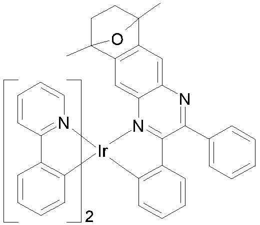 | |
| Ir510 | 1215692-14-0 | 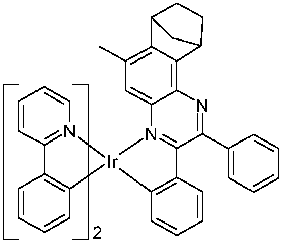 | 41 % |
| | L63 | | |
| Ir511 | 1215692-29-7 | 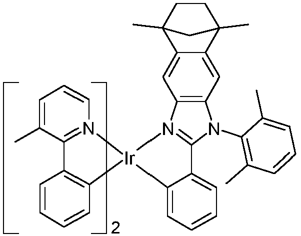 | 37 % |
| | L69 | | |
| Ir512 | 1215692-29-7 | 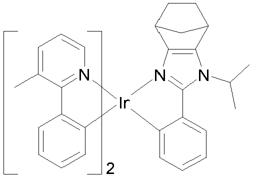 | 39 % |
| | L75 | | |
| Ir517 | [Ir(L10)₂HOMe)]_{2]}OTf | 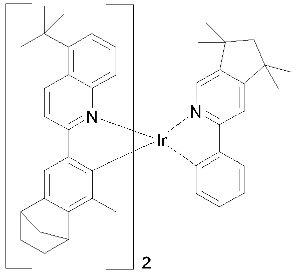 | 45 % |
| | L42 | Diastereomerengemisch | |
| IrL518 | [Ir(L11)₂HOMe)]_{2]}OTf | 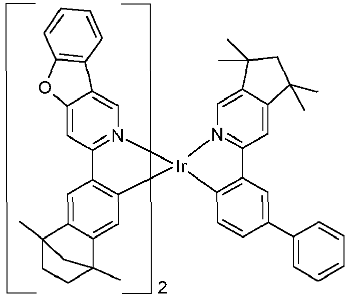 | 33 % |
| | L44 | Diastereomerengemisch | |
| Ir522 | [Ir(L25)₂HOMe)]_{2]}OTf | 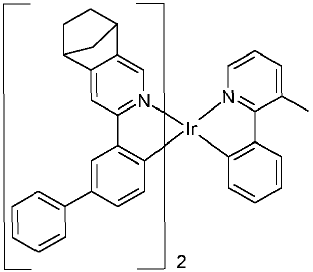 | 42 % |
| | 10273-90-2 | Diastereomerengemisch | |
| Ir528 | [Ir(L59)₂HOMe)]_{2]}OTf | 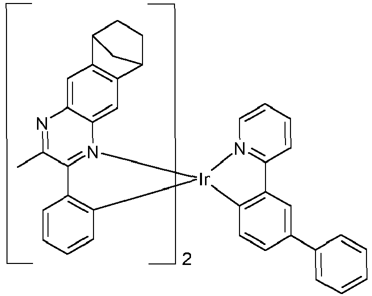 | 33 % |
| | 458541-39-4 | Diastereomerengemisch | |
| Ir532 | [Ir(L72)₂HOMe)]_{2]}OTf | 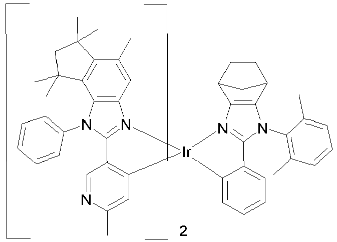 | 37 % |
| | L74 | | |
| Ir533 | [Ir(L74)₂HOMe)]_{2]}OTf | 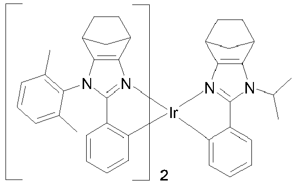 | 35 % |
| | L75 | Diastereomerengemisch | |
| Ir534 | [Ir(L74)₂HOMe)]_{2]}OTf | 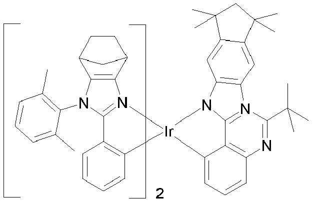 | 21 % |
| | L93 | Diastereomerengemisch | |
| Ir535 | [Ir(L74)₂HOMe)]_{2]}OTf | 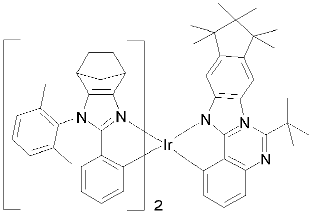 | 19 % |
| | L94 | Diastereomerengemisch | |
| Ir536 | [Ir(L74)₂HOMe)]_{2]}OTf 22 mmol L94 Lösungsm ittel 1,2-Propylenglykol 160 °C | 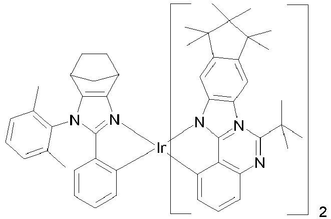 | 26 % |
| Ir551 | [Ir(L102)₂(HOMe)₂]OTf 1008-89-56 Lösungsm ittel 1,2-Propylenglykol 140 °C | 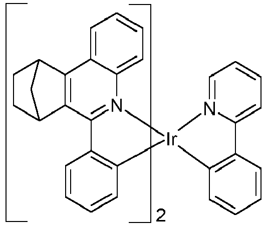 | 26 % |
| | | Diastereomerengemisch | |

### 6) Heteroleptische tris-faciale Iridium-Komplexe enthaltend Liganden vom Arduengo-Carben-Typ:

Darstellung analog A. G. Tennyson et al., Inorg. Chem., 2009, 48, 6924. Ein Gemisch aus 22 mmol des Liganden, 10 mmol Iridium-Chloro-Dimer [Ir(L)₂Cl]₂, 10 mmol Siber(I)oxid und 300 ml 1,2-Dichlorethan wird 30 h bei 90 °C gerührt. Nach Erkalten saugt man vom ausgefallenen Feststoff über ein Celite-Bett ab, wäscht diesen einmal mit 30 ml 1,2-Dichlorethan und engt das Filtrat im Vakuum zur Trockene ein. Das so erhaltene Rohprodukt wird an Kieselgel (Lösemittel bzw. deren Gemische, z. B. Dichlormethan, THF, Toluol, n-Heptan, Cyclohexan) chromatographiert, und wie unter 1) Variante A beschrieben fraktioniert sublimiert.

| **Bsp.** | **[Ir(L)₂Cl]₂** | **Ir-Komplex** | **Ausbeute** |
|---|---|---|---|
| | **Ligand L** | **Diastereomer** | |
| Ir540 | [Ir(L74)₂Cl]₂ | 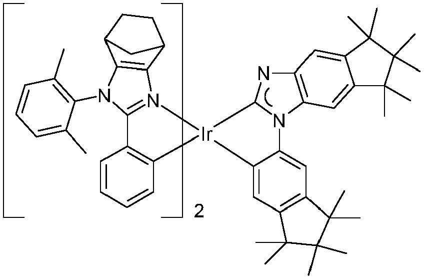 | 39 % |
| | L86 | Diastereomerengemisch | |
| Ir541 | [Ir(L74)₂Cl]₂ | 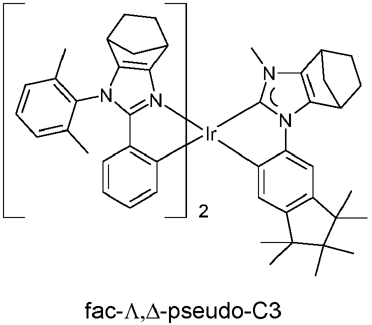 | 21 % |
| | L91 | fac-Λ,Δ-pseudo-C3 | |

### 7) Iridium-Komplexe vom Typ Ir(L)₂L' enthaltend nicht o-metallierte Liganden L':

Ein Gemisch aus 25 mmol des Liganden L', 10 mmol Iridium-Chloro-Dimer [Ir(L)₂Cl]₂, 30 mmol Natriumhydrogencarbonat, 100 ml 2-Ethoxyethanol und 30 ml Wasser wird 16 h bei 90 °C gerührt. Nach Erkalten saugt man vom ausgefallenen Feststoff ab, wäscht diesen dreimal mit je 30 ml Ethanol und trocknet im Vakuum. Das so erhaltene Rohprodukt wird an Kieselgel (Lösemittel bzw. deren Gemische, z. B. Dichlormethan, THF, Toluol, n-Heptan, Cyclohexan) chromatographiert bzw. umkristallisiert, und wie unter 1) Variante A beschrieben fraktioniert sublimiert.

| **Bsp.** | [Ir(L)₂Cl]₂ | **Ir-Komplex** | **Ausbeu te** |
|---|---|---|---|
| | **Ligand L'** | **Diastereomer** | |
| Ir544 | [Ir(L10)₂Cl]₂ | 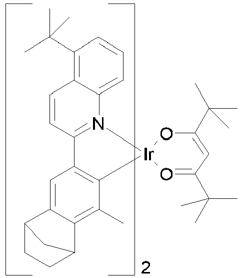 | 58 % |
| | 1118-71-4 | Diastereomerengemisch | |
| Ir547 | [Ir(L74)₂Cl]₂ | 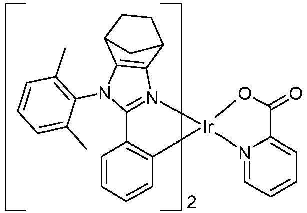 | 71 % |
| | 98-98-6 | Diastereomerengemisch | |
| Ir556 | [Ir(L102)₂Cl]₂ | 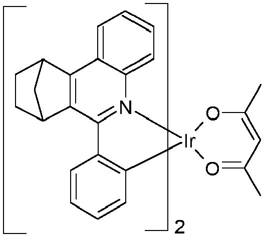 | 70 % |
| | 123-54-6 | | |
| | | Diastereomerengemisch | |
| Ir557 | [Ir(L103)₂Cl]₂ | 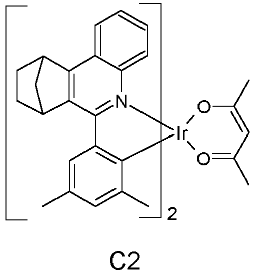 | 28 % |
| | 123-54-6 | C2 | |
| Ir558 | [Ir(L104)₂Cl]₂ | 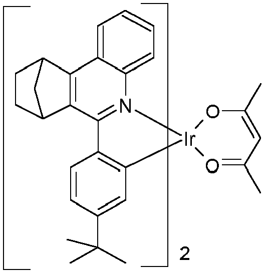 | 58 % |
| | 123-54-6 | Diastereomerengemisch | |
| Ir559 | [Ir(L105)₂Cl]₂ | 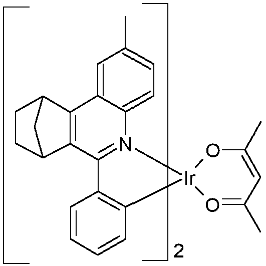 | 66 % |
| | 123-54-6 | Diastereomerengemisch | |
| Ir560 | [Ir(L106)₂Cl]₂ | 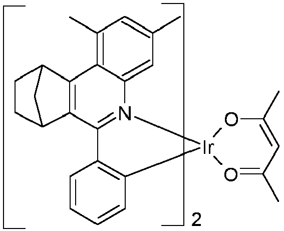 | 63 % |
| | 123-54-6 | Diastereomerengemisch | |
| Ir561 | [Ir(L107)₂Cl]₂ | 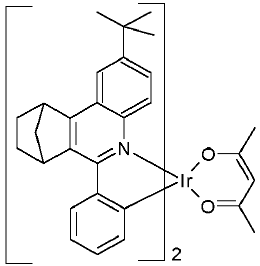 | 76 % |
| | 123-54-6 | Diastereomerengemisch | |
| Ir562 | [Ir(L108)₂Cl]₂ | 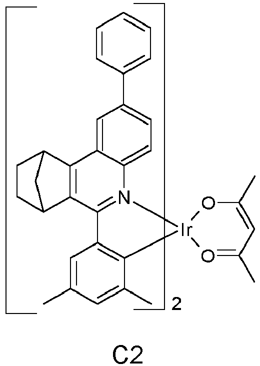 | 35 % |
| | 123-54-6 | C2 | |
| Ir563 | [Ir(L109)₂Cl]₂ | 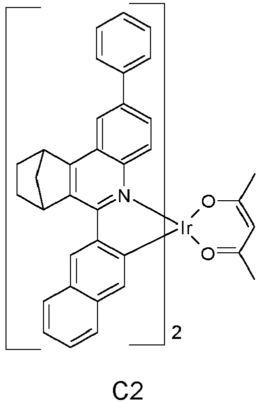 | 35 % |
| | 123-54-6 | C2 | |
| Ir564 | [Ir(L110)₂Cl]₂ | 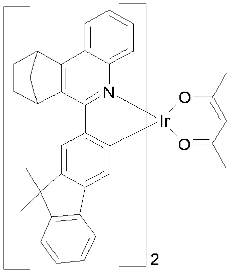 | 73 % |
| | 123-54-6 | Diastereomerengemisch | |
| Ir565 | [Ir(L111)₂Cl]₂ | 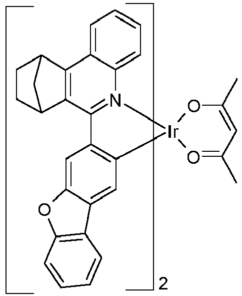 | 75 % |
| | 123-54-6 | Diastereomerengemisch | |
| Ir567 | [Ir(L112)₂Cl]₂ | 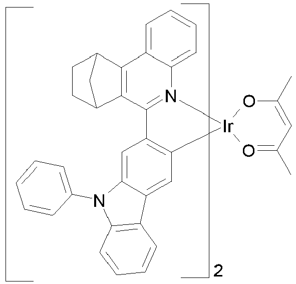 | 67 % |
| | 123-54-6 | Diastereomerengemisch | |
| Ir568 | [Ir(L113)₂Cl]₂ | 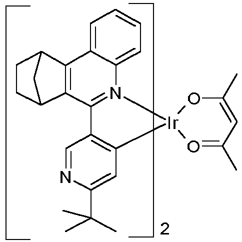 | 70 % |
| | 123-54-6 | Diastereomerengemisch | |
| Ir569 | [Ir(L114)₂Cl]₂ | 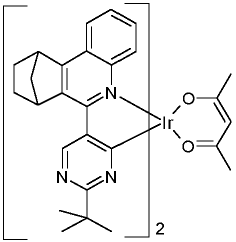 | 58 % |
| | 123-54-6 | Diastereomerengemisch | |
| Ir570 | [Ir(L115a)₂Cl]₂ | 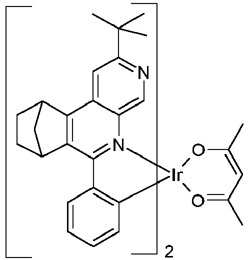 | 50 % |
| | 123-54-6 | Diastereomerengemisch | |
| Ir571 | [Ir(L115b)₂Cl]₂ | 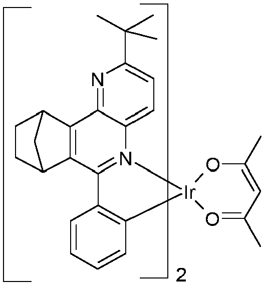 | 70 % |
| | 123-54-6 | Diastereomerengemisch | |
| Ir572 | [Ir(L116)₂Cl]₂ | 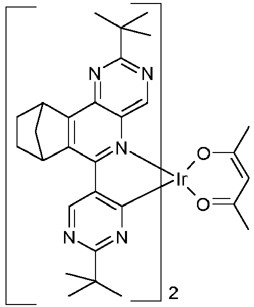 | 48 % |
| | 123-54-6 | Diastereomerengemisch | |
| Ir573 | [Ir(L117)₂Cl]₂ | 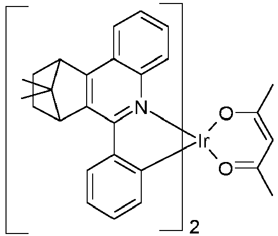 | 67 % |
| | 123-54-6 | Diastereomerengemisch | |
| It574 | [Ir(L118)₂Cl]₂ | 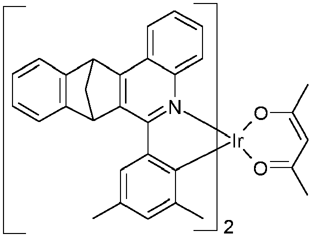 | 59 % |
| | 123-54-6 | Diastereomerengemisch | |
| It575 | [Ir(L119)₂Cl]₂ | 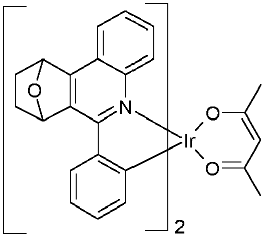 | 56 % |
| | 123-54-6 | Diastereomerengemisch | |
| Ir576 | [Ir(L120)₂Cl]₂ | 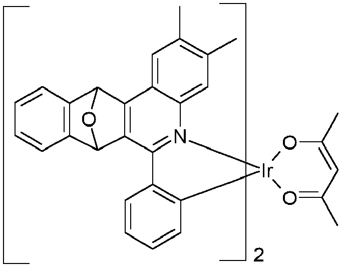 | 60 % |
| | 123-54-6 | Diastereomerengemisch | |
| Ir577 | [Ir(L121)₂Cl]₂ | 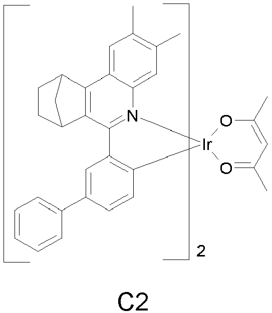 | 46 % |
| | 123-54-6 | C2 | |
| Ir578 | [Ir(L122)₂Cl]₂ | 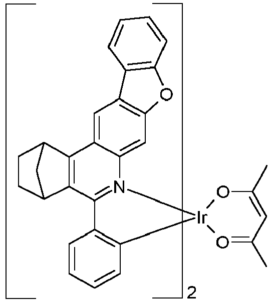 | 55 % |
| | 123-54-6 | Diastereomerengemisch | |
| Ir579 | [Ir(L123)₂Cl]₂ | 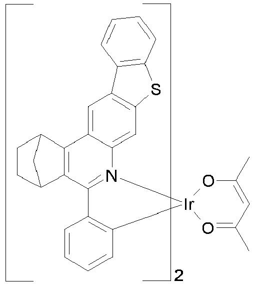 | 43 % |
| | 123-54-6 | Diastereomerengemisch | |
| Ir580 | [Ir(L124)₂Cl]₂ | 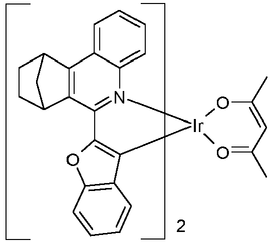 | 47 % |
| | 123-54-6 | Diastereomerengemisch | |
| Ir581 | [Ir(L125)₂Cl]₂ | 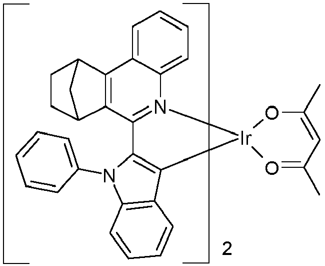 | 32 % |
| | 123-54-6 | Diastereomerengemisch | |
| Ir582 | [Ir(L126)₂Cl]₂ | 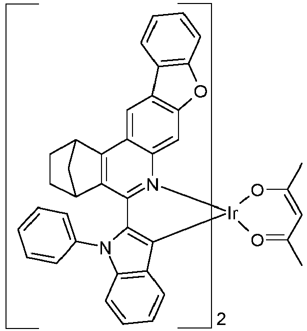 | 45 % |
| | 123-54-6 | Diastereomerengemisch | |
| Ir585 | [Ir(L136)₂Cl]₂ | 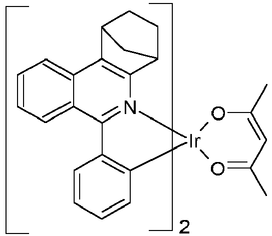 | 51 % |
| | 123-54-6 | Diastereomerengemisch | |
| Ir586 | [Ir(L137)₂Cl]₂ | 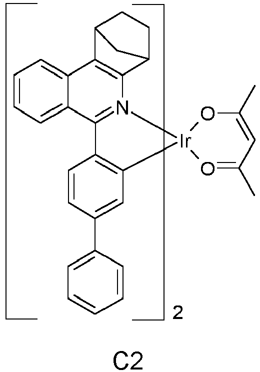 | 33 % |
| | 123-54-6 | C2 | |
| Ir587 | [Ir(L138)₂Cl]₂ | 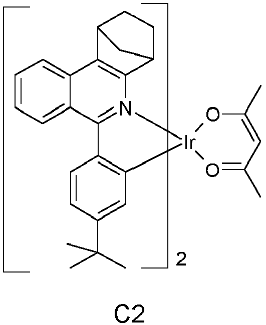 | 37 % |
| | 123-54-6 | C2 | |

### 8) Platin-Komplexe vom Typ PtLL' enthaltend nicht o-metallierte Liganden L':

Darstellung analog J. Brooks et al., Inorg. Chem. 2002, 41, 3055. Ein Gemisch aus 20 mmol des Liganden L, 10 mmol K₂PtCl₄ 75 ml 2-Ethoxyethanol und 25 ml Wasser wird 16 h unter Rückfluss erhitzt. Nach Erkalten und Zugabe von 100 ml Wasser saugt man vom ausgefallenen Feststoff ab, wäscht diesen einmal mit 30 ml Wasser und trocknet im Vakuum. Man suspendiert das so erhaltene Platin-Chloro-Dimer der Formel [PtLCl]₂ in 100 ml 2-Ethoxyethanol, gibt 30 mmol der Liganden L' und 50 mmol Natriumcarbonat zu, rührt die Reaktionsmischung 16 h bei 100 °C und engt dann im Vakuum zur Trockene ein. Das so erhaltene Rohprodukt wird an Kieselgel (Lösemittel bzw. deren Gemische, z. B. Dichlormethan, THF, Toluol, n-Heptan, Cyclohexan) chromatographiert bzw. umkristallisiert, und wie unter 1) Variante A beschrieben fraktioniert sublimiert.

| **Bsp.** | **Ligand L** | **Pt-Komplex** | **Ausbeute** |
|---|---|---|---|
| | **Ligand L'** | | |
| Pt002 | L10 | 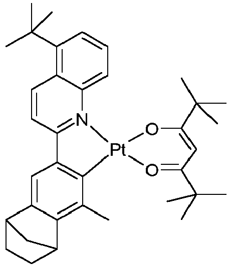 | 31 % |
| | 1118-71-4 | | |
| Pt006 | L74 | 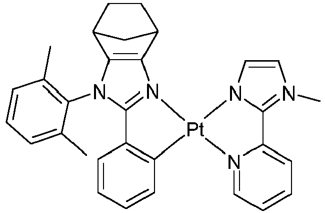 | 36 % |
| | 77429-59-5 | | |

### 9) Platin-Komplexe tetradentater Liganden:

Ein Gemisch aus 10 mmol des Liganden L, 10 mmol K₂PtCl₄, 400 mmol Lithiumacetat, wasserfrei, und 200 ml Eisessig wird 60 h unter Rückfluss erhitzt. Nach Erkalten und Zugabe von 200 ml Wasser extrahiert man zweimal mit je 250 ml Toluol, trocknet über Magnesiumsulfat, filtriert über ein Celite-Bett ab, wäscht das Celite mit 200 ml Toluol nach und entfernt dann das Toluol im Vakuum. Der so erhaltene Feststoff wird wie unter 1) Variante A beschrieben durch Heißextraktion gereinigt und dann fraktioniert sublimiert.

| Bsp. | Ligand L | Pt-Komplex | Extraktionsmittel | Ausbeute |
|---|---|---|---|---|
| Pt(L144) | L144 | Pt(L144) | wie Pt(L143) | 29 % |
| | | Diastereomerengemisch | | |
| Pt(L147) | L147 | Pt(L147) | o-Xylol | 46 % |

### 10) Platin-Komplexe tetradentater Liganden vom

### Arduengo-Carben-Typ:

Ein Gemisch aus 10 mmol des Liganden, 10 mmol Silber(I)oxid und 200 ml Dioxan wird 16 h bei Raumtemperatur gerührt, dann mit 100 ml Butanon, 20 mmol Natriumcarbonat und 10 mmol Cyclooctadienyl-platindichlorid versetzt und 16 h unter Rückfluss erhitzt. Nach Entfernen des Lösungsmittels wird der Feststoff mit 500 ml heißem Toluol ausgerührt, die Suspension wird über ein Celite-Bett filtriert und das Filtrat wird zur Trockene eingeengt. Der so erhaltene Feststoff wird an Kieselgel mit DCM chromatographiert und dann wie unter 1) Variante A beschrieben fraktioniert sublimiert.

| Bsp. | Ligand | Komolex | Ausbeute |
|---|---|---|---|
| Pt(L151) | L151 | 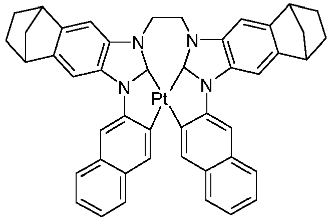 | 31 % |
| | | Diastereomerengemisch | |

### Derivatisierung der Metallkomplexe

### 1) Halogenierung der Iridium-Komplexe:

Eine Lösung bzw. Suspension von 10 mmol eines Komplexes, der in para-Position zum Iridium A x C-H-Gruppen (mit A = 1, 2 oder 3) trägt, in 1000 ml Dichlormethan wird unter Licht- und Luftausschluss bei 30 °C mit A x 10.5 mmol N-Halogensuccinimid (Halogen: Cl, Br, I) versetzt und 20 h gerührt. In DCM schlecht lösliche Komplexe können auch in anderen Lösungsmitteln (TCE, THF, DMF, etc.) und bei erhöhter Temperatur umgesetzt werden. Anschließend wird das Lösungsmittel im Vakuum weitgehend entfernt. Der Rückstand wird mit 100 ml MeOH ausgekocht, der Feststoff wird abgesaugt, dreimal mit 30 ml Methanol gewaschen und dann im Vakuum getrocknet.

### Synthese von Ir(L22-Br)₃:

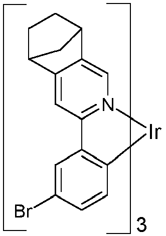

Eine bei 30 °C gerührte Suspension von 8.5 g (10 mmol) Ir(L22)₃ in 1000 ml DCM wird auf ein Mal mit 5.6 g (31.5 mmol) N-Bromsuccinimid versetzt und dann weitere 20 h gerührt. Nach Entfernen von ca. 900 ml des DCMs im Vakuum wird die zitronengelbe Suspension mit 100 ml Methanol versetzt, der Feststoff wird abgesaugt, dreimal mit ca. 30 ml Methanol gewaschen und dann im Vakuum getrocknet. Ausbeute: 10.4 g (9.5 mmol) 95 %; Reinheit: ca. 99.5 %ig nach NMR.

Analog können folgende Verbindungen dargestellt werden:

| Bsp. | Komplex | Bromierter Komplex | Ausbeute |
|---|---|---|---|
| Ir(L102-Br)₃ | 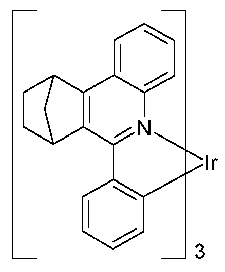 | 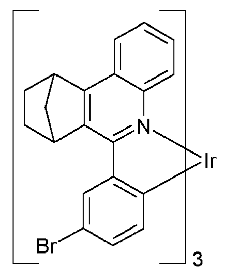 | 92 % |
| | Ir(L102)₃ | Ir(L102-Br)₃ | |

### 2) Suzuki-Kupplung an den Iridium-Komplexen:

### Variante A, zweiphasige Reaktionsmischung:

Eine Suspension von 10 mmol eines bromierten Komplexes, 40 - 80 mmol der Boronsäure bzw. des Boronsäureesters und 80 mmol Trikaliumphosphat in einem Gemisch aus 300 ml Toluol, 100 ml Dioxan und 300 ml Wasser wird mit 0.6 mmol Tri-o-tolylphosphin und dann mit 0.1 mmol Palladium(II)acetat versetzt und 16 h unter Rückfluss erhitzt. Nach Erkalten gibt man 500 ml Wasser und 200 ml Toluol zu, trennt die wässrige Phase ab, wäscht die organische Phase dreimal mit 200 ml Wasser, einmal mit 200 ml gesättigter Kochsalzlösung und trocknet über Magnesiumsulfat. Man filtriert über ein Celite-Bett ab, wäscht dieses mit Toluol nach, entfernt das Toluol fast vollständig im Vakuum, gibt 300 ml Ethanol zu, saugt vom ausgefallenen Rohprodukt ab, wäscht dieses dreimal mit je 100 ml EtOH und trocknet im Vakuum. Das Rohprodukt wird mit Toluol zweimal an Kieselgel gesäult. Der Metallkomplex wird abschließend getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### Variante B, einphasige Reaktionsmischung:

Eine Suspension von 10 mmol eines bromierten Komplexes, 40 - 80 mmol der Boronsäure bzw. des Boronsäureesters und 60 - 100 mmol der Base (Kaliumfluorid, Trikaliumphosphat, Kaliumcarbonat, Cäsiumcarbonat etc. jeweils wasserfrei) und 100 g Glaskugeln (3 mm Durchmesser) in 100 ml - 500 ml eines aprotischen Lösungsmittels (THF, Dioxan, Xylol, Mesitylen, Dimethylacetamid, NMP, DMSO, etc.) wird mit 0.6 mmol Tri-o-tolylphosphin und dann mit 0.1 mmol Palladium(II)acetat versetzt und 1 - 24 h unter Rückfluss erhitzt. Alternativ können andere Phosphine wir Tri-tert-butylphosphin, S-Phos, X-Phos, Xanthphos, etc. eingesetzt werden, wobei bei diesen Phosphinen das bevorzugte Phosphin : Palladium Verhältnis 2:1 bis 1.2:1 beträgt. Man entfernt das Lösungsmittel im Vakuum, nimmt das Produkt in einem geeigneten Lösungsmittel (Toluol, Dichlormethan, Ethylacetat, etc.) auf und reinigt wie unter Variante A beschrieben.

### Synthese von Ir588₃:

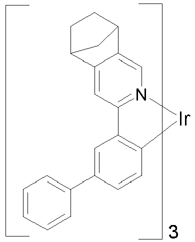

### Variante B:

Einsatz von 10.9 g (10.0 mmol) Ir(L22-Br)₃ und 4.9 g (40.0 mmol) Phenylboronsäure [98-80-6], 32.5 g (100 mmol) Cäsiumcarbonat, 62 mg (0.15 mmol) SPhos [657408-07-6], 25 mg (0.1 mmol) Palladium(II)acetat , 200 Dioxan, 100 °C, 8 h. Chromatographische Trennung an Kieselgel mit Toluol/Ethylacetat (90:10, vv). Ausbeute: 6.9 g (6.4 mmol) 64 %; Reinheit: ca. 99.8 %ig nach HPLC.

Analog können folgende Verbindungen dargestellt werden:

| Bsp. | Komplex Boronsäure Variante | Produkt | Ausbeute |
|---|---|---|---|
| Ir591 | Ir(L102-Br)₃ | 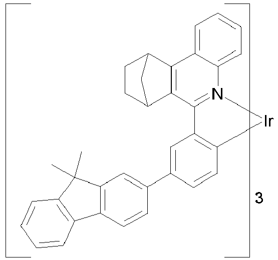 | 42 % |
| | 333432-28-3 A | | |
| | chromatographische | | |
| | Trennung mit DCM | | |

### 3) Buchwald-Kupplung an den Iridium-Komplexen:

Ein Gemisch aus 10 mmol des bromierten Komplexes, 40 mmol des Diarylamins oder Carbazols, 45 mmol Natrium-tert-butylat bei Aminen bzw. 80 mmol Trikaliumphosphat, wasserfrei, bei Carbazolen, 100 g Glaskugeln (3 mm Durchmesser) und 300 - 500 ml Toluol wird mit 0.4 mmol Tri-tert-butylphosphin und dann mit 0.3 mmol Palladium(II)acetat versetzt und unter gutem Rühren 16 h unter Rückfluss erhitzt. Nach Erkalten trennt man die wässrige Phase ab, wäscht zweimal mit 200 ml Wasser, einmal mit 200 ml gesättigter Kochsalzlösung und trocknet über Magnesiumsulfat. Man filtriert über ein Celite-Bett ab, wäscht dieses mit Toluol nach, entfernt das Lösungsmittel fast vollständig im Vakuum, gibt 300 ml Ethanol zu, saugt vom ausgefallenen Rohprodukt ab, wäscht dieses dreimal mit je 100 ml EtOH und trocknet im Vakuum. Das Rohprodukt wird mit Toluol zweimal an Kieselgel chromatographisch gereinigt. Der Metallkomplex wird abschließend getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### 4) Cyanierung der Iridium-Komplexe:

Ein Gemisch aus 10 mmol des bromierten Komplexes, 13 mmol Kupfer(I)-cyanid pro Brom-Funktion und 300 ml NMP wird 20 h bei 200 °C gerührt. Nach Erkalten entfernt man das Lösungsmittel im Vakuum, nimmt den den Rückstand in 500 ml Dichlormethan auf, filtriert über Celite von den Kupfersalzen ab, engt das Dichlormethan im Vakuum fast bis zur Trockene ein, gibt 100 ml Ethanol zu, saugt vom ausgefallenen Feststoff ab, wäscht diesen zweimal mit je 50 ml Ethanol und trocknet im Vakuum. Chromatographie oder Heißextraktion und fraktionierte Sublimation des Rohproduktes wie in 1) Variante A beschrieben.

### 5) Borylierung der Iridium-Komplexe:

Ein Gemisch von 10 mmol des bromierten Komplexes, 12 mmol Bis-(pinacolato)diboran [73183-34-3] pro Brom-Funktion, 30 mmol Kaliumacetat, wasserfrei pro Bromfunktion, 0.2 mmol Tricyclohexylphosphin, 0.1 mmol Palladium(II)acetat und 300 ml Lösungsmittel (Dioxan, DMSO, NMP, etc.) wird 4-16 h bei 80-160 °C gerührt. Nach Entfernen des Lösungsmittels im Vakuum wird der Rückstand in 300 ml Dichlormethan, THF oder Ethylacetat aufgenommen, über ein Celite-Bett filtriert, das Filtrat wird bis zur beginnenden Kristallisation im Vakuum eingeengt und abschließend noch tropfenweise mit ca. 100 ml Methanol versetzt, um die Kristallisation zu vervollständigen. Die Verbindungen können aus Dichlormethan, Ethylacetat oder THF unter Zusatz von Methanol oder alternativ aus Cyclohexan umkristallisiert werden.

### Polymere enthaltend die Metallkomplexe:

### Allgemeine Polymerisationsvorschrift für die Bromide bzw. Boronsäure-Derivate als polymerisierbare Gruppe, Suzuki-Polymerisation Variante A - Zweiphasiges Reaktionsgemisch:

Die Monomere (Bromide und Boronsäuren bzw. Boronsäureester, Reinheit nach HPLC > 99.8 % ig) werden in der in der Tabelle angegebenen Zusammensetzung in einer Gesamtkonzentration von ca. 100 mmol/L in einem Gemisch aus 2 Volumenteilen Toluol: 6 Volumenteilen Dioxan : 1 Volumenteil Wasser gelöst bzw. suspendiert. Dann gibt man 2 mol Äquivalente Tri-kalium-phosphat pro eingesetzter Br-Funktionalität zu, rührt 5 min. nach, fügt dann 0.03 bis 0.003 mol Äquivalente Tri-ortho-tolylphosphin und dann 0.005 bis 0.0005 mol Äquivalente Palladium(II)acetat (Verhältnis Phosphin zu Pd bevorzugt 6:1) pro eingesetzter Br-Funktionalität zu und erhitzt unter sehr gutem Rühren 2-3 h unter Rückfluss. Falls die Viskosität der Mischung zu stark ansteigt, kann mit einem Gemisch aus 2 Volumenteilen Toluol: 3 Volumenteilen Dioxan verdünnt werden. Nach insgesamt 4-6 h Reaktionszeit fügt man zum end-capping 0.05 mol Äquivalente pro eingesetzter Boronsäure-Funktionalität eines Monobromaromaten und dann 30 min. danach 0.05 mol Äquivalente pro eingesetzter Br-Funktionalität einer Monoboronsäure bzw. eines Monoboronsäureesters zu und kocht weiter 1 h nach. Nach Erkalten verdünnt man mit 300 ml Toluol. trennt die wässrige Phase ab, wäscht die organische Phase zweimal mit je 300 ml Wasser, trocknet über Magnesiumsulfat, filtriert über ein Celite-Bett ab, um Palladium zu entfernen und engt dann zur Trockene ein. Man löst das Rohpolymer in THF (Konzentration ca. 10 - 30 g/L) und lässt die Lösung unter sehr gutem Rühren langsam in das doppelte Volumen Methanol einlaufen. Das Polymer wird abgesaugt und dreimal mit Methanol gewaschen. Der Umfällvorgang wird dreimal wiederholt, danach wird das Polymer im Vakuum bis zur Gewichtskonstanz bei 30 - 50 °C getrocknet.

### Variante B - Einphasiges Reaktionsgemisch:

Die Monomere (Bromide und Boronsäuren bzw. Boronsäureester, Reinheit nach HPLC > 99.8 % ig) werden in der in Tabelle angegebenen Zusammensetzung in einer Gesamtkonzentration von ca. 100 mmol/L in einem Lösemittel (THF, Dioxan, Xyylol, Mesitylen, Dimethylacetamid, NMP, DMSO, etc.) gelöst bzw. suspendiert. Dann gibt man 3 mol Äquivalente Base (Kaliumfluorid, Trikaliumphosphat, Kaliumcarbonat, Cäsiumcarbonat etc. jeweils wasserfrei) pro Br-Funktionalität und das Gewichtsäquivalent Glaskugeln (3 mm Durchmesser) zu, rührt 5 min. nach, fügt dann 0.03 bis 0.003 mol Äquivalente Tri-ortho-tolylphosphin und dann 0.005 bis 0.0005 mol Äquivalente Palladium(II)acetat (Verhältnis Phosphin zu Pd bevorzugt 6:1) pro Br-Funktionalität zu und erhitzt unter sehr gutem Rühren 2-3 h unter Rückfluss. Alternativ können andere Phosphine wir Tritert-butylphosphin, S-Phos, X-Phos, Xanthphos, etc. eingesetzt werden, wobei bei diesen Phosphinen das bevorzugte Phosphin : Palladium Verhältnis 2:1 bis 1.3:1 beträgt. Nach insgesamt 4-12 h Reaktionszeit fügt man zum end-capping 0.05 mol Aquivalente eines Monobromaromaten und dann 30 min. danach 0.05 mol Äquivalente einer Monoboronsäure bzw. eines Monoboronsäureesters zu und kocht weiter 1 h nach. Man entfernt das Lösungsmittel weitgehend im Vakuum, nimmt den Rückstand in Toluol auf, und reinigt das Polymer wie unter Variante A beschrieben.

### Beispiel: Vergleich der Photolumineszenzspektren

Figur 1 zeigt das Photolumineszenzspektrum des Komplexes Ir(L3)₃, also eines Tris(phenylisochinolin)iridium-Komplexes (nicht Gegenstand der Erfindung), welcher einen ankondensierten aliphatischen Fünfring enthält, im Vergleich zu dem Spektrum des entsprechenden Komplexes ohne diese Gruppe. Die Spektren wurden in einer ca. 10⁻⁵ molaren Lösung in entgastem Toluol bei Raumtemperatur gemessen. Es lässt sich deutlich die schmalere Emissionsbande mit einer Halbwertsbreite FWHM von 48 nm gegenüber 74 nm bei der Verbindung ohne eine ankondensierte aliphatische Gruppe erkennen. Der erfindungsgemäße Komplex weist weiterhin eine höhere Photolumineszenzquanteneffizienz auf.

### Beispiel: Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Glasplättchen, mit strukturiertem ITO (50 nm, Indium-Zinn-Oxid) bilden die Substrate, auf welche die OLEDs aufgebracht werden. Die OLEDs haben prinzipiell folgenden Schichtaufbau: Substrat / Lochtransportschicht 1 (HTL1) bestehend aus HTM dotiert mit 3 % NDP-9 (kommerziell erhältlich von der Fa. Novaled), 20 nm / Lochtransportschicht 2 (HTL2) / optionale Elektronenblockerschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuumprozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie M3:M2:Ir(L1)₃ (55%:35%:10%) bedeutet hierbei, dass das Material M3 in einem Volumenanteil von 55%, M2 in einem Anteil von 35% und Ir(L1)₃ in einem Anteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 7 gezeigt.

Die OLEDs werden standardmäßig charakterisiert. Hierfür werden die Elektrolumineszenzspektren, die Stromeffizienz (gemessen in cd/A) und die Spannung (gemessen bei 1000 cd/m² in V) bestimmt aus Strom-Spannungs-Helligkeits-Kennlinien (IUL-Kennlinien). Für ausgewählte Versuche wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD50 bedeutet, dass es sich bei der genannten Lebensdauer um die Zeit handelt, bei der die Leuchtdichte auf 50% der Startleuchtdichte abgefallen ist, also von z.B. 1000 cd/m² auf 500 cd/m². Je nach Emissionsfarbe wurden unterschiedliche Starthelligkeiten gewählt. Die Werte für die Lebensdauer können mit Hilfe dem Fachmann bekannten Umrechnungsformeln auf eine Angabe für andere Startleuchtdichten umgerechnet werden. Hierbei ist die Lebensdauer für eine Startleuchtdichte von 1000 cd/m² eine übliche Angabe.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Als Vergleich gemäß dem Stand der Technik werden die Iridium-Verbindungen gemäß Tabelle 7 verwendet. Die Ergebnisse der OLEDs sind in Tabelle 2 zusammengefasst.

**Tabelle 1: Aufbau der OLEDs**

| **Bsp.** | **HTL2** | **EBL** | **EML** | **HBL** | **ETL** |
|---|---|---|---|---|---|
| | **Dicke** | **Dicke** | **Dicke** | **Dicke** | **Dicke** |
| Rote OLEDs | | | | | |
| D-IrR1 | HTM 280 nm | --- | M7:M8:Ir-R1 | - | ETM1:ETM2 |
| | | | (65%:30%:5%) | | (50%:50%) |
| | | | 35 nm | | 40 nm |
| D-Ir587 | HTM 280 nm | --- | M6:M8:Ir587 | - | ETM1:ETM2 |
| | | | (65%:30%:5%) | | (50%:50%) |
| | | | 35 nm | | 40 nm |
| D-IrR2 | HTM 280 nm | --- | M9:Ir-R2 | - | ETM1:ETM2 |
| | | | (92%:8%) | | (50%:50%) |
| | | | 35 nm | | 40 nm |
| D-Ir544 | HTM 280 nm | --- | M9:Ir544 | --- | ETM1:ETM2 |
| | | | (92%:8%) | | (50%:50%) |
| | | | 35 nm | | 40 nm |
| D-Ir556 | HTM 280 nm | --- | M9:Ir556 | --- | ETM1:ETM2 |
| | | | (95%:5%) | | (50%:50%) |
| | | | 35 nm | | 40 nm |
| D-Ir557 | HTM 280 nm | --- | M9:Ir557 | --- | ETM1:ETM2 |
| | | | (92%:8%) | | (50%:50%) |
| | | | 35 nm | | 40 nm |
| D-Ir568 | HTM 280 nm | --- | M9:Ir568 | --- | ETM1:ETM2 |
| | | | (95%:5%) | | (50%:50%) |
| | | | 35 nm | | 40 nm |
| D-lrR3 | HTM | --- | M7:M8:Ir-R3 | --- | ETM1:ETM2 |
| | 280 nm | | (65%:30%:5%) | | (50%:50%) |
| | | | 35 nm | | 40 nm |
| D-lrR4 | HTM | --- | M7:M8:Ir-R4 | --- | ETM1:ETM2 |
| | | | (65%:30%:5%) | | (50%:50%) |
| | 280 nm | | 35 nm | | 40 nm |
| D-Pt-R1 | HTM | --- | M7:M8:Pt-R1 | --- | ETM1:ETM2 |
| | | | (65%:30%:5%) | | (50%:50%) |
| | 280 nm | | 35 nm | | 40 nm |

| Gelbe OLEDs | | | | | |
|---|---|---|---|---|---|
| D-Ir-Y1 | HTM | --- | M7:M8:Ir-Y1 | --- | ETM1:ETM2 |
| | | | (62%:30%:8%) | | (50%:50%) |
| | 230 nm | | 25 nm | | 45 nm |
| D-Ir(L28)₃ | HTM | --- | M7:M8:Ir(L28)₃ | --- | ETM1:ETM2 |
| | | | (62%:30%:8%) | | (50%:50%) |
| | 230 nm | | 25 nm | | 45 nm |
| D-Ir-Y2 | HTM | --- | M7:M8:Ir-Y2 | --- | ETM1:ETM2 |
| | | | (62%:30%:8%) | | (50%:50%) |
| | 230 nm | | 25 nm | | 45 nm |

| Grüne OLEDs | | | | | |
|---|---|---|---|---|---|
| D-Ir-G1 | HTM | --- | M7:M8:Ir-G1 | HBM2 | ETM1:ETM2 |
| | | | (65%:30%:5%) | | (50%:50%) |
| | 230 nm | | 25 nm | 10 nm | 35 nm |
| D-Ir(L22)₃ | HTM | --- | M7:M8:Ir(L22)₃ | HBM2 | ETM1:ETM2 |
| | | | (65%:30%:5%) | | (50%:50%) |
| | 230 nm | | 25 nm | 10 nm | 35 nm |
| D-Ir(L33)₃ | HTM | --- | M7:M8:Ir(L33)₃ | HBM2 | ETM1:ETM2 |
| | | | (65%:30%:5%) | | (50%:50%) |
| | 230 nm | | 25 nm | 10 nm | 35 nm |
| D-Ir(L34)₃ | HTM | --- | M7:M8:Ir(L34)₃ | HBM2 | ETM1:ETM2 |
| | | | (65%:30%:5%) | | (50%:50%) |
| | 230 nm | | 25 nm | 10 nm | 35 nm |
| D-Ir(L35)₃ | HTM | --- | M7:M8:Ir(L35)₃ | HBM2 | ETM1:ETM2 |
| | | | (65%:30%:5%) | | (50%:50%) |
| | 230 nm | | 25 nm | 10 nm | 35 nm |
| D-Ir(L38)₃ | HTM | --- | M7:M8:Ir(L38)₃ | HBM2 | ETM1:ETM2 |
| | | | (65%:30%:5%) | | (50%:50%) |
| | 230 nm | | 25 nm | 10 nm | 35 nm |
| D-Ir(L49)₃ | HTM | --- | M7:M8:Ir(L49)₃ | HBM2 | ETM1:ETM2 |
| | | | (65%:30%:5%) | | (50%:50%) |
| | 230 nm | | 25 nm | 10 nm | 35 nm |
| D-Ir(L50)3 | HTM | --- | M7:M8:Ir(L50)₃ | HBM2 | ETM1:ETM2 |
| | | | (65%:30%:5%) | | (50%:50%) |
| | 230 nm | | 25 nm | 10 nm | 35 nm |
| D-Ir(L52)₃ | HTM | --- | M7:M8:Ir(L52)₃ | HBM2 | ETM1:ETM2 |
| | | | (65%:30%:5%) | | (50%:50%) |
| | 230 nm | | 25 nm | 10 nm | 35 nm |
| D-Ir-G2 | HTM | --- | M7:M8:Ir-G2 | HBM2 | ETM1:ETM2 |
| | | | (65%:30%:5%) | | (50%:50%) |
| | 230 nm | | 25 nm | 10 nm | 35 nm |

| Blaue OLEDs | | | | | |
|---|---|---|---|---|---|
| D-Ir-B1 | HTM | EBM | M1:M4:Ir-B1 | HBM1 | ETM1:ETM2 |
| | | | (60%:35%:5%) | | (50%:50%) |
| | 190 nm | 10 nm | 25 nm | 10 nm | 15 nm |
| D-Ir(L74)₃ | HTM | EBM | M1:M4:Ir(L74)₃ | HBM1 | ETM1:ETM2 |
| | | | (60%:35%:5%) | | (50%:50%) |
| | 190 nm | 10 nm | 25 nm | 10 nm | 15 nm |
| D-Ir(L77)₃ | HTM | EBM | M1:M4:Ir(L77)₃ | HBM1 | ETM1:ETM2 |
| | | | (60%:35%:5%) | | (50%:50%) |
| | 190 nm | 10 nm | 25 nm | 10 nm | 15 nm |
| D-Ir-B2 | HTM | EBM | M10:M4:Ir-B2 | HBM1 | ETM1:ETM2 |
| | | | (65%:25%:10%) | | (50%:50%) |
| | 190 nm | 10 nm | 25 nm | 10 nm | 15 nm |
| D-fac-Ir(L88)₃ | HTM | EBM | M10:M4:fac-Ir(L88)₃ | HBM1 | ETM1:ETM2 |
| | | | (65%:25%:10%) | | (50%:50%) |
| | 190 nm | 10 nm | 25 nm | 10 nm | 15 nm |

**Tabelle 2: Ergebnisse der Vakuum-prozessierten OLEDs**

| **Bsp.** | **EQE (%)** | **Spannung (V)** | **CIE x/y** | **LD80 (h)** |
|---|---|---|---|---|
| | **1000 cd/m²** | **1000 cd/m²** | **1000 cd/m²** | **1000 cd/m²** |
| **Rote OLEDs** | | | | |
| D-IrR1 | 13.3 | 2.9 | 0.67/0.33 | 14000 |
| D-Ir587 | 19.3 | 3.2 | 0.68/0.32 | 17000 |
| D-IrR2 | 18.9 | 3.8 | 0.66/0.34 | 30000 |
| D-Ir544 | 22.4 | 3.6 | 0.65/0.34 | 54000 |
| D-Ir556 | 19.6 | 3.4 | 0.66/0.34 | 36000 |
| D-Ir557 | 19.2 | 3.3 | 0.67/0.33 | 40000 |
| D-Ir568 | 19.4 | 3.5 | 0.63/0.36 | 47000 |
| D-IrR3 | 16.3 | 3.2 | 0.62/0.37 | 21000 |
| D-Ir542 | 21.0 | 3.2 | 0.64/0.35 | 33000 |
| D-IrR4 | 12.7 | 3.3 | 0.70/0.29 | 17000 |
| D-Ir546 | 18.0 | 3.2 | 0.71/0.28 | 39000 |
| D-Pt-R1 | 11.0 | 3.4 | 0.68/0.32 | 11000 |

| **Gelbe OLEDs** | | | | |
|---|---|---|---|---|
| D-Ir-Y1 | 19.8 | 3.0 | 0.38/0.61 | 32000 |
| D-Ir(L28)₃ | 22.3 | 3.1 | 0.40/0.59 | 39000 |
| D-Ir-Y2 | 21.5 | 2.8 | 0.46/0.53 | 41000 |

| **Grüne OLEDs** | | | | |
|---|---|---|---|---|
| D-Ir-G1 | 18.0 | 3.4 | 0.32/0.64 | 8000 |
| D-Ir(L22)₃ | 21.3 | 3.3 | 0.28/0.62 | 23000 |
| D-Ir(L33)₃ | 22.4 | 3.4 | 0.31/0.63 | 21000 |
| D-Ir(L34)₃ | 22.6 | 3.4 | 0.31/0.63 | 25000 |
| D-Ir(L35)₃ | 22.4 | 3.4 | 0.31/0.63 | 24000 |
| D-Ir(L38)₃ | 21.4 | 3.3 | 0.30/0.64 | 19000 |
| D-Ir(L49)₃ | 22.3 | 3.4 | 0.31/0.63 | 22000 |
| D-Ir(L50)₃ | 22.3 | 3.3 | 0.31/0.64 | 23000 |
| D-Ir(L52)₃ | 23.2 | 3.4 | 0.31/0.64 | 24000 |
| D-Ir-G2 | 19.1 | 3.2 | 0.35/0.61 | 19000 |

| **Blaue OLEDs** | | | | |
|---|---|---|---|---|
| | | | | **LD50 (h)** |
| | | | | **1000 cd/m²** |
| D-Ir-B1 | 16.3 | 4.8 | 0.18/0.37 | 1000 |
| D-Ir(L74)₃ | 22.5 | 4.7 | 0.16/0.38 | 1200 |
| D-Ir(L77)₃ | 21.0 | 4.8 | 0.15/0.36 | 700 |
| D-Ir-B2 | 3.2 | 5.3 | 0.16/0.06 | 50 |
| D-fac-Ir(L88)₃ | 8.8 | 5.6 | 0.16/0.10 | 200 |

### 2) Lösungs-prozessierte Devices:

### A: Aus löslichen Funktionsmaterialien

Die erfindungsgemäßen Iridium-Komplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich aus Substrat / ITO / PEDOT (80 nm) / Interlayer (80 nm) / Emissionsschicht (80 nm) / Kathode zusammen. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum als Pufferschicht eine 80 nm Schicht PEDOT (PEDOT ist ein Polythiophen-Derivat (Baytron P VAI 4083sp.) von H. C. Starck, Goslar, das als wässrige Dispersion geliefert wird) durch Spin-Coating aufgebracht. Die benötigte Spinrate hängt vom Verdünnungsgrad und der spezifischen Spin-Coater-Geometrie ab (typisch für 80 nm: 4500 rpm). Um Restwasser aus der Schicht zu entfernen, werden die Substrate für 10 Minuten bei 180 °C auf einer Heizplatte ausgeheizt. Die verwendete Interlayer dient der Lochinjektion, in diesem Fall wird HIL-012 von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Emitter zusammen mit den Matrixmaterialien in Toluol gelöst. Der typische Feststoffgehalt solcher Lösungen liegt zwischen 16 und 25 g/L, wenn, wie hier, die für eine Device typische Schichtdicke von 80 nm mittels Spincoating erzielt werden soll. Die lösungsprozessierten Devices enthalten eine Emissionsschicht aus (Polystyrol):M5:M6:Ir(L)₃ (25%:25%:40%:10%). Die Emissionsschicht wird in einer Inertgasatmosphäre, im vorliegenden Fall Argon, aufgeschleudert und 30 min bei 130 °C ausgeheizt. Zuletzt wird eine Kathode aus Barium (5 nm) und dann Aluminium (100 nm) (hochreine Metalle von Aldrich, besonders Barium 99.99 % (Best-Nr. 474711); Aufdampfanlagen von Lesker o.a., typischer Aufdampfdruck 5 x 10⁻⁶ mbar) aufgedampft. Optional kann zunächst eine Lockblockierschicht und dann eine Eletronentransportschicht und dann erst die Kathode (z.B. AI oder LiF/AI) im Vakuum aufgedampft werden. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 3 fasst die erhaltenen Daten zusammen.

**Tabelle 3: Ergebnisse mit aus Lösung prozessierten Materialien**

| **Bsp.** | **Emitter** | **EQE (%)** | **Spannung (V)** | **CIE x/y** |
|---|---|---|---|---|
| | | **1000 cd/m²** | **1000 cd/m²** | **1000 cd/m²** |
| **Rote OLEDs** | | | | |
| Sol-D-Ir-R2 | Ir-R2 | 17.1 | 3.9 | 0.66/0.34 |
| Sol-D-Ir544 | Ir544 | 21.2 | 3.8 | 0.65/0.34 |
| Sol-D-Ir564 | Ir564 | 18.7 | 3.6 | 0.68/0.31 |
| Sol-D-Ir567 | Ir567 | 18.5 | 3.2 | 0.68/0.31 |

| **Gelbe OLEDs** | | | | |
|---|---|---|---|---|
| Sol-D-Ir-Y3 | IrY3 | 19.5 | 3.9 | 0.48/0.49 |

| **Grüne OLEDs** | | | | |
|---|---|---|---|---|
| Sol-D-Ir-G3 | Ir-G3 | 18.5 | 4.3 | 0.34/0.61 |
| Sol-D-Ir(L26)₃ | Ir(L26)3 | 21.7 | 4.4 | 0.34/0.61 |

### 3) Weiß emittierende OLEDs

Gemäß den allgemeinen Verfahren aus 1) wird eine weiß emittierende OLED mit folgendem Schichtaufbau hergestellt:

**Tabelle 5: Aufbau der weißen OLEDs**

| **Bsp.** | **HTL2** | **EML** | **EML** | **EML** | **HBL** | **ETL** |
|---|---|---|---|---|---|---|
| | | **Rot** | **Blau** | **Grün** | | |
| | **Dicke** | **Dicke** | **Dicke** | **Dicke** | **Dicke** | **Dicke** |
| D-W1 | HTM | EBM:IrL544 | M1:M3:IrL536 | M3:Ir(L42)₃ | M3 | ETM1:ETM2 |
| | | (97%:3%) | (45%:50%:5%) | (90%:10%) | | (50%:50%) |
| | 230 nm | 9nm | 8 nm | 7 nm | 10 nm | 30 nm |

**Tabelle 6: Deviceergebnisse**

| **Bsp.** | **EQE (%)** | **Spannung (V)** | **CIE x/y** | **LD50 (h)** |
|---|---|---|---|---|
| | **1000 cd/m²** | **1000 cd/m²** | **1000 cd/m²** | **1000 cd/m²** |
| D-W1 | 22.4 | 6.1 | 0.42/0.39 | 6000 |

**Tabelle 7: Strukturformeln der verwendeten Materialien**

| | |
|---|---|
| 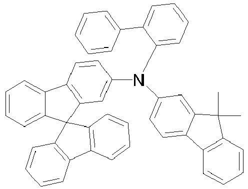 | 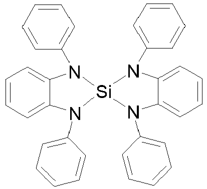 |
| HTM | EBM = M10 |
| 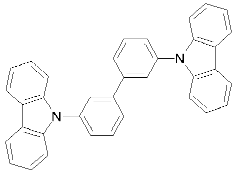 | 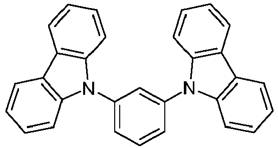 |
| M1 | M2 |
| 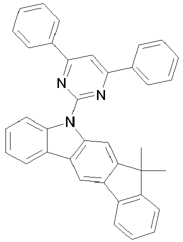 | 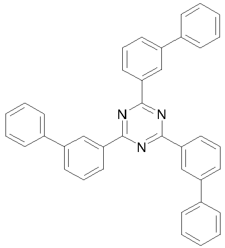 |
| M3 = HBM2 | M4 = HBM1 |
| 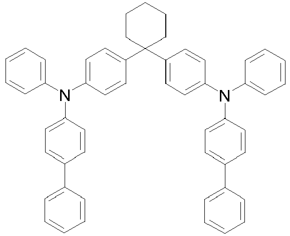 | 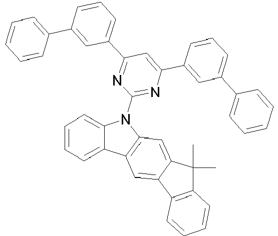 |
| M5 | M6 |
| 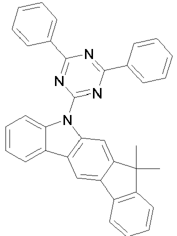 | 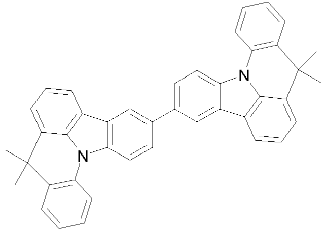 |
| M7 | M8 |
| 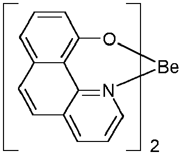 148896-39-3 | |
| M9 | |
| 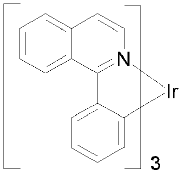 435293-93-9 | 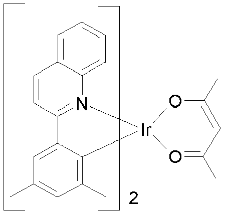 1056874-46-4 |
| Ir-R1 | Ir-R2 |
| 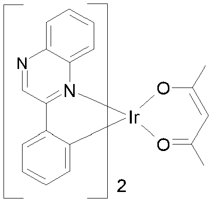 1361033-48-8 | 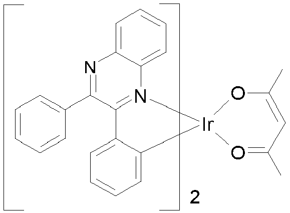 848127-98-0 |
| Ir-R3 | Ir-R4 |
| 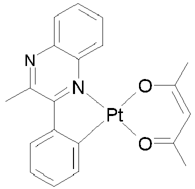 890307-63-8 | 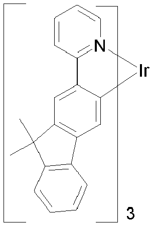 458532-65-5 |
| Pt-R1 | Ir-Y1 |
| 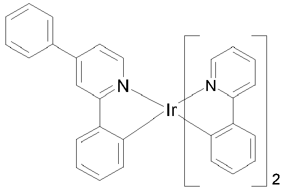 | 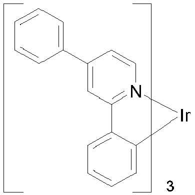 459133-57-4 |
| Ir-Y2 | Ir-Y3 |
| 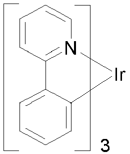 | 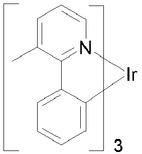 359014-71-4 |
| Ir-G1 | Ir-G2 |
| 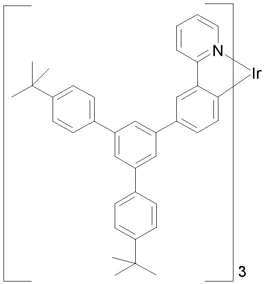 856219-87-9 | |
| Ir-G3 | |
| 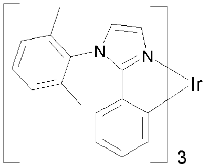 1013022-35-9 | 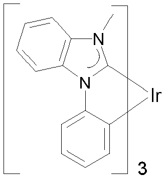 869486-05-5 |
| Ir-B1 | Ir-B2 |
| 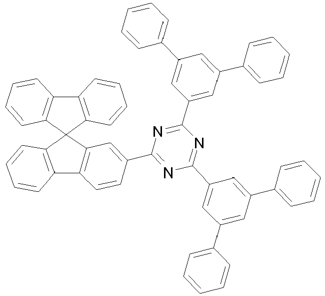 | 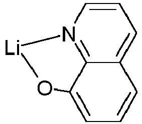 |
| ETM1 | ETM2 |

### Beispiel L160: 1-Phenyl-1H-1,2,3,4-tetrahydro-1,4-methano-benz[f]indazol

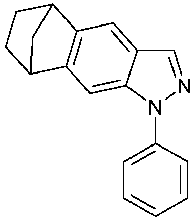

Durchführung analog H. K. Lee et al., Synth. Commun., 2013, 43, 915. Ein Gemisch aus 25.1 g (100 mmol) S53, 11.9 g (110 mmol) Phenylhydrazin [100-63-0], 19.2 g (200 mmol) Natrium-tert-butylat, 636 mg (10 mmol) Kupferbronze und 500 ml PEG-400 wird 10 h am Wasserabscheider bei 120 °C gerührt. Nach Erkalten setzt man 1000 ml Ethylacetat zu, saugt über ein Celite-Bett ab, wäscht das Filtrat fünfmal mit je 300 ml Wasser, und einmal mit 500 ml ges. Kochsalzlösung und trocknet die organische Phase über Magnesiumsulfat. Nach Entfernen des Lösungsmittels kristallisiert man den Rückstand dreimal aus DMF / EtOH um und unterwirft den Rückstand einer fraktionierten Kugelrohrdestillation (T ca. 150 °C, p ca. 10⁻⁴ mbar). Ausbeute: 12.5 g (48 mmol), 48 %; Reinheit: ca. 99.5 % nach ¹H-NMR.

Analog können die folgenden Verbindungen dargestellt werden:

| Bsp. | Edukte | Produkt | Ausbeute |
|---|---|---|---|
| L162 | 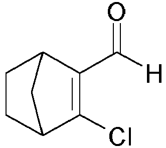 1194655-78-1 | 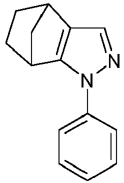 | 26 % |

### Darstellung von fac-tris-homoleptischen Iridium-Komplexen:

Die Darstellung erfolgt analog 1) Homoleptische tris-faciale Iridium-Komplexe vom Phenyl-Pyridin-, Phenyl-Imidazol- bzw. Phenyl-Benzimidazol-Typ.

| **Bsp.** | **Ligand L** | **Ir-Komplex Diastereomer** | **Variante Reaktionsmedium Reaktionstemp. Reaktionszeit Suspensionsmittel Extraktionsmittel** | **Ausbeute** |
|---|---|---|---|---|
| Ir(L160)₃ | L160 | 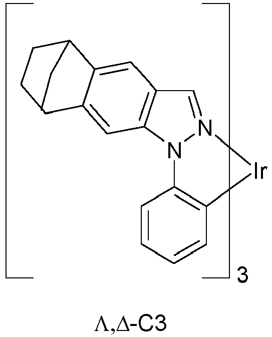 | A 260 °C 60 h Ethylacetat o-Xylol | 23 % |
| Ir(L162)₃ | L162 | 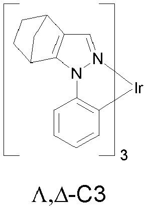 | A --- 260 °C 40 h Ethanol o-Xylol | 22 % |

### OLED-Beispiele

Die Herstellung der OLEDs erfolgt durch Vakuum-Prozessierung, wie oben beschrieben.

### Aufbau der OLEDs:

| **Bsp.** | **HTL2 Dicke** | **EBL Dicke** | **EML Dicke** | **HBL Dicke** | **ETL Dicke** |
|---|---|---|---|---|---|
| D-fac-Ir(162)₃ | HTM 190 nm | EBM 10 nm | M1 0:M4:fac-Ir(L162)₃ (60%:35%:5%) 25 nm | HBM1 10 nm | ETM1:ETM2 (50%:50%) 15 nm |

### Device-Ergebnisse:

| **Bsp.** | **EQE (%) 1000 cd/m²** | **Spannung (V) 1000 cd/m²** | **CIE x/y 1000 cd/m²** |
|---|---|---|---|
| D-fac-Ir(162)₃ | 6.5 | 5.0 | 0.14/0.12 |

## Patentansprüche

1. Verbindung gemäß Formel (1),
M(L)ₙ(L')ₘ Formel (1)
welche eine Teilstruktur M(L)ₙ der Formel (2) enthält: 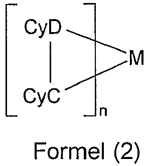 wobei für die verwendeten Symbole und Indizes gilt:
M ist Iridium oder Platin;
CyC ist eine Aryl- oder Heteroarylgruppe mit 5 bis 18 aromatischen Ringatomen oder eine Fluorengruppe, welche jeweils über ein Kohlenstoffatom an M koordiniert und welche jeweils mit einem oder mehreren Resten R substituiert sein kann und welche jeweils über eine kovalente Bindung mit CyD verbunden ist;
CyD ist eine Heteroarylgruppe mit 5 bis 18 aromatischen Ringatomen, welche über ein neutrales Stickstoffatom oder über ein Carben-Kohlenstoffatom an M koordiniert und welche mit einem oder mehreren Resten R substituiert sein kann und welche über eine kovalente Bindung mit CyC verbunden ist;
R ist bei jedem Auftreten gleich oder verschieden H, D, F, Cl, Br, I, N(R¹)₂, CN, NO₂, OH, COOH, C(=O)N(R¹)2, Si(R¹)3, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann, oder eine Aralkyl- oder Heteroaralkylgruppe mit 5 bis 40 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei benachbarte Reste R auch miteinander ein mono- oder polycyclisches, aliphatisches, aromatisches oder heteroaromatisches Ringsystem bilden;
R¹ ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere benachbarte Reste R¹ miteinander oder R¹ mit R ein mono- oder polycyclisches, aliphatisches, aromatisches oder heteroaromatisches Ringsystem bilden;
R² ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R² auch miteinander ein mono- oder polycyclisches, aliphatisches Ringsystem bilden;
L' ist gleich oder verschieden bei jedem Auftreten ein bidentater Coligand;
n ist 1, 2 oder 3;
m ist 0, 1 oder 2;
dabei können CyC und CyD auch über eine Gruppe ausgewählt aus C(R¹)₂, C(R¹)₂-C(R¹)₂-, NR¹, O oder S miteinander verknüpft sein;
dabei können auch mehrere Liganden L miteinander oder L mit L' über eine Einfachbindung oder eine bivalente oder trivalente Brücke verknüpft sein und so ein tridentates, tetradentates, pentadentates oder hexadentates Ligandensystem aufspannen;
dabei kann auch ein Substituent R zusätzlich an das Metall koordinieren;
**dadurch gekennzeichnet, dass** CyD und/oder CyC zwei benachbarte Kohlenstoffatome aufweist, die jeweils mit Resten R substituiert sind, wobei die jeweiligen Reste R zusammen mit den C-Atomen einen Ring der folgenden Formel (4) aufspannen, 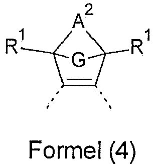 wobei R¹ und R² die oben genannten Bedeutungen aufweisen, die gestrichelten Bindungen die Verknüpfung der beiden Kohlenstoffatome im Liganden andeuten und weiterhin gilt:
A² ist C(R¹)₂ oder O;
G ist eine Alkylengruppe mit 1, 2 oder 3 C-Atomen, welche mit einem oder mehreren Resten R² substituiert sein kann, oder eine orthoverknüpfte Arylen- oder Heteroarylengruppe mit 5 bis 14 aromatischen Ringatomen, welche durch einen oder mehrere Reste R² substituiert sein kann.

2. Verbindung nach Anspruch 1, **dadurch gekennzeichnet, dass** M Iridium(III) ist und der Index n für 1, 2 oder 3 steht oder dass M Platin(II) ist und der Index n für 1 oder 2 steht.

3. Verbindung nach Anspruch 1 oder 2, **dadurch gekennzeichnet, dass** CyC ausgewählt ist aus den Formeln (CyC-1) bis (CyC-19), wobei die Gruppe CyC jeweils an der durch # gekennzeichneten Position an CyD bindet und an der durch * gekennzeichneten Position an das Metall koordiniert, 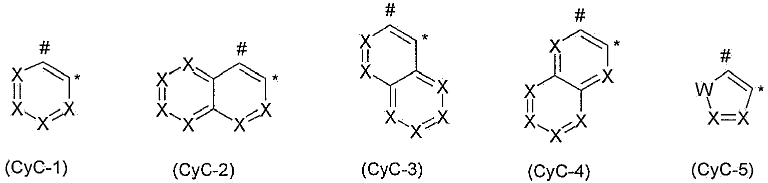 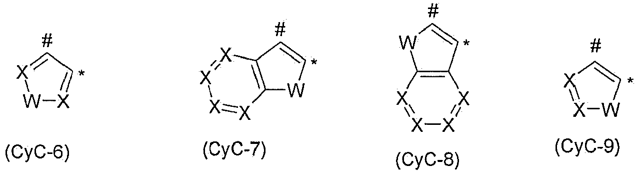 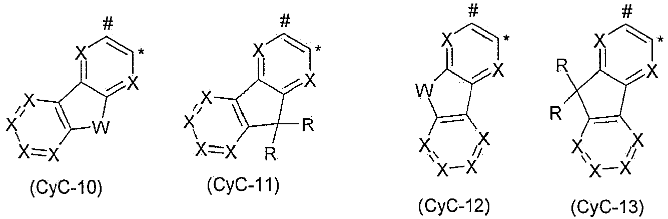 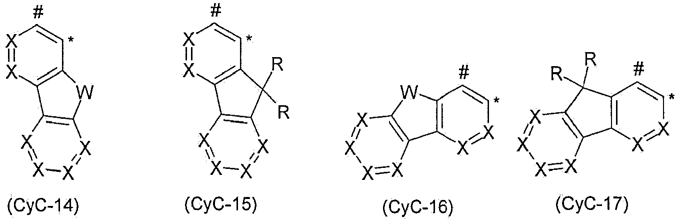 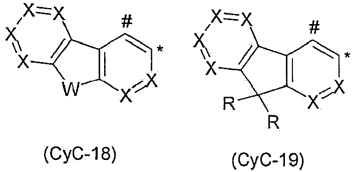
wobei R die in Anspruch 1 genannten Bedeutungen aufweist und für die weiteren verwendeten Symbole gilt:
X ist bei jedem Auftreten gleich oder verschieden CR oder N;
W ist bei jedem Auftreten gleich oder verschieden NR, O, S oder CR2.

4. Verbindung nach einem oder mehreren der Ansprüche 1 bis 3, **dadurch gekennzeichnet, dass** CyC ausgewählt ist aus den Formeln (CyC-1a) bis (CyC-19a), 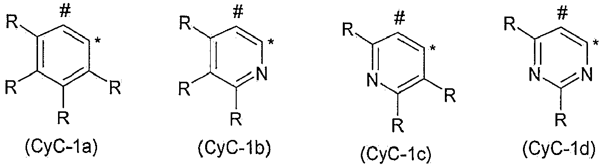 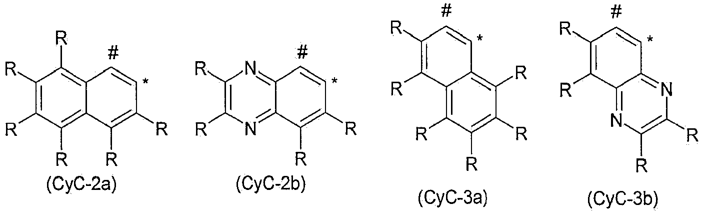 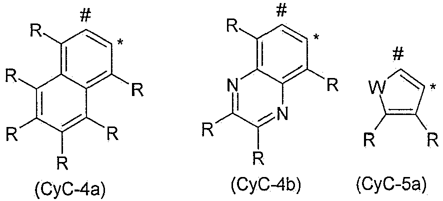 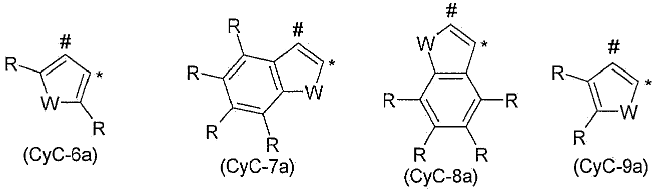 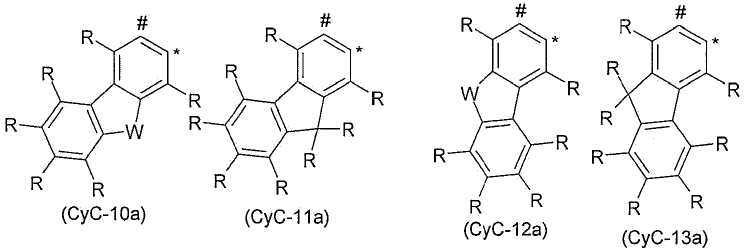 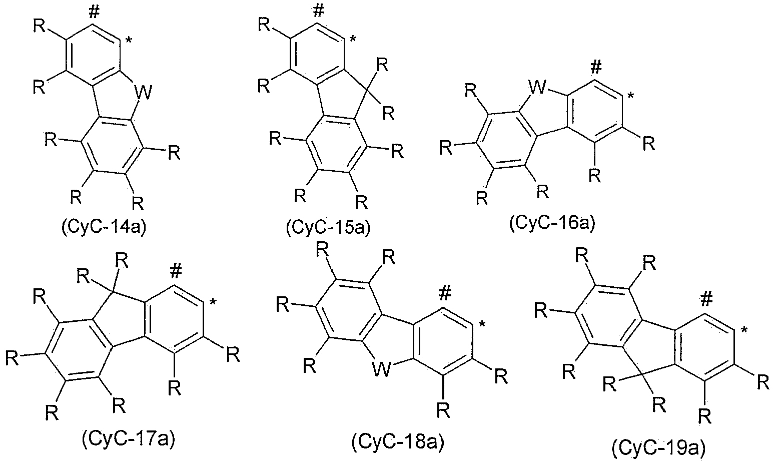 wobei die verwendeten Symbole die in Anspruch 1 und 3 genannten Bedeutungen aufweisen.

5. Verbindung nach einem oder mehreren der Ansprüche 1 bis 4, **dadurch gekennzeichnet, dass** CyD ausgewählt ist aus den Formeln (CyD-1) bis (CyD-10), wobei die Gruppe CyD jeweils an der durch # gekennzeichneten Position an CyC bindet und an der durch * gekennzeichneten Position an das Metall koordiniert, 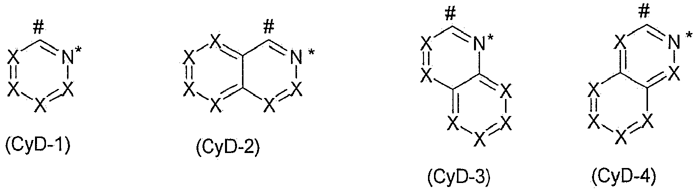 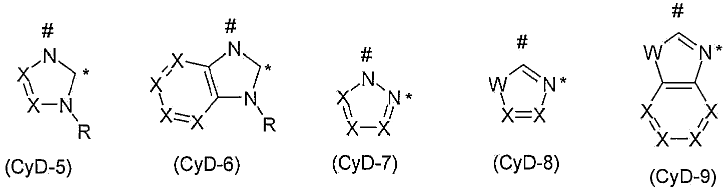 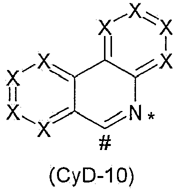 wobei X, W und R die in den Ansprüchen 1 und 3 genannten Bedeutungen aufweist.

6. Verbindung nach einem oder mehreren der Ansprüche 1 bis 5, **dadurch gekennzeichnet, dass** CyD ausgewählt ist aus den Formeln (CyD-1a) bis (CyD-10a), 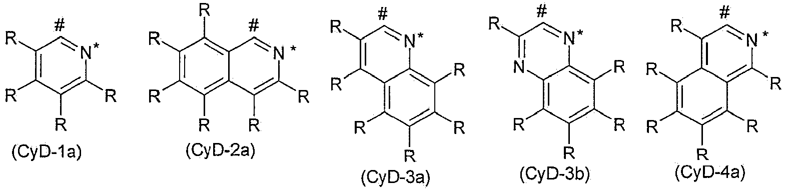 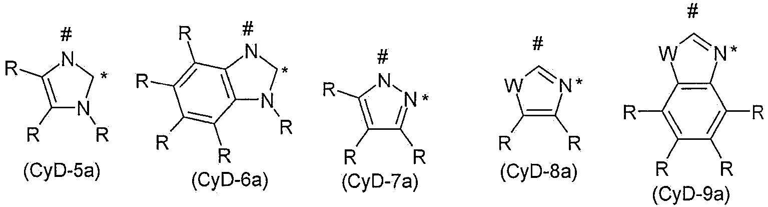 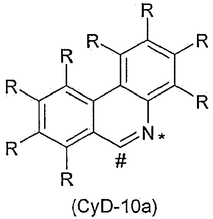 wobei die verwendeten Symbole die in den Ansprüche 1 und 3 genannten Bedeutungen aufweisen.

7. Verbindung nach einem oder mehreren der Ansprüche 1 bis 6, **dadurch gekennzeichnet, dass** CyC eine Gruppe der Formel (4) aufweist und ausgewählt ist aus den Formeln (CyC-1-1) bis (CyC-19-1) und/oder dass CyD eine Gruppe der Formel (4) aufweist und ausgewählt ist aus den Formeln (CyD-1-1) bis (CyD-10-1), 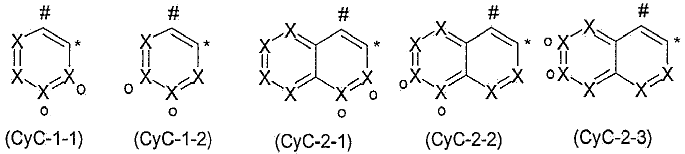 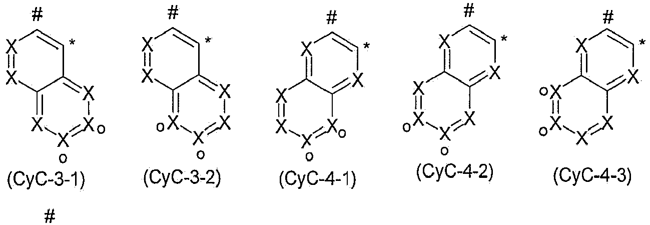 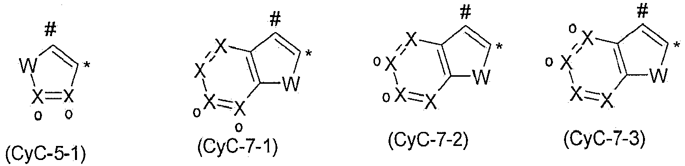 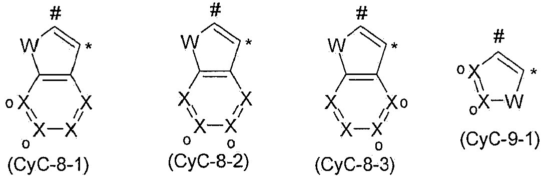 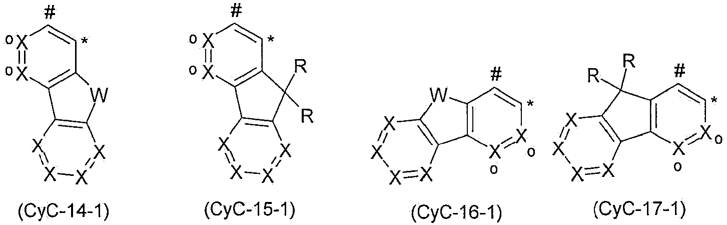 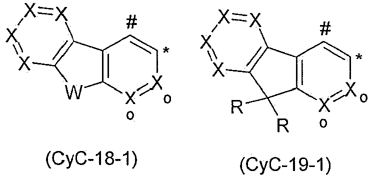 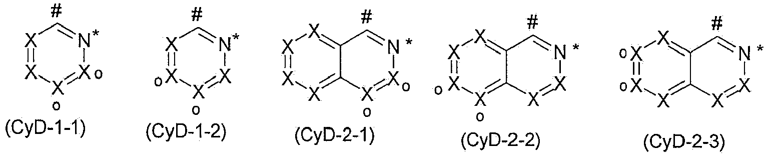 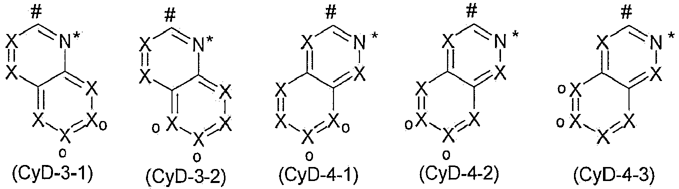 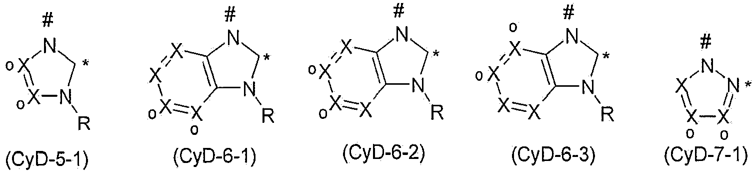 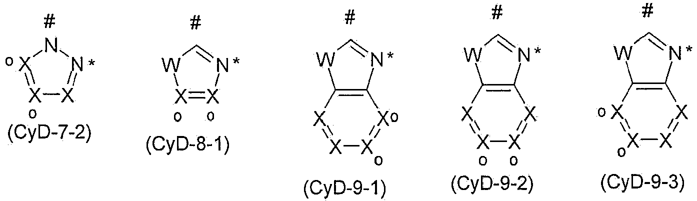 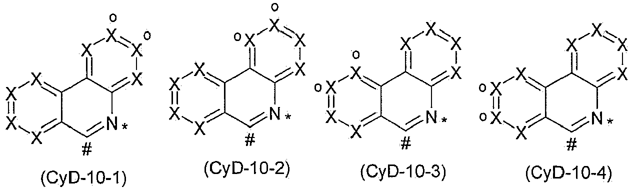 wobei die verwendeten Symbole und Indizes die in den Ansprüchen 1 und 3 genannten Bedeutungen aufweisen und ° jeweils die Positionen kennzeichnet, die für CR stehen, wobei die jeweiligen Reste R zusammen mit den C-Atomen, an die sie gebunden sind, einen Ring der Formel (4) aufspannen.

8. Verbindung nach einem oder mehreren der Ansprüche 1 bis 7, **dadurch gekennzeichnet, dass** die Struktur der Formel (4) dargestellt ist durch die Formel (4-C), 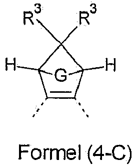 wobei die verwendeten Symbole die in Anspruch 1 genannten Bedeutungen aufweisen und weiterhin gilt:
R³ ist gleich oder verschieden bei jedem Auftreten F, eine geradkettige Alkyl- oder Alkoxygruppe mit 1 bis 20 C-Atomen, eine verzweigte oder cyclische Alkyl- oder Alkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C=C, Si(R²)₂, C=O, NR², O, S oder CONR² ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann, oder eine Aralkyl- oder Heteroaralkylgruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

9. Verbindung nach einem oder mehreren der Ansprüche 1 bis 8, ausgewählt aus den Formeln (17) bis (22), 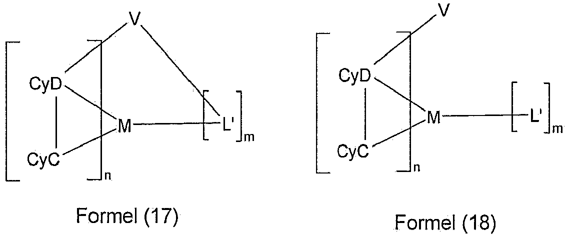 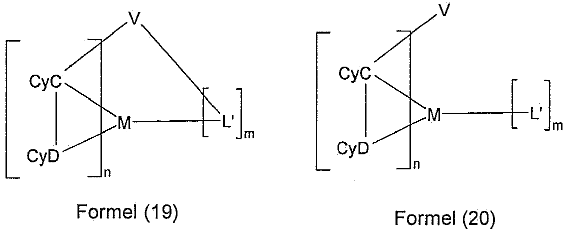 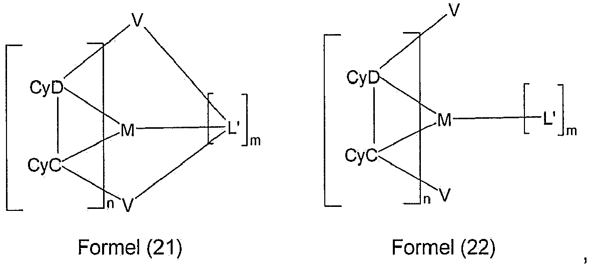 wobei die verwendeten Symbole und Indizes die in Anspruch 1 genannten Bedeutungen aufweisen und V eine Einfachbindung oder eine verbrückende Einheit darstellt, welche 1 bis 80 Atome aus der dritten, vierten, fünften und/oder sechsten Hauptgruppe oder einen 3- bis 6-gliedrigen Homo- oder Heterocyclus enthält, die die Teilliganden L miteinander oder L mit L' miteinander kovalent verbindet.

10. Verfahren zur Herstellung einer Verbindung nach einem oder mehreren der Ansprüche 1 bis 9 durch Umsetzung der freien Liganden L und gegebenenfalls L' mit Metallalkoholaten der Formel (67), mit Metallketoketonaten der Formel (68), mit Metallhalogeniden der Formel (69), mit dimeren Metallkomplexen der Formel (70) oder mit Metallkomplexen der Formel (71), 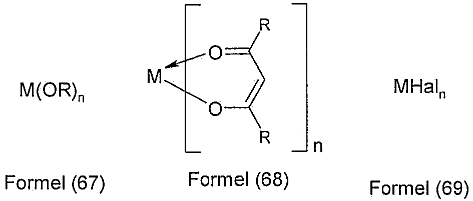 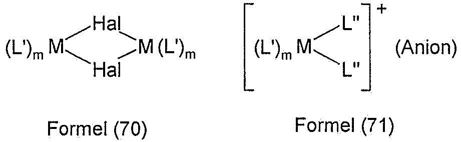 wobei die Symbole M, m, n und R die in Anspruch 1 angegebenen Bedeutungen haben, Hal = F, Cl, Br oder I ist, L" für einen Alkohol oder ein Nitril steht und (Anion) ein nicht-koordinierendes Anion ist.

11. Oligomer, Polymer oder Dendrimer enthaltend eine oder mehrere Verbindungen nach einem oder mehreren der Ansprüche 1 bis 9, wobei ein oder mehrere Bindungen der Verbindung zum Polymer, Oligomer oder Dendrimer vorhanden sind.

12. Formulierung, enthaltend eine Verbindung nach einem oder mehreren der Ansprüche 1 bis 10 und/oder ein Oligomer, Polymer oder Dendrimer nach Anspruch 11 und mindestens eine weitere Verbindung.

13. Verwendung einer Verbindung nach einem oder mehreren der Ansprüche 1 bis 9 oder eines Oligomers, Polymers oder Dendrimers nach Anspruch 11 in einer elektronischen Vorrichtung oder zur Erzeugung von Singulett-Sauerstoff oder zur Photokatalyse.

14. Elektronische Vorrichtung, enthaltend mindestens eine Verbindung nach einem oder mehreren der Ansprüche 1 bis 9 oder ein Oligomer, Polymer oder Dendrimer nach Anspruch 11, wobei die elektronische Vorrichtung bevorzugt ausgewählt ist aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen oder organischen Laserdioden.

15. Elektronische Vorrichtung nach Anspruch 14, wobei es sich um eine organische Elektrolumineszenzvorrichtung handelt, **dadurch gekennzeichnet, dass** die Verbindung nach einem oder mehreren der Ansprüche 1 bis 9 oder das Oligomer, Polymer oder Dendrimer nach Anspruch 11 als emittierende Verbindung in einer oder mehreren emittierenden Schichten eingesetzt wird, bevorzugt in Kombination mit einem Matrixmaterial.

## Claims

1. Compound of the formula (1),
M(L)n(L')m formula (1)
which contains a moiety M(L)ₙ of the formula (2): 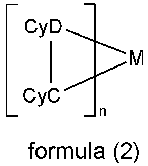 where the following applies to the symbols and indices used:
M is iridium or platinum;
CyC is an aryl or heteroaryl group having 5 to 18 aromatic ring atoms or a fluorene group, which is in each case coordinated to M via a carbon atom and which may in each case be substituted by one or more radicals R and which is in each case bonded to CyD via a covalent bond;
CyD is a heteroaryl group having 5 to 18 aromatic ring atoms which is coordinated to M via a neutral nitrogen atom or via a carbene carbon atom and which may be substituted by one or more radicals R and which is bonded to CyC via a covalent bond;
R is on each occurrence, identically or differently, H, D, F, Cl, Br, I, N(R¹)₂, CN, NO₂, OH, COOH, C(=O)NR¹)₂, Si(R¹)₃, B(OR¹)₂, C(=O)R¹, P(=O)(R¹)₂, S(=O)R¹, S(=O)₂R¹ , OSO₂R¹, a straightchain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, which may in each case be substituted by one or more radicals R¹, where one or more non-adjacent CH₂ groups may be replaced by R¹C=CR¹, C=C, Si(R¹)₂, C=O, NR¹, O, S or CONR¹ and where one or more H atoms may be replaced by D, F, Cl, Br, I or CN, or an aromatic or heteroaromatic ring system having 5 to 60 aromatic ring atoms, which may in each case be substituted by one or more radicals R¹, or an aryloxy or heteroaryloxy group having 5 to 40 aromatic ring atoms, which may be substituted by one or more radicals R¹, or an aralkyl or heteroaralkyl group having 5 to 40 aromatic ring atoms, which may be substituted by one or more radicals R¹, or a diarylamino group, diheteroarylamino group or arylheteroarylamino group having 10 to 40 aromatic ring atoms, which may be substituted by one or more radicals R¹; two adjacent radicals R may also form a mono- or polycyclic, aliphatic, aromatic or heteroaromatic ring system with one another;
R¹ is on each occurrence, identically or differently, H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², a straight-chain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, which may in each case be substituted by one or more radicals R², where one or more non-adjacent CH₂ groups may be replaced by R²C=CR², C=C, Si(R²)₂, C=O, NR², O, S or CONR² and where one or more H atoms may be replaced by D, F, Cl, Br, I, CN or NO₂, or an aromatic or heteroaromatic ring system having 5 to 60 aromatic ring atoms, which may in each case be substituted by one or more radicals R², or an aryloxy or heteroaryloxy group having 5 to 40 aromatic ring atoms, which may be substituted by one or more radicals R², or an aralkyl or heteroaralkyl group having 5 to 40 aromatic ring atoms, which may be substituted by one or more radicals R², or a diarylamino group, diheteroarylamino group or arylheteroarylamino group having 10 to 40 aromatic ring atoms, which may be substituted by one or more radicals R²; two or more adjacent radicals R¹ with one another or R¹ with R may form a mono- or polycyclic, aliphatic, aromatic or heteroaromatic ring system;
R² is on each occurrence, identically or differently, H, D, F or an aliphatic, aromatic and/or heteroaromatic hydrocarbon radical having 1 to 20 C atoms, in which, in addition, one or more H atoms may be replaced by F; two or more substituents R² here may also form a mono- or polycyclic, aliphatic ring system with one another;
L' is, identically or differently on each occurrence, any desired coligand;
n is 1, 2 or 3;
m is 0, 1 or 2;
CyC and CyD may also be linked to one another via a group selected from C(R¹)₂, C(R¹)₂-C(R¹)₂-, NR¹, O or S;
a plurality of ligands L may also be linked to one another or L may be linked to L' via a single bond or a divalent or trivalent bridge and thus form a tridentate, tetradentate, pentadentate or hexadentate ligand system;
a substituent R may also additionally be coordinated to the metal;
**characterised in that** CyD and/or CyC contain(s) two adjacent carbon atoms which are in each case substituted by radicals R, where the respective radicals R, together with the C atoms, form a ring of the following formula (4), 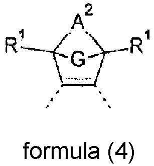 where R¹ and R² have the meanings given above, the dashed bonds indicate the linking of the two carbon atoms in the Igand and furthermore:
A² is C(R¹)₂ or O;
G is an alkylene group having 1, 2 or 3 C atoms, which may be substituted by one or more radicals R², or an ortho-linked arylene or heteroarylene group having 5 to 14 aromatic ring atoms, which may be substituted by one or more radicals R².

2. Compound according to Claim 1, **characterised in that** M is iridium(III) and the index n stands for 1, 2 or 3 or **in that** M is platinum(II) and the index n stands for 1 or 2.

3. Compound according to Claim 1 or 2, **characterised in that** CyC is selected from the formulae (CyC-1) to (CyC-19), where the group CyC is in each case bonded to CyD at the position denoted by # and is coordinated to the metal at the position denoted by *, 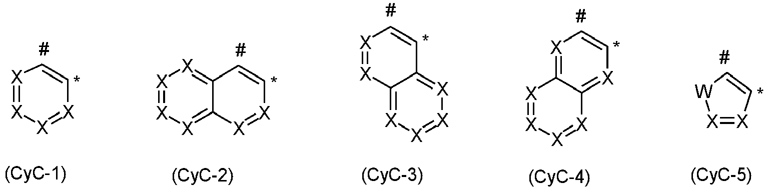 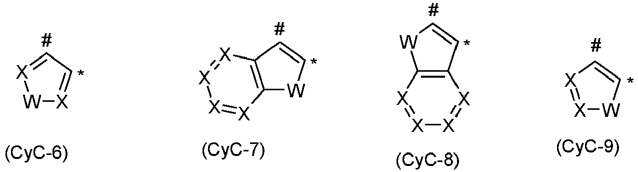 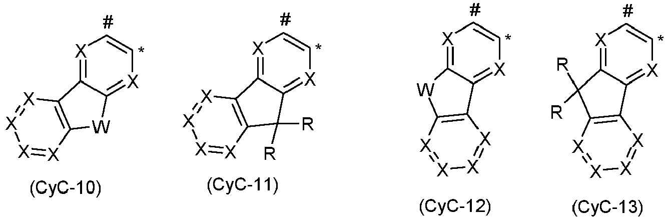 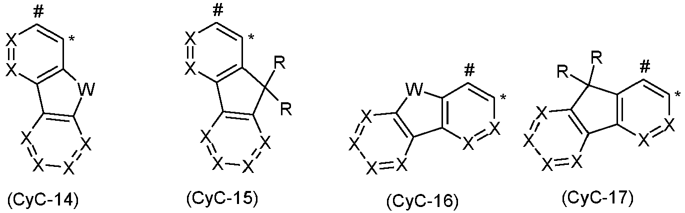 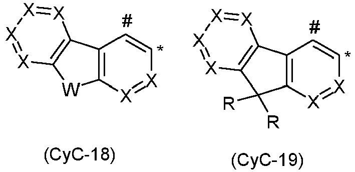 where R has the meanings given in Claim 1 and the following applies to the other symbols used:
X is on each occurrence, identically or differently, CR or N;
W is on each occurrence, identically or differently, NR, O, S or CR₂.

4. Compound according to one or more of Claims 1 to 3, **characterised in that** CyC is selected from the formulae (CyC-1 a) to (CyC-19a), 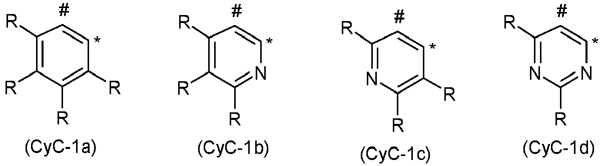 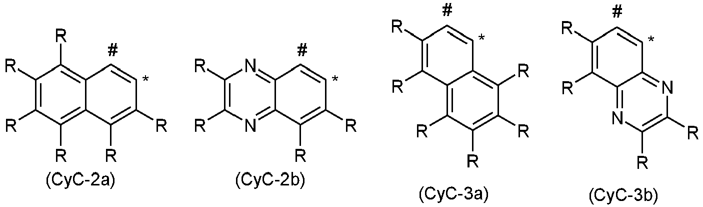 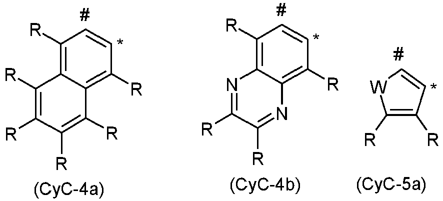 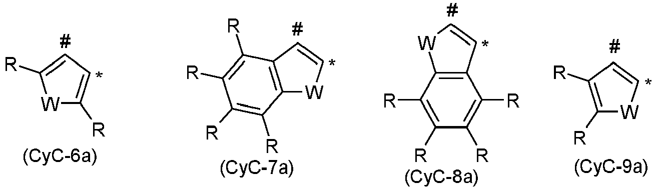 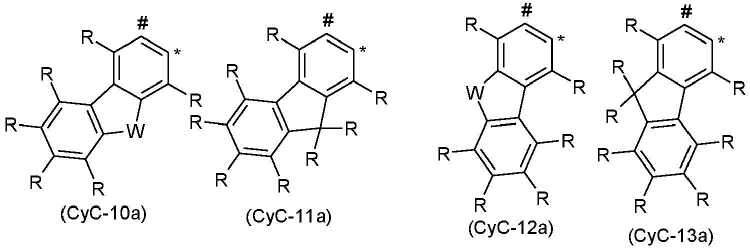 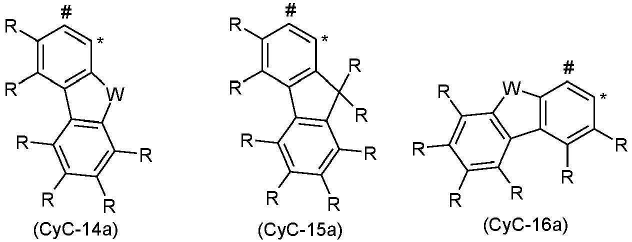 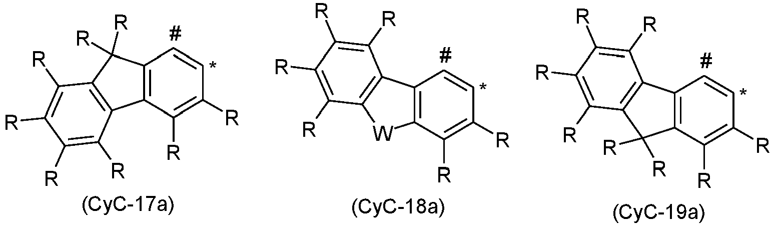 where the symbols used have the meanings given in Claims 1 and 3.

5. Compound according to one or more of Claims 1 to 4, **characterised in that** CyD is selected from the formulae (CyD-1) to (CyD-10), where the group CyD is in each case bonded to CyC at the position denoted by # and is coordinated to the metal at the position denoted by *, 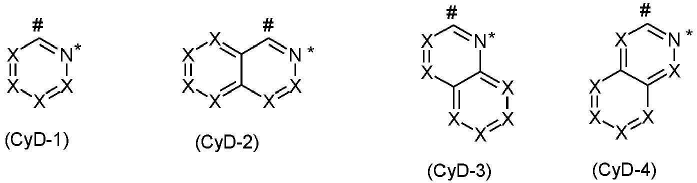 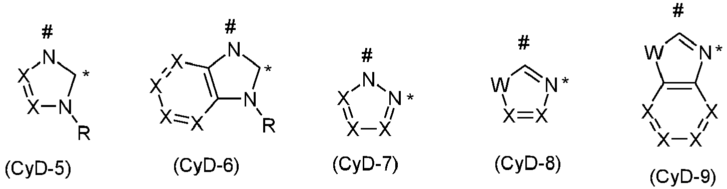 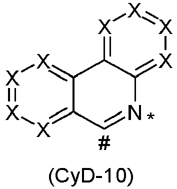 where X, W and R have the meanings given in Claims 1 and 3.

6. Compound according to one or more of Claims 1 to 5, **characterised in that** CyD is selected from the formulae (CyD-1 a) to (CyD-10a), 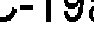 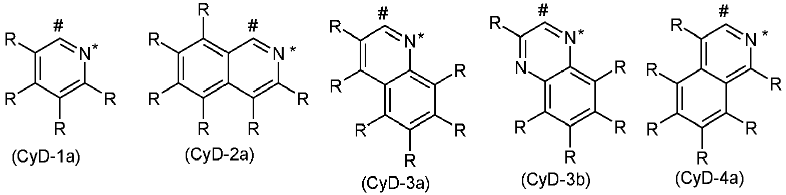 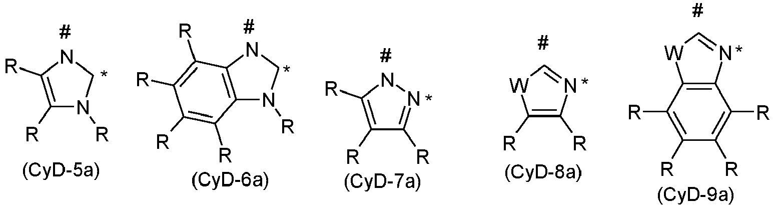 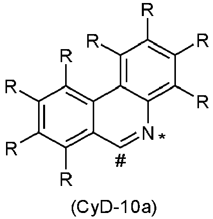 where the symbols used have the meanings given in Claims 1 and 3.

7. Compound according to one or more of Claims 1 to 6, **characterised in that** CyC contains a group of the formula (4) and is selected from the formulae (CyC-1-1) to (CyC-19-1) and/or **in that** CyD contains a group of the formula (4) and is selected from the formulae (CyD1-1) to (CyD-1 0-1), 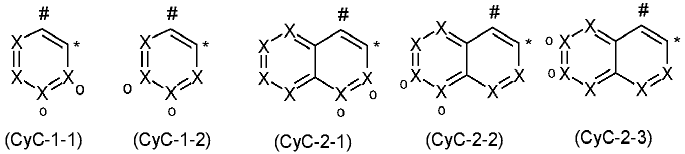 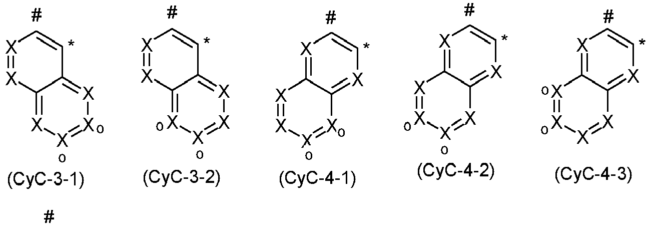 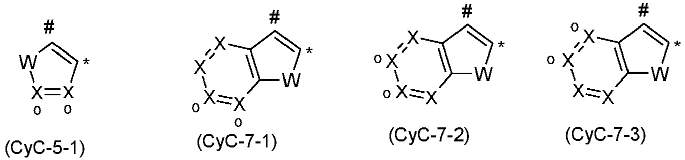 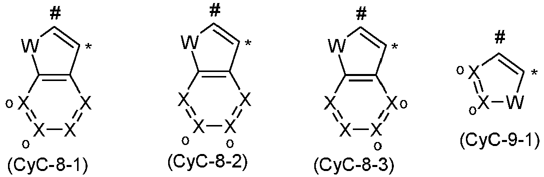 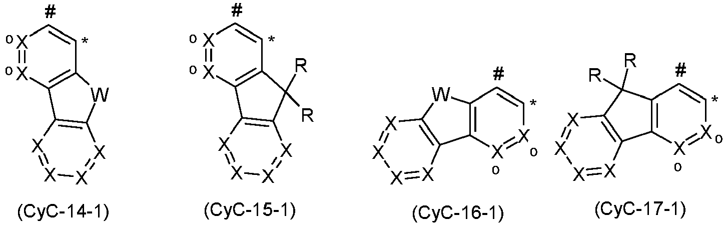 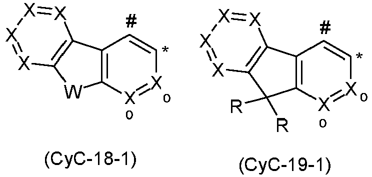 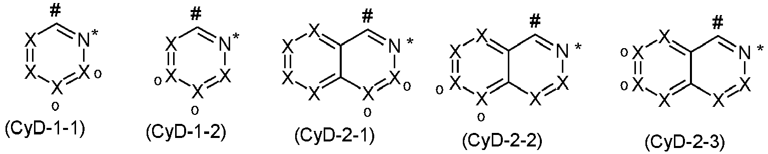 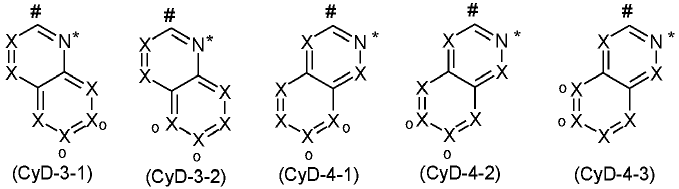 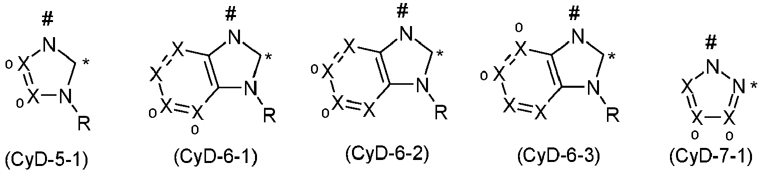 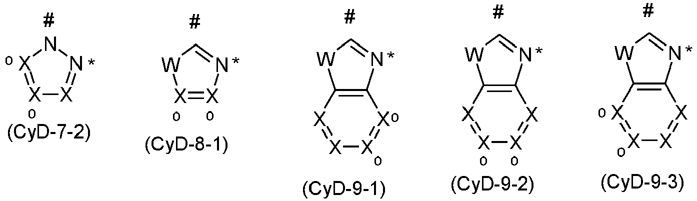 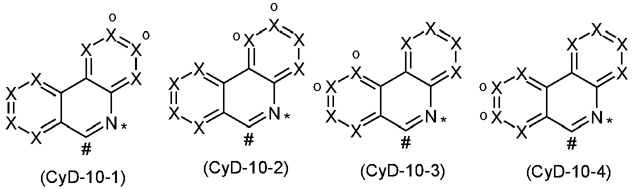 where the symbols and indices used have the meanings given in Claims 1 and 3 and ° in each case denotes the positions which stand for CR, where the respective radicals R, together with the C atoms to which they are bonded, form a ring of the formula (4).

8. Compound according to one or more of Claims 1 to 7, **characterised in that** the structure of the formula (4) is represented by the formula (4-C), 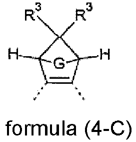 where the symbols used have the meanings given in Claim 1 and furthermore:
R³ is, identically or differently on each occurrence, F, a straight-chain alkyl or alkoxy group having 1 to 20 C atoms, a branched or cyclic alkyl or alkoxy group having 3 to 20 C atoms, which may in each case be substituted by one or more radicals R², where one or more non-adjacent CH₂ groups may be replaced by R²C=CR², C=C, Si(R²)₂, C=O, NR², O, S or CONR² and where one or more H atoms may be replaced by D or F, or an aromatic or heteroaromatic ring system having 5 to 24 aromatic ring atoms, which may in each case be substituted by one or more radicals R², or an aryloxy or heteroaryloxy group having 5 to 24 aromatic ring atoms, which may be substituted by one or more radicals R², or an aralkyl or heteroaralkyl group having 5 to 24 aromatic ring atoms, which may be substituted by one or more radicals R²; two radicals R³ which are bonded to the same carbon atom may form an aliphatic or aromatic ring system with one another and thus form a spiro system; furthermore, R³ may form an aliphatic ring system with an adjacent radical R or R¹.

9. Compound according to one or more of Claims 1 to 8, selected from the formulae (17) to (22), 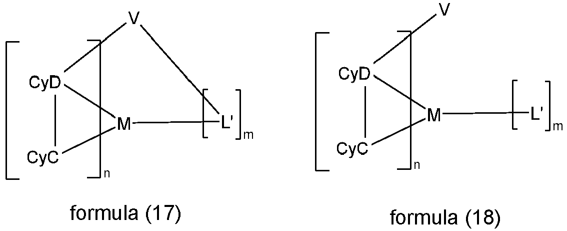 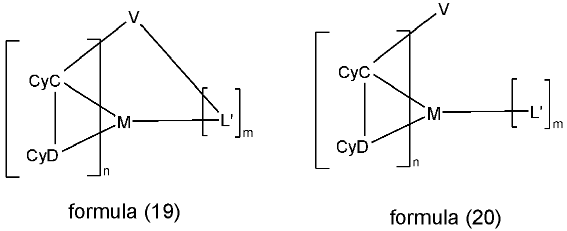 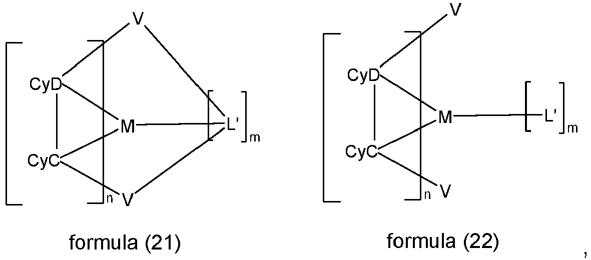 where the symbols and indices used have the meanings given in Claim 1 and V represents a single bond or a bridging unit which contains 1 to 80 atoms from the third, fourth, fifth and/or sixth main group or a 3- to 6-membered homo- or heterocycle which covalently bonds the part-ligands L to one another or L and L' to one another.

10. Process for the preparation of a compound according to one or more of Claims 1 to 9 by reaction of the free ligands L and optionally L' with metal alkoxides of the formula (67), with metal ketoketonates of the formula (68), with metal halides of the formula (69), with dimeric metal complexes of the formula (70) or with metal complexes of the formula (71), 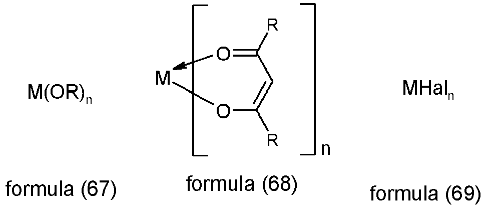 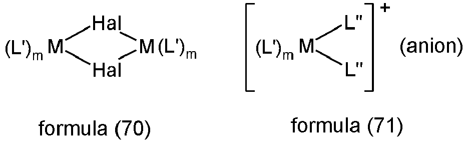 where the symbols M, m, n and R have the meanings indicated in Claim 1, Hal = F, Cl, Br or I, L" stands for an alcohol or a nitrile and (anion) is a non-coordinating anion.

11. Oligomer, polymer or dendrimer containing one or more compounds according to one or more of Claims 1 to 9, where one or more bonds are present from the compound to the polymer, oligomer or dendrimer.

12. Formulation comprising a compound according to one or more of Claims 1 to 9 and/or an oligomer, polymer or dendrimer according to Claim 11 and at least one further compound.

13. Use of a compound according to one or more of Claims 1 to 9 or an oligomer, polymer or dendrimer according to Claim 11 in an electronic device or for the generation of singlet oxygen or for photocatalysis.

14. Electronic device comprising at least one compound according to one or more of Claims 1 to 9 or an oligomer, polymer or dendrimer according to Claim 11, where the electronic device is preferably selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells or organic laser diodes.

15. Electronic device according to Claim 14, which is an organic electroluminescent device, **characterised in that** the compound according to one or more of Claims 1 to 9 or the oligomer, polymer or dendrimer according to Claim 11 is employed as emitting compound in one or more emitting layers, preferably in combination with a matrix material.

## Revendications

1. Composé de la formule (1),
M(L)ₙ(L')ₘ formule (1)
laquelle contient une moitié M(L)ₙ de la formule (2) : 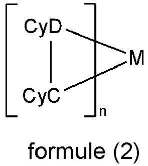 où ce qui suit s'applique aux symboles et indices qui sont utilisés :
M est iridium ou platine ;
CyC est un groupe aryle ou hétéroaryle qui comporte de 5 à 18 atomes de cycle aromatique ou un groupe fluorène, lequel est dans chaque cas coordonné sur M via un atome de carbone et lequel peut dans chaque cas être substitué par un radical ou par plusieurs radicaux R et lequel est dans chaque cas lié sur CyD via une liaison covalente ;
CyD est un groupe hétéroaryle qui comporte de 5 à 18 atomes de cycle aromatique, lequel est coordonné sur M via un atome d'azote ou via un atome de carbone carbène et lequel peut être substitué par un radical ou par plusieurs radicaux R et lequel est lié sur CyC via une liaison covalente ;
R est pour chaque occurrence, de manière identique ou différente, H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, un groupe alkyle, alcoxy ou thioalcoxy en chaîne droite qui comporte de 1 à 20 atome(s) de C ou un groupe alkényle ou alkynyle qui comporte de 2 à 20 atomes de C ou un groupe alkyle, alcoxy ou thioalcoxy ramifié ou cyclique qui comporte de 3 à 20 atomes de C, lequel peut dans chaque cas être substitué par un radical ou par plusieurs radicaux R¹, où un ou plusieurs groupe(s) CH₂ non adjacents peut/peuvent être remplacé(s) par R¹C=CR¹, C=C, Si(R¹)₂, C=O, NR¹, O, S ou CONR¹ et où un ou plusieurs atome(s) de H peut/peuvent être remplacé(s) par D, F, Cl, Br, I ou CN, ou un système de cycle aromatique ou hétéroaromatique qui comporte de 5 à 60 atomes de cycle aromatique, lequel peut dans chaque cas être substitué par un radical ou par plusieurs radicaux R¹, ou un groupe aryloxy ou hétéroaryloxy qui comporte de 5 à 40 atomes de cycle aromatique, lequel peut être substitué par un radical ou par plusieurs radicaux R¹, ou un groupe aralkyle ou hétéroaralkyle qui comporte de 5 à 40 atomes de cycle aromatique, lequel peut être substitué par un radical ou par plusieurs radicaux R¹, ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R¹ ; deux radicaux R adjacents peuvent également former un système de cycle aliphatique, aromatique ou hétéroaromatique mono- ou polycyclique l'un avec l'autre ;
R¹ est pour chaque occurrence, de manière identique ou différente, H, D, F, Cl, Br, I, N(R²)₂, CN, NO₂, Si(R²)₃, B(OR²)₂, C(=O)R ², P(=O)(R²)₂, S(=O)R² S(=O)₂R² OSO₂R², un groupe alkyle, alcoxy ou thioalcoxy en chaîne droite qui comporte de 1 à 20 atome(s) de C ou un groupe alkényle ou alkynyle qui comporte de 2 à 20 atomes de C ou un groupe alkyle, alcoxy ou thioalcoxy ramifié ou cyclique qui comporte de 3 à 20 atomes de C, groupe peut dans chaque cas être substitué par un radical ou par plusieurs radicaux R², où un ou plusieurs groupe(s) CH₂ non adjacents peut/peuvent être remplacé(s) par R²C=CR², C=C, Si(R²)₂, C=O, NR², O, S ou CONR² et où un ou plusieurs atome(s) de H peut/peuvent être remplacé(s) par D, F, Cl, Br, I, CN ou NO₂, ou un système de cycle aromatique ou hétéroaromatique qui comporte de 5 à 60 atomes de cycle aromatique, lequel peut dans chaque cas être substitué par un radical ou par plusieurs radicaux R², ou un groupe aryloxy ou hétéroaryloxy qui comporte de 5 à 40 atomes de cycle aromatique, lequel peut être substitué par un radical ou par plusieurs radicaux R², ou un groupe aralkyle ou hétéroaralkyle qui comporte de 5 à 40 atomes de cycle aromatique, lequel peut être substitué par un radical ou par plusieurs radicaux R², ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R² ; deux radicaux R¹ adjacents ou plus l'un avec l'autre ou les uns avec les autres ou R¹ avec R peuvent former un système de cycle aliphatique, aromatique ou hétéroaromatique mono- ou polycyclique ;
R² est pour chaque occurrence, de manière identique ou différente, H, D, F ou un radical hydrocarbone aliphatique, aromatique et/ou hétéroaromatique qui comporte de 1 à 20 atome(s) de C, où, en outre, un ou plusieurs atome(s) de H peut/peuvent être remplacé(s) par F ; deux substituants R² ou plus peuvent ici également former un système de cycle aliphatique mono- ou polycyclique l'un avec l'autre ou les uns avec les autres ;
L' est, de manière identique ou différente pour chaque occurrence, un quelconque co-ligand souhaité ;
n est 1, 2 ou 3 ;
m est 0, 1 ou 2;
CyC et CyD peuvent également être liés l'un à l'autre via un groupe sélectionné parmi C(R¹)₂, C(R¹)₂-C(R¹)₂-, NR¹, O ou S ;
les ligands d'une pluralité de ligands L peuvent également être liés les uns aux autres ou les ligands d'une pluralité de ligands L peuvent être liés à L' via une liaison simple ou un pont divalent ou trivalent, d'où ainsi la formation d'un système de ligands tridenté, tétradenté, pentadenté ou hexadenté ;
un substituant R peut également de façon additionnelle être coordonné sur le métal ;
**caractérisé en ce que** CyD et/ou CyC contient/contiennent deux atomes de carbone adjacents qui sont dans chaque cas substitués par des radicaux R, où les radicaux respectifs R, en association avec les atomes de C, forment un cycle de la formule (4) qui suit, 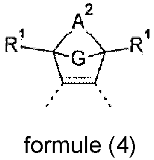 dans laquelle R¹ et R² présentent les significations qui ont été données ci-avant, les liaisons en pointillés indiquent le lien des deux atomes de carbone dans le ligand et en outre :
A² est C(R¹)₂ ou O;
G est un groupe alkylène qui comporte 1, 2 ou 3 atome(s) de C, lequel peut être substitué par un ou plusieurs radicaux R², ou un groupe arylène ou hétéroarylène ortho-lié qui comporte de 5 à 14 atomes de cycle aromatique, lequel peut être substitué par un radical ou par plusieurs radicaux R².

2. Composé selon la revendication 1, **caractérisé en ce que** M est iridium(III) et l'indice n représente 1, 2 ou 3 ou **en ce que** M est platine(II) et l'indice n représente 1 ou 2.

3. Composé selon la revendication 1 ou 2, **caractérisé en ce que** CyC est sélectionné parmi les formules (CyC-1) à (CyC-19), où le groupe CyC est dans chaque cas lié à CyD au niveau de la position qui est indiquée par # et est coordonné sur le métal au niveau de la position qui est indiquée par *, 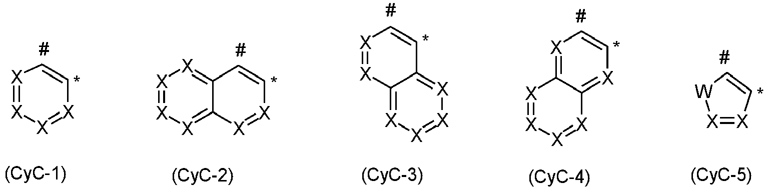 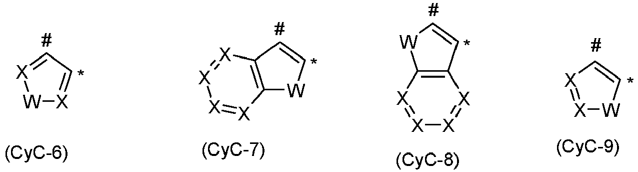 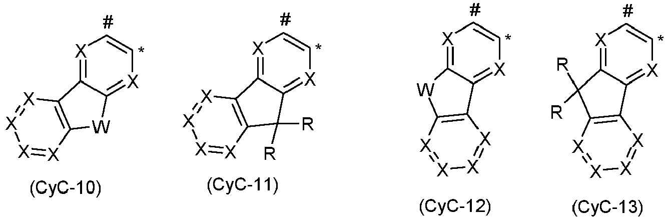 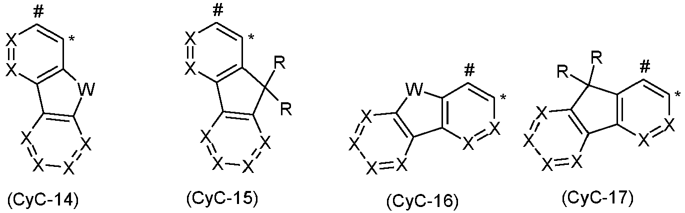 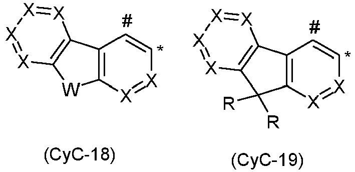 dans lesquelles R présente les significations qui ont été données selon la revendication 1 et ce qui suit s'applique aux autres symboles qui sont utilisés :
X est pour chaque occurrence, de manière identique ou différente, CR ou N ;
W est pour chaque occurrence, de manière identique ou différente, NR, O, S ou CR₂.

4. Composé selon une ou plusieurs des revendications 1 à 3, **caractérisé en ce que** CyC est sélectionné parmi les formules (CyC-1 a) à (CyC-19a), 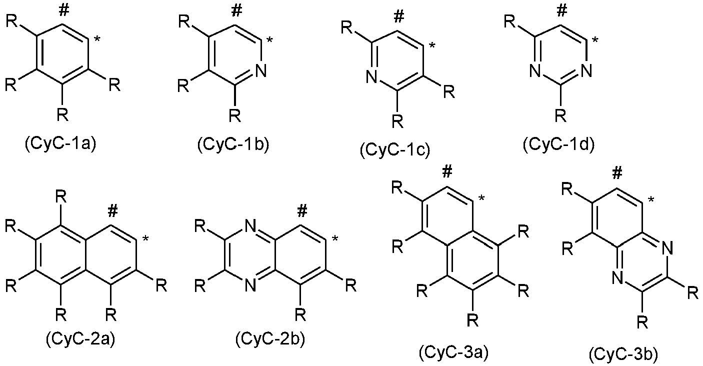 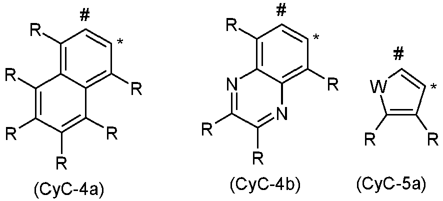 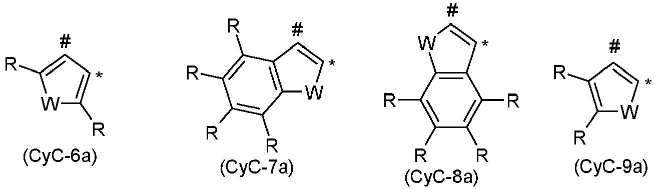 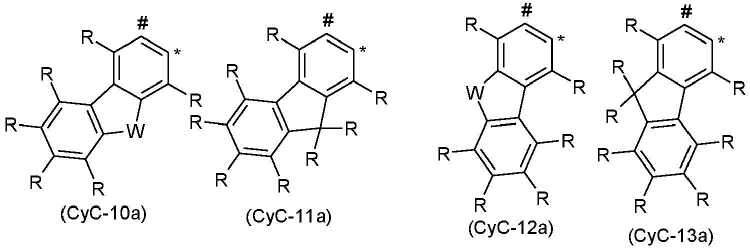 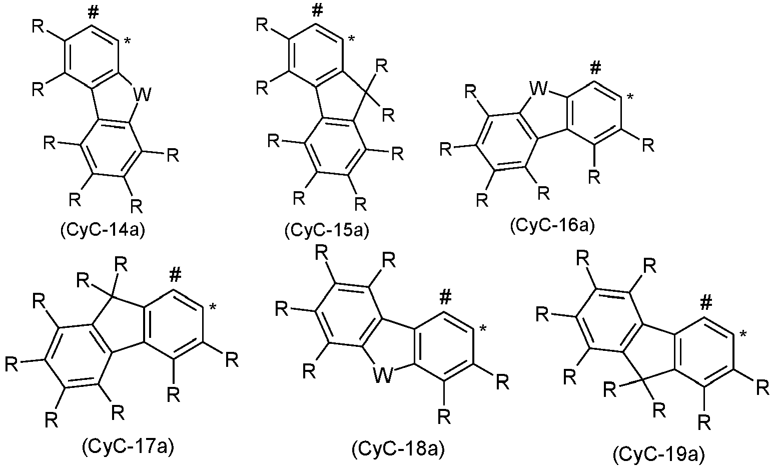 dans lesquelles les symboles qui sont utilisés présentent les significations qui ont été données selon les revendications 1 et 3.

5. Composé selon une ou plusieurs des revendications 1 à 4, **caractérisé en ce que** CyD est sélectionné parmi les formules (CyD-1) à (CyD-10), où le groupe CyD est dans chaque cas lié sur CyC au niveau de la position qui est indiquée par # et est coordonné sur le métal au niveau de la position qui est indiquée par *, 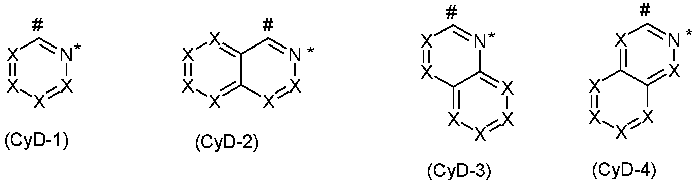 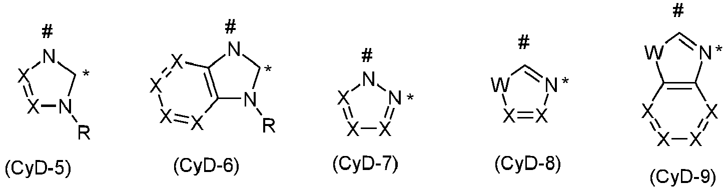 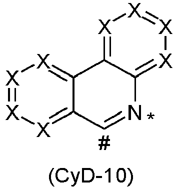 dans lesquelles X, W et R présentent les significations qui ont été données selon les revendications 1 et 3.

6. Composé selon une ou plusieurs des revendications 1 à 5, **caractérisé en ce que** CyD est sélectionné parmi les formules (CyD-1 a) à (CyD-10a), 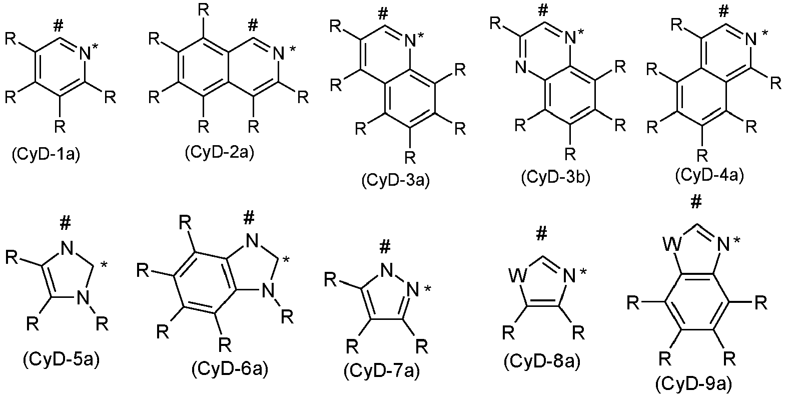 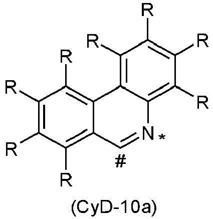 dans lesquelles les symboles qui sont utilisés présentent les significations qui ont été données selon les revendications 1 et 3.

7. Composé selon une ou plusieurs des revendications 1 à 6, **caractérisé en ce que** CyC contient un groupe de la formule (4) et est sélectionné parmi les formules (CyC-1-1) à (CyC-19-1) et/ou **en ce que** CyD contient un groupe de la formule (4) et est sélectionné parmi les formules (CyD1-1) à (CyD-10-1), 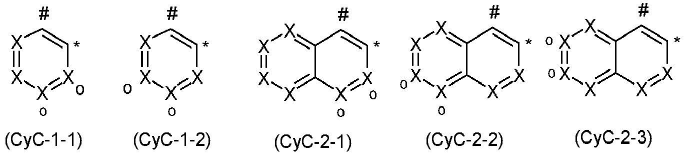 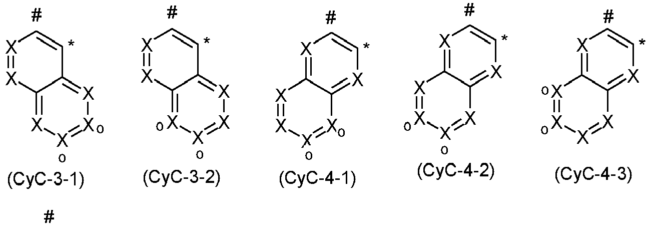 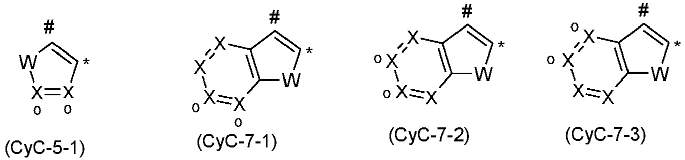 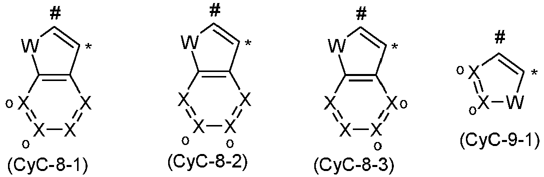 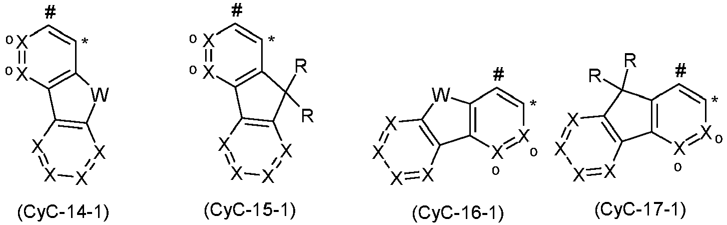 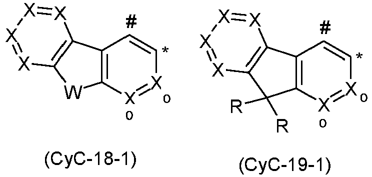 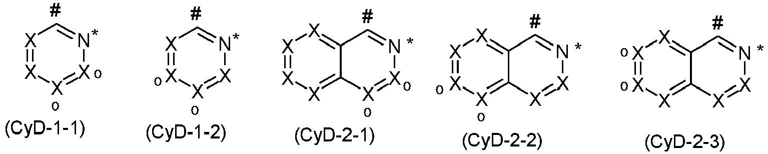 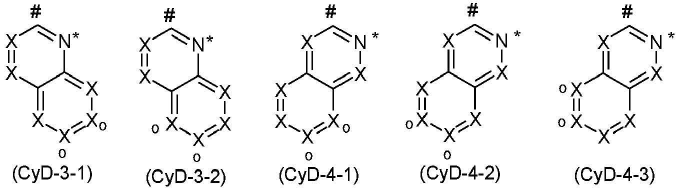 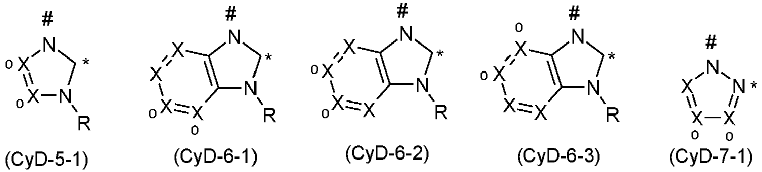 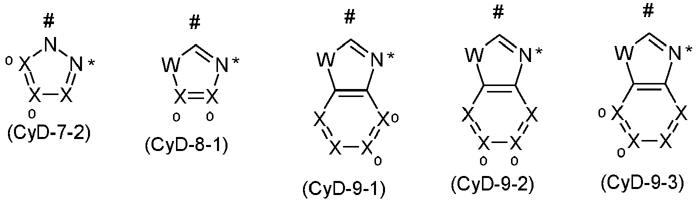 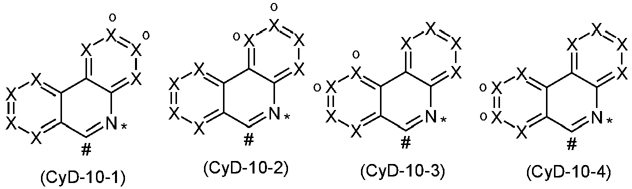 dans lesquelles les symboles et indices qui sont utilisés présentent les significations qui ont été données selon les revendications 1 et 3 et ° indique dans chaque cas les positions qui représentent CR, où les radicaux respectifs R, en association avec les atomes de C auxquels ils sont liés, forment un cycle de la formule (4).

8. Composé selon une ou plusieurs des revendications 1 à 7, **caractérisé en ce que** la structure de la formule (4) st représentée par la formule (4-C), 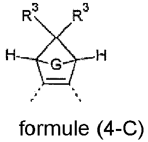 dans laquelle les symboles qui sont utilisés présentent les significations qui ont été données selon la revendication 1 et en outre ;
R³ est, de manière identique ou différente pour chaque occurrence, F, un groupe alkyle ou alcoxy en chaîne droite qui comporte de 1 à 20 atome(s) de C, un groupe alkyle ou alcoxy ramifié ou cyclique qui comporte de 3 à 20 atomes de C, lequel peut dans chaque cas être substitué par un radical ou par plusieurs radicaux R², où un ou plusieurs groupe(s) CH₂ non adjacents peut/ peuvent être remplacé(s) par R²C=CR², C≡C, Si(R²)₂, C=O, NR², O, S ou CONR² et où un ou plusieurs atome(s) de H peut/ peuvent être remplacé(s) par D ou F, ou un système de cycle aromatique ou hétéroaromatique qui comporte de 5 à 24 atomes de cycle aromatique, lequel peut dans chaque cas être substitué par un radical ou par plusieurs radicaux R², ou un groupe aryloxy ou hétéroaryloxy qui comporte de 5 à 24 atomes de cycle aromatique, lequel peut être substitué par un radical ou par plusieurs radicaux R², ou un groupe aralkyle ou hétéroaralkyle qui comporte de 5 à 24 atomes de cycle aromatique, lequel peut être substitué par un radical ou par plusieurs radicaux R² ; deux radicaux R³ qui sont liés au même atome de carbone peuvent former un système de cycle aliphatique ou aromatique l'un avec l'autre et peuvent ainsi former un système spiro ; qui plus est, R³ peut former un système de cycle aliphatique avec un radical adjacent R ou R¹.

9. Composé selon une ou plusieurs des revendications 1 à 8, sélectionné parmi les formules (17) à (22), 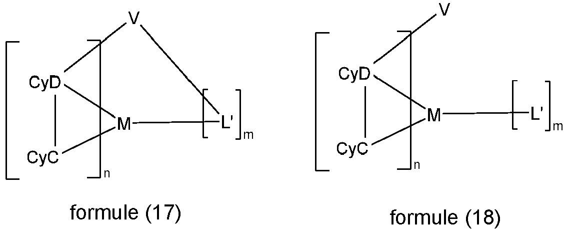 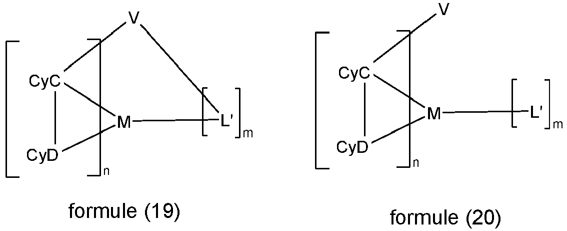 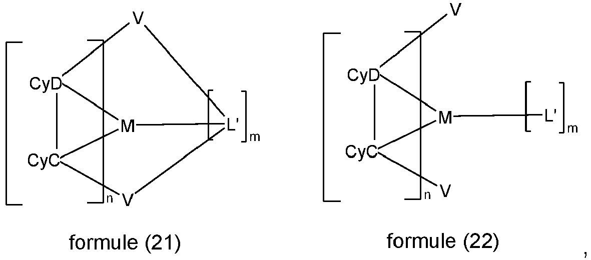 dans lesquelles les symboles et indices qui sont utilisés présentent les significations qui ont été données selon la revendication 1 et V représente une liaison simple ou une unité de pontage qui contient de 1 à 80 atome(s) issu(s) du troisième, quatrième, cinquième et/ou sixième groupe(s) principal/principaux ou un homocycle ou un hétérocycle à 3 à 6 éléments qui lie de façon covalente les ligands partiels L les uns aux autres ou les ligands partiels L et L' ensemble.

10. Procédé pour la préparation d'un composé selon une ou plusieurs des revendications 1 à 9 par réaction des ligands libres L et en option L' avec des alcoxydes de métal de la formule (67), avec des cétocétonates de métal de la formule (68), avec des halogénures de métal de la formule (69), avec des complexes de métal dimériques de la formule (70) ou avec des complexes de métal de la formule (71), 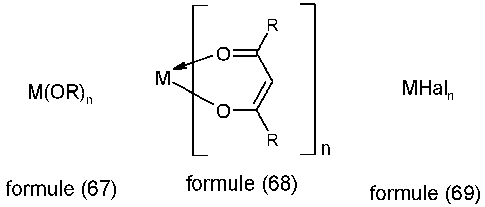 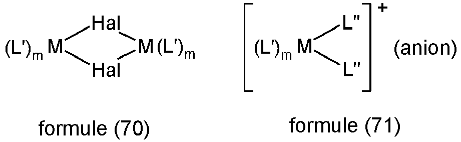 dans lesquelles les symboles M, m, n et R présentent les significations qui ont été indiquées selon la revendication 1, Hal = F, Cl, Br ou I, L" représente un alcool ou un nitrile et (anion) est un anion de non coordination.

11. Oligomère, polymère ou dendrimère contenant un ou plusieurs composé(s) selon une ou plusieurs des revendications 1 à 9, où une ou plusieurs liaison(s) est/sont présente(s) depuis le composé sur le polymère, l'oligomère ou le dendrimère.

12. Formulation comprenant un composé selon une ou plusieurs des revendications 1 à 9 et/ou un oligomère, un polymère ou un dendrimère selon la revendication 11 et au moins un autre composé.

13. Utilisation d'un composé selon une ou plusieurs des revendications 1 à 9 ou d'un oligomère, d'un polymère ou d'un dendrimère selon la revendication 11 dans un dispositif électronique ou pour la génération d'un oxygène singulet ou pour une photocatalyse.

14. Dispositif électronique comprenant au moins un composé selon une ou plusieurs des revendications 1 à 9 ou un oligomère, un polymère ou un dendrimère selon la revendication 11, où le dispositif électronique est de préférence sélectionné parmi le groupe qui est constitué par les dispositifs électroluminescents organiques, les circuits intégrés organiques, les transistors à effet de champ organiques, les transistors à film mince organiques, les transistors à émission de lumière organiques, les cellules solaires organiques, les détecteurs optiques organiques, les photorécepteurs organiques, les dispositifs à extinction de champ organiques, les cellules électrochimiques à émission de lumière ou les diodes laser organiques.

15. Dispositif électronique selon la revendication 14, lequel est un dispositif électroluminescent organique, **caractérisé en ce que** le composé selon une ou plusieurs des revendications 1 à 9 ou l'oligomère, le polymère ou le dendrimère selon la revendication 11 est utilisé en tant que composé d'émission dans une ou plusieurs couche(s) d'émission, de préférence en combinaison avec un matériau de matrice.
